# EUROPEAN PATENT SPECIFICATION

(11) **EP 2 700 111 B1**
(45) Date of publication and mention of the grant of the patent: **21.01.2015**
(21) Application number: 12710663.1
(22) Date of filing: 23.03.2012
(51) Int. Cl.: H01L 51/46, C07D 495/04

(54) **CONJUGATED POLYMERS**
KONJUGIERTE POLYMERE
POLYMÈRES CONJUGUÉS

(30) Priority: 21.04.2011 EP 11003393
(43) Date of publication of application: 26.02.2014
(73) Proprietor: Merck Patent GmbH, 64293 Darmstadt (DE)
(72) Inventor: BLOUIN, Nicolas, Southampton SO16 7DE (GB); MITCHELL, William, Chandler's Ford SO53 3PE (GB); TOPLEY, Amy, Southampton SO18 3NB (GB); TIERNEY, Steven, Southampton SO16 4BS (GB)
(86) International application number: PCT/EP2012/001269
(87) International publication number: WO 2012/143077

(56) References cited:
- WO-A1-2010/008672
- US-A1- 2010 307 594
- M.C. SCHARBER ET AL: "Design Rules for Donors in Bulk-Heterojunction Solar Cells-Towards 10?% Energy-Conversion Efficiency", ADVANCED MATERIALS, vol. 18, no. 6, 22 February 2006 (2006-02-22), pages 789-794, XP055097646, ISSN: 0935-9648, DOI: 10.1002/adma.200501717

## Description

### Technical Field

The invention relates to novel polymers containing one or more repeating units based on 4,8-bis(1,1-difluoralkyl)-benzo[1,2-b:4,5-b']dithiophene or derivatives thereof, methods for their preparation and monomers used therein, blends, mixtures and formulations containing them, the use of the polymers, blends, mixtures and formulations as semiconductor in organic electronic (OE) devices, especially in organic photovoltaic (OPV) devices, and to OE and OPV devices comprising these polymers, blends, mixtures or formulations.

### Background

In recent years there has been growing interest in the use of conjugated, semiconducting polymers for electronic applications. One particular area of importance is organic photovoltaics (OPV). Conjugated polymers have found use in OPVs as they allow devices to be manufactured by solution-processing techniques such as spin casting, dip coating or ink jet printing. Solution processing can be carried out cheaper and on a larger scale compared to the evaporative techniques used to make inorganic thin film devices. Currently, polymer based photovoltaic devices are achieving efficiencies up to 8%.

The conjugated polymer serves as the main absorber of the solar energy, therefore a low band gap is a basic requirement of the ideal polymer design to absorb the maximum of the solar spectrum. A commonly used strategy to provide conjugated polymers with narrow band gap is to utilize alternating copolymers consisting of both electron rich donor units and electron deficient acceptor units within the polymer backbone.

However, the conjugated polymers that have been suggested in prior art for use ion OPV devices do still suffer from certain drawbacks. For example many polymers suffer from limited solubility in commonly used organic solvents, which can inhibit their suitability for device manufacturing methods based on solution processing, or show only limited power conversion efficiency in OPV bulk-hetero-junction devices, or have only limited charge carrier mobility, or are difficult to synthesize and require synthesis methods which are unsuitable for mass production.

Therefore, there is still a need for organic semiconducting (OSC) materials that are easy to synthesize, especially by methods suitable for mass production, show good structural organization and film-forming properties, exhibit good electronic properties, especially a high charge carrier mobility, good processibility, especially a high solubility in organic solvents, and high stability in air. Especially for use in OPV cells, there is a need for OSC materials having a low bandgap, which enable improved light harvesting by the photoactive layer and can lead to higher cell efficiencies, compared to the polymers from prior art.

It was an aim of the present invention to provide compounds for use as organic semiconducting materials that do not have the drawbacks of prior art materials as described above, are easy to synthesize, especially by methods suitable for mass production, and do especially show good processibility, high stability, good solubility in organic solvents, high charge carrier mobility, and a low bandgap. Another aim of the invention was to extend the pool of OSC materials available to the expert. Other aims of the present invention are immediately evident to the expert from the following detailed description.

The inventors of the present invention have found that one or more of the above aims can be achieved by providing conjugated polymers containing 4,8-bis(1,1-difluoralkyl)-benzo[1,2-b:4,5-b']dithiophene repeating units.

Polymers comprising a benzo[1,2-b:4,5-b']dithiophene unit have been disclosed in US 7,524,922 B2, US 2010/0078074 A1, WO 2010/135701 A1 and WO 2010/008672 A1. However these documents do not disclose or suggest polymers according to the present invention.

It was found that conjugated polymers based on these units show good processability and high solubility in organic solvents, and are thus especially suitable for large scale production using solution processing methods. At the same time, they show a low bandgap, high charge carrier mobility, high external quantum efficiency in BHJ solar cells, good morphology when used in p/n-type blends e.g. with fullerenes, high oxidative stability, and are promising materials for organic electronic OE devices, especially for OPV devices with high power conversion efficiency.

The addition of a 1,1-difluoralkyl) ketone substituent at the 4- and 8-position of the benzo[1,2-b:4,5-b']dithiophene core unit yields the novel 4,8-bis(1,1-difluoralkyl)-benzo[1,2-b:4,5-b']dithiophene unit according to the present invention, which show inter alia improved solubility and electronic properties.

Incorporation of one or more electron-accepting units in addition to the electron-donating benzo[1,2-b:4,5-b']dithiophene unit yields a "donor-acceptor" co-polymer, enabling a reduction of the bandgap and thereby improved light harvesting properties in bulk heterojunction (BHJ) photovoltaic devices.

### Summary

The invention relates to conjugated polymers comprising one or more divalent units of formula I 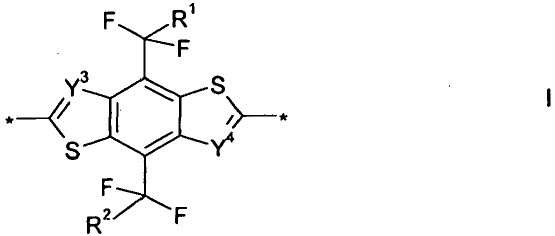 wherein
- Y³: is N or CR³,
- Y⁴: is N or CR⁴,
- R¹, R²: denote independently of each other, and on each occurrence identically or differently, straight-chain, branched or cyclic alkyl with 1 to 30 C atoms, preferably 1 to 20 C atoms, in which one or more non-adjacent C atoms are optionally replaced by -O-, - S-, -C(O)-, -C(O)-O-, -O-C(O)-, -CH=CH- or -C≡C- and which are unsubstituted or substituted by F, Cl, Br, I or CN,
- R³, R⁴: denote independently of each other, and on each occurrence identically or differently, H, halogen, or an optionally substituted carbyl or hydrocarbyl group, wherein one or more C atoms are optionally replaced by a hetero atom.

The invention further relates to conjugated polymers comprising one or more repeating units, wherein said repeating units contain a unit of formula I and/or one or more groups selected from aryl and heteroaryl groups that are optionally substituted, and wherein at least one repeating unit in the polymer contains at least one unit of formula I.

The invention further relates to monomers containing a unit of formula I and further containing one or more reactive groups, which can be used for the preparation of conjugated polymers as described above and below.

The invention further relates to the use of units of formula I as electron donor units in semiconducting polymers.

The invention further relates to a semiconducting polymer comprising one or more units of formula I as electron donor units, and preferably further comprising one or more units having electron acceptor properties.

The invention further relates to the use of the polymers according to the present invention as p-type semiconductors.

The invention further relates to the use of the polymers according to the present invention as electron donor component in semiconducting materials, formulations, blends, devices or components of devices.

The invention further relates to a semiconducting material, formulation, blend, device or component of a device comprising a polymer according to the present invention as electron donor component, and preferably further comprising one or more compounds or polymers having electron acceptor properties.

The invention further relates to a mixture or polymer blend comprising one or more polymers according to the present invention and one or more additional compounds or polymers which are preferably selected from compounds and polymers having one or more of semiconducting, charge transport, hole or electron transport, hole or electron blocking, electrically conducting, photoconducting or light emitting properties.

The invention further relates to a mixture or polymer blend as described above and below, which comprises one or more polymers according to of the present invention and one or more n-type organic semiconductor compounds, preferably selected from fullerenes or substituted fullerenes.

The invention further relates to a formulation comprising one or more polymers, mixtures or polymer blends according to the present invention and optionally one or more solvents, preferably selected from organic solvents.

The invention further relates to the use of polymers, mixtures, polymer blends and formulations according to the present invention as charge transport, semiconducting, electrically conducting, photoconducting or light emitting material in an optical, electrooptical, electronic, electroluminescent or photoluminescent device, or in a component of such a device, or in an assembly comprising such a device or component.

The invention further relates to a charge transport, semiconducting, electrically conducting, photoconducting or light emitting material or component comprising one or more polymers, mixtures, polymer blends or formulations according to the present invention.

The invention further relates to an optical, electrooptical, electronic, electroluminescent or photoluminescent device, or a component thereof, or an assembly comprising it, which comprises one or more polymers, mixtures, polymer blends or formulations according to the present invention, or comprises a charge transport, semiconducting, electrically conducting, photoconducting or light emitting material according to the present invention.

The optical, electrooptical, electronic, electroluminescent and photoluminescent devices include, without limitation, organic field effect transistors (OFETs), organic thin film transistors (OTFTs), organic light emitting diodes (OLEDs), organic light emitting transistors (OLETs), organic photovoltaic devices (OPVs), organic solar cells, laser diodes, organic plasmon-emitting diodes (OPEDs), Schottky diodes, oganic photoconductors (OPCs) and organic photodetectors (OPDs).

The components of the above devices include, without limitation, charge injection layers, charge transport layers, interlayers, planarising layers, antistatic films, polymer electrolyte membranes (PEMs), conducting substrates and conducting patterns.

The assemblies comprising such devices or components include, without limitation, integrated circuits (ICs), radio frequency identification (RFID). tags or security markings or security devices containg them, flat panel displays or backlights thereof, electrophotographic devices, electrophotographic recording devices, organic memory devices, sensor devices, biosensors and biochips.

In addition the compounds, polymers, mixtures, polymer blends and formulations of the present invention can be used as electrode materials in batteries and in components or devices for detecting and discriminating DNA sequences.

### Brief Description of the Drawings

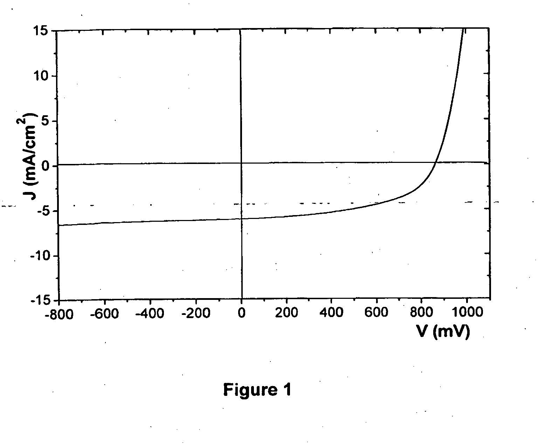

Figure 1 shows the J-V curve for an OPV device of Example 6.

### Detailed Description

The monomers and polymers of the present invention are easy to synthesize and exhibit several advantageous properties, like a low bandgap, a high charge carrier mobility, a high solubility in organic solvents, a good processability for the device manufacture process, a high oxidative stability and a long lifetime in electronic devices.

The unit of formula I is especially suitable as (electron) donor unit in p-type semiconducting polymers or copolymers, in particular copolymers containing both donor and acceptor units, and for the preparation of blends of p-type and n-type semiconductors which are useful for application in bulk heterojunction photovoltaic devices.

In addition, they show the following advantageous properties:
i) The 1,1-difluoroalkyl side chains reduce the electron density in the benzo[1,2-b;4,5-b']dithiophene core thus lowering the polymer HOMO energy level and increasing the open circuit potential (V_{oc}) and consequently the efficiency of the OPV device.
ii) The 1,1-difluoroalkyl side chains reduce the electron density in the overall polymer backbone thus lowering the polymer LUMO energy level and reducing the energy lost during the electron transfer process between the polymer (donor) and the fullerene derivative (acceptor) in the bulk heterojunction.
iii) The 1,1-difluoroalkyl side chains increase the polymer lifetime compared, for example, to an ester functionality with similar electron-withdrawing properties.

The synthesis of the unit of formula I, its functional derivatives, homopolymer, and co-polymers can be achieved based on methods that are known to the skilled person and described in the literature, as will be further illustrated herein.

Above and below, the term "polymer" generally means a molecule of high relative molecular mass, the structure of which essentially comprises the multiple repetition of units derived, actually or conceptually, from molecules of low relative molecular mass (PAC, 1996, 68, 2291). The term "oligomer" generally means a molecule of intermediate relative molecular mass, the structure of which essentially comprises a small plurality of units derived, actually or conceptually, from molecules of lower relative molecular mass (PAC, 1996, 68, 2291). In a preferred sense according to the present invention a polymer means a compound having > 1, i.e. at least 2 repeating units, preferably ≥ 5 repeating units, and an oligomer means a compound with > 1 and < 10, preferably < 5, repeating units.

Above and below, in a formula showing a polymer or a repeating unit, like formula I and its subformulae, an asterisk ("*") denotes a linkage to an adjacent repeating unit or a terminal group in the polymer chain.

The terms "repeating unit" and "monomeric unit" mean the constitutional repeating unit (CRU), which is the smallest constitutional unit the repetition of which constitutes a regular macromolecule, a regular oligomer molecule, a regular block or a regular chain (PAC, 1996, 68, 2291).

The terms "donor" and "acceptor", unless stated otherwise, mean an electron donor or electron acceptor, respectively. "Electron donor" means a chemical entity that donates electrons to another compound or another group of atoms of a compound. "Electron acceptor" means a chemical entity that accepts electrons transferred to it from another compound or another group of atoms of a compound. (see also U.S. Environmental Protection Agency, 2009, Glossary of technical terms, http://www.epa.gov/oust/cat/TUMGLOSS.HTM).

The term "leaving group" means an atom or group (charged or uncharged) that becomes detached from an atom in what is considered to be the residual or main part of the molecule taking part in a specified reaction (see also PAC, 1994, 66, 1134).

The term "conjugated" means a compound containing mainly C atoms with sp²-hybridisation (or optionally also sp-hybridisation), which may also be replaced by hetero atoms. In the simplest case this is for example a compound with alternating C-C single and double (or triple) bonds, but does also include compounds with units like 1,3-phenylene. "Mainly" means in this connection that a compound with naturally (spontaneously) occurring defects, which may lead to interruption of the conjugation, is still regarded as a conjugated compound.

Unless stated otherwise, the molecular weight is given as the number average molecular weight Mₙ or weight average molecular weight M_{w}, which is determined by gel permeation chromatography (GPC) against polystyrene standards in eluent solvents such as tetrahydrofuran, trichloromethane (TCM, chloroform), chlorobenzene or 1, 2, 4-trichlorobenzene. Unless stated otherwise, 1,2,4-trichlorobenzene is used as solvent. The degree of polymerization, also referred to as total number of repeating units, n, means the number average degree of polymerization given as n = Mₙ/M_{U}, wherein Mₙ is the number average molecular weight and M_{U} is the molecular weight of the single repeating unit, see J. M. G. Cowie, Polymers: Chemistry & Physics of Modem Materials, Blackie, Glasgow, 1991.

The term "carbyl group" as used above and below denotes any monovalent or multivalent organic radical moiety which comprises at least one carbon atom either without any non-carbon atoms (like for example -C=C-), or optionally combined with at least one non-carbon atom such as N, O, S, P, Si, Se, As, Te or Ge (for example carbonyl etc.). The term "hydrocarbyl group" denotes a carbyl group that does additionally contain one or more H atoms and optionally contains one or more hetero atoms like for example N, O, S, P, Si, Se, As, Te or Ge.

The term "hetero atom" means an atom in an organic compound that is not a H- or C-atom, and preferably means N, O, S, P, Si, Se, As, Te or Ge.

A carbyl or hydrocarbyl group comprising a chain of 3 or more C atoms may be straight-chain, branched and/or cyclic, including spiro and/or fused rings.

Preferred carbyl and hydrocarbyl groups include alkyl, alkoxy, alkylcarbonyl, alkoxycarbonyl, alkylcarbonyloxy and alkoxycarbonyloxy, each of which is optionally substituted and has 1 to 40, preferably 1 to 25, very preferably 1 to 18 C atoms, furthermore optionally substituted aryl or aryloxy having 6 to 40, preferably 6 to 25 C atoms, furthermore alkylaryloxy, arylcarbonyl, aryloxycarbonyl, arylcarbonyloxy and aryloxycarbonyloxy, each of which is optionally substituted and has 6 to 40, preferably 7 to 40 C atoms, wherein all these groups do optionally contain one or more hetero atoms, preferably selected from N, O, S, P, Si, Se, As, Te and Ge.

The carbyl or hydrocarbyl group may be a saturated or unsaturated acyclic group, or a saturated or unsaturated cyclic group. Unsaturated acyclic or cyclic groups are preferred, especially aryl, alkenyl and alkynyl groups (especially ethynyl). Where the C₁-C₄₀ carbyl or hydrocarbyl group is acyclic, the group may be straight-chain or branched. The C₁-C₄₀ carbyl or hydrocarbyl group includes for example: a C₁-C₄₀ alkyl group, a C₁-C₄₀ alkoxy or oxaalkyl group, a C₂-C₄₀ alkenyl group, a C₂-C₄₀ alkynyl group, a C₃-C₄₀ allyl group, a C₄-C₄₀ alkyldienyl group, a C₄-C₄₀ polyenyl group, a C₆-C₁₈ aryl group, a C₆-C₄₀ alkylaryl group, a C₆-C₄₀ arylalkyl group, a C₄-C₄₀ cycloalkyl group, a C₄-C₄₀ cycloalkenyl group, and the like. Preferred among the foregoing groups are a C₁-C₂₀ alkyl group, a C₂-C₂₀ alkenyl group, a C₂ -C₂₀ alkynyl group, a C₃-C₂₀ allyl group, a C₄-C₂₀ alkyldienyl group, a C₆-C₁₂ aryl group, and a C₄-C₂₀ polyenyl group, respectively. Also included are combinations of groups having carbon atoms and groups having hetero atoms, like e.g. an alkynyl group, preferably ethynyl, that is substituted with a silyl group, preferably a trialkylsilyl group.

Aryl and heteroaryl preferably denote a mono-, bi- or tricyclic aromatic or heteroaromatic group with 4 to 30 ring C atoms that may also comprise condensed rings and is optionally substituted with one or more groups L,
wherein L is selected from halogen, -CN, -NC, -NCO, -NCS, -OCN, -SCN, -C(=O)NR⁰R⁰⁰, -C(=O)X⁰, -C(=O)R⁰, -NH₂, -NR⁰R⁰⁰, -SH, -SR⁰, -SO₃H,-SO₂R⁰, -OH, -NO₂, -CF₃, -SF₅, P-Sp-, optionally substituted silyl, or carbyl or hydrocarbyl with 1 to 40 C atoms that is optionally substituted and optionally comprises one or more hetero atoms, and is preferably alkyl, alkoxy, thiaalkyl, alkylcarbonyl, alkoxycarbonyl or alkoxycarbonyloxy with 1 to 20 C atoms that is optionally fluorinated, and R⁰, R⁰⁰, X⁰, P and Sp have the meanings given above and below.

Very preferred substituents L are selected from halogen, most preferably F, or alkyl, alkoxy, oxaalkyl, thioalkyl, fluoroalkyl and fluoroalkoxy with 1 to 12 C atoms or alkenyl, alkynyl with 2 to 12 C atoms.

Especially preferred aryl and heteroaryl groups are phenyl in which, in addition, one or more CH groups may be replaced by N, naphthalene, thiophene, selenophene, thienothiophene, dithienothiophene, fluorene and oxazole, all of which can be unsubstituted, mono- or polysubstituted with L as defined above. Very preferred rings are selected from pyrrole, preferably N-pyrrole, furan, pyridine, preferably 2- or 3-pyridine, pyrimidine, pyridazine, pyrazine, triazole, tetrazole, pyrazole, imidazole, isothiazole, thiazole, thiadiazole, isoxazole, oxazole, oxadiazole, thiophene preferably 2-thiophene, selenophene, preferably 2-selenophene, thieno[3,2-b]thiophene, indole, isoindole, benzofuran, benzothiophene, benzodithiophene, quinole, 2- methylquinole, isoquinole, quinoxaline, quinazoline, benzotriazole, benzimidazole, benzothiazole, benzisothiazole, benzisoxazole, benzoxadiazole, benzoxazole, benzothiadiazole, all of which can be unsubstituted, mono- or polysubstituted with L as defined above. Further examples of heteroaryl groups are those selected from the following formulae

An alkyl or alkoxy radical, i.e. where the terminal CH₂ group is replaced by -O-, can be straight-chain or branched. It is preferably straight-chain, has 2, 3, 4, 5, 6, 7 or 8 carbon atoms and accordingly is preferably ethyl, propyl, butyl, pentyl, hexyl, heptyl, octyl, ethoxy, propoxy, butoxy, pentoxy, hexoxy, heptoxy, or octoxy, furthermore methyl, nonyl, decyl, undecyl, dodecyl, tridecyl, tetradecyl, pentadecyl, nonoxy, decoxy, undecoxy, dodecoxy, tridecoxy or tetradecoxy, for example.

An alkenyl group, wherein one or more CH₂ groups are replaced by - CH=CH- can be straight-chain or branched. It is preferably straight-chain, has 2 to 10 C atoms and accordingly is preferably vinyl, prop-1-, or prop-2-enyl, but-1-, 2- or but-3-enyl, pent-1-, 2-, 3- or pent-4-enyl, hex-1-, 2-, 3-, 4- or hex-5-enyl, hept-1-, 2-, 3-, 4-, 5- or hept-6-enyl, oct-1-, 2-, 3-, 4-, 5-, 6- or oct-7-enyl, non-1-, 2-, 3-, 4-, 5-, 6-, 7- or non-8-enyl, dec-1-, 2-, 3-, 4-, 5-, 6-, 7-, 8- or dec-9-enyl.

Especially preferred alkenyl groups are C₂-C₇-1E-alkenyl, C₄-C₇-3E-alkenyl, C₅-C₇-4-alkenyl, C₆-C₇-5-alkenyl and C₇-6-alkenyl, in particular C₂-C₇-1E-alkenyl, C₄-C₇-3E-alkenyl and C₅-C₇-4-alkenyl. Examples for particularly preferred alkenyl groups are vinyl, 1 E-propenyl, 1E-butenyl, 1E-pentenyl, 1 E-hexenyl, 1E-heptenyl, 3-butenyl, 3E-pentenyl, 3E-hexenyl, 3E-heptenyl, 4-pentenyl, 4Z-hexenyl, 4E-hexenyl, 4Z-heptenyl, 5-hexenyl, 6-heptenyl and the like. Groups having up to 5 C atoms are generally preferred.

An oxaalkyl group, i.e. where one CH₂ group is replaced by -O-, is preferably straight-chain 2-oxapropyl (=methoxymethyl), 2-(=ethoxymethyl) or 3-oxabutyl (=2-methoxyethyl), 2-, 3-, or 4-oxapentyl, 2-, 3-, 4-, or 5-oxahexyl, 2-, 3-, 4-, 5-, or 6-oxaheptyl, 2-, 3-, 4-, 5-, 6- or 7-oxaoctyl, 2-, 3-, 4-, 5-, 6-, 7- or 8-oxanonyl or 2-, 3-, 4-, 5-, 6-,7-, 8- or 9-oxadecyl, for example.Oxaalkyl, i.e. where one CH₂ group is replaced by-O-, is preferably straight-chain 2-oxapropyl (=methoxymethyl), 2-(=ethoxymethyl) or 3-oxabutyl (=2-methoxyethyl), 2-, 3-, or 4-oxapentyl, 2-, 3-, 4-, or 5-oxahexyl, 2-, 3-, 4-, 5-, or 6-oxaheptyl, 2-, 3-, 4-, 5-, 6- or 7-oxaoctyl, 2-, 3-, 4-, 5-, 6-, 7- or 8-oxanonyl or 2-, 3-, 4-, 5-, 6-,7-, 8- or 9-oxadecyl, for example.

In an alkyl group wherein one CH₂ group is replaced by -O- and one by-C(O)-, these radicals are preferably neighboured. Accordingly these radicals together form a carbonyloxy group -C(O)-O- or an oxycarbonyl group -O-C(O)-. Preferably this group is straight-chain and has 2 to 6 C atoms. It is accordingly preferably acetyloxy, propionyloxy, butyryloxy, pentanoyloxy, hexanoyloxy, acetyloxymethyl, propionyloxymethyl, butyryloxymethyl, pentanoyloxymethyl, 2-acetyloxyethyl, 2-propionyloxy-ethyl, 2-butyryloxyethyl, 3-acetyloxypropyl, 3-propionyloxypropyl, 4-acetyloxybutyl, methoxycarbonyl, ethoxycarbonyl, propoxycarbonyl, butoxycarbonyl, pentoxycarbonyl, methoxycarbonylmethyl, ethoxycarbonylmethyl, propoxycarbonylmethyl, butoxycarbonylmethyl, 2-(methoxycarbonyl)ethyl, 2-(ethoxycarbonyl)ethyl, 2-(propoxy-carbonyl)ethyl, 3-(methoxycarbonyl)propyl, 3-(ethoxycarbonyl)propyl, 4-(methoxycarbonyl)-butyl.

An alkyl group wherein two or more CH₂ groups are replaced by -O-and/or -C(O)O- can be straight-chain or branched. It is preferably straight-chain and has 3 to 12 C atoms. Accordingly it is preferably bis-carboxymethyl, 2,2-bis-carboxy-ethyl, 3,3-bis-carboxy-propyl, 4,4-bis-carboxy-butyl, 5,5-bis-carboxy-pentyl, 6,6-bis-carboxy-hexyl, 7,7-bis-carboxy-heptyl, 8,8-bis-carboxy-octyl, 9,9-bis-carboxy-nonyl, 10,10-bis-carboxy-decyl, bis-(methoxycarbonyl)-methyl, 2,2-bis-(methoxycarbonyl)-ethyl, 3,3-bis-(methoxycarbonyl)-propyl, 4,4-bis-(methoxycarbonyl)-butyl, 5,5-bis-(methoxycarbonyl)-pentyl, 6,6-bis-(methoxycarbonyl)-hexyl, 7,7-bis-(methoxycarbonyl)-heptyl, 8,8-bis-(methoxycarbonyl)-octyl, bis-(ethoxycarbonyl)-methyl, 2,2-bis-(ethoxycarbonyl)-ethyl, 3,3-bis-(ethoxycarbonyl)-propyl, 4,4-bis-(ethoxycarbonyl)-butyl, 5,5-bis-(ethoxycarbonyl)-hexyl.

A thioalkyl group, i.e where one CH₂ group is replaced by -S-, is preferably straight-chain thiomethyl (-SCH₃), 1-thioethyl (-SCH₂CH₃), 1-thiopropyl (= -SCH₂CH₂CH₃), 1- (thiobutyl), 1-(thiopentyl), 1-(thiohexyl), 1-(thioheptyl), 1-(thiooctyl), 1-(thiononyl), 1-(thiodecyl), 1-(thioundecyl) or 1-(thiododecyl), wherein preferably the CH₂ group adjacent to the sp² hybridised vinyl carbon atom is replaced.

A fluoroalkyl group is preferably straight-chain perfluoroalkyl CᵢF₂ᵢ₊₁, wherein i is an integer from 1 to 15, in particular CF₃, C₂F₅; C₃F₇, C₄F₉, C₅F₁₁, C₆F₁₃, C₇F₁₅ or C₈F₁₇, very preferably C₆F₁₃.

The above-mentioned alkyl, alkoxy, alkenyl, oxaalkyl, thioalkyl, carbonyl and carbonyloxy groups can be achiral or chiral groups. Particularly preferred chiral groups are 2-butyl (=1-methylpropyl), 2-methylbutyl, 2-methylpentyl, 3-methylpentyl, 2-ethylhexyl, 2-propylpentyl, in particular 2-methylbutyl, 2-methylbutoxy, 2-methylpentoxy, 3-methylpentoxy, 2-ethyl-hexoxy, 1-methylhexoxy, 2-octyloxy, 2-oxa-3-methylbutyl, 3-oxa-4-methylpentyl, 4-methylhexyl, 2-hexyl, 2-octyl, 2-nonyl, 2-decyl, 2-dodecyl, 6-methoxyoctoxy, 6-methyloctoxy, 6-methyloctanoyloxy, 5-methylheptyloxycarbonyl, 2-methylbutyryloxy, 3-methylvaleroyloxy, 4-methylhexanoyloxy, 2-chloropropionyloxy, 2-chloro-3-methylbutyryloxy, 2-chloro-4-methyl-valeryloxy, 2-chloro-3-methylvaleryloxy, 2-methyl-3-oxapentyl, 2-methyl-3-oxahexyl, 1-methoxypropyl-2-oxy, 1-ethoxypropyl-2-oxy, 1-propoxypropyl-2-oxy, 1-butoxypropyl-2-oxy, 2-fluorooctyloxy, 2-fluorodecyloxy, 1,1,1-trifluoro-2-octyloxy, 1,1,1-trifluoro-2-octyl, 2-fluoromethyloctyloxy for example. Very preferred are 2-hexyl, 2-octyl, 2-octyloxy, 1,1,1-trifluoro-2-hexyl, 1,1,1-trifluoro-2-octyl and 1,1,1-trifluoro-2-octyloxy.

Preferred achiral branched groups are isopropyl, isobutyl (=methylpropyl), isopentyl (=3-methylbutyl), tert. butyl, isopropoxy, 2-methyl-propoxy and 3-methylbutoxy.

In another preferred embodiment of the present invention, R³ and R⁴ are independently of each other selected from primary, secondary or tertiary alkyl or alkoxy with 1 to 30 C atoms, wherein one or more H atoms are optionally replaced by F, or aryl, aryloxy, heteroaryl or heteroaryloxy that is optionally alkylated or alkoxylated and has 4 to 30 ring atoms. Very preferred groups of this type are selected from the group consisting of the following formulae 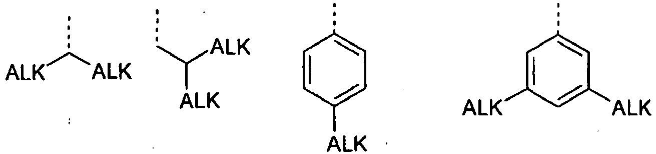 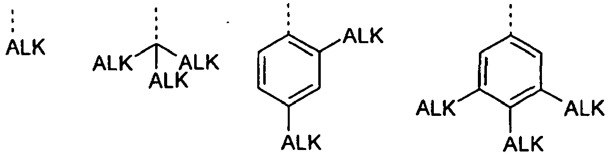 wherein "ALK" denotes optionally fluorinated, preferably linear, alkyl or alkoxy with 1 to 20, preferably 1 to 12 C-atoms, in case of tertiary groups very preferably 1 to 9 C atoms, and the dashed line denotes the link to the ring to which these groups are attached. Especially preferred among these groups are those wherein all ALK subgroups are identical.

-CY¹=CY²- is preferably -CH=CH-, -CF=CF- or -CH=C(CN)-.

Halogen is F, Cl, Br or I, preferably F, Cl or Br.

-CO-, -C(=O)- and -C(O)- denote a carbonyl group, i.e.

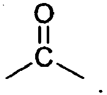

The units and polymers may also be substituted with a polymerisable or crosslinkable reactive group, which is optionally protected during the process of forming the polymer. Particular preferred units polymers of this type are those comprising one or more units of formula I wherein one or more of R¹⁻⁴ denote or contain a group P-Sp-. These units and polymers are particularly useful as semiconductors or charge transport materials, as they can be crosslinked via the groups P, for example by polymerisation in situ, during or after processing the polymer into a thin film for a semiconductor component, to yield crosslinked polymer films with high charge carrier mobility and high thermal, mechanical and chemical stability.

Preferably the polymerisable or crosslinkable group P is selected from CH₂=CW¹-C(O)-O-, CH₂=CW¹-C(O)-, 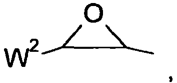 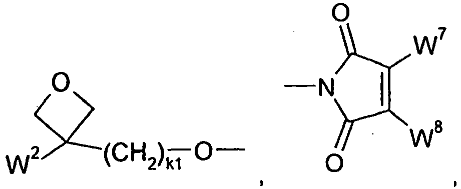 CH₂=CW²-(O)ₖ₁-, CW¹=CH-C(O)-(O)ₖ₃-, CW¹=CH-C(O)-NH-, CH₂=CW¹-C(O)-NH-, CH₃-CH=CH-O-, (CH₂=CH)₂CH-OC(O)-, (CH₂=CH-CH₂)₂CH-O-C(O)-, (CH₂=CH)₂CH-O-, (CH₂=CH-CH₂)₂N-, (CH₂=CH-CH₂)₂N-C(O)-, HO-CW²W³-, HS-CW²W³-, HW²N-, HO-CW²W³-NH-, CH₂=CH-(C(O)-O)ₖ₁-Phe-(O)ₖ₂-, CH₂=CH-(C(O))ₖ₁-Phe-(O)ₖ₂-, Phe-CH=CH-, HOOC-, OCN-, and W⁴W⁵W⁶Si-, with W¹ being H, F, Cl, CN, CF₃, phenyl or alkyl with 1 to 5 C-atoms, in particular H, Cl or CH₃, W² and W³ being independently of each other H or alkyl with 1 to 5 C-atoms, in particular H, methyl, ethyl or n-propyl, W⁴, W⁵ and W⁶ being independently of each other Cl, oxaalkyl or oxacarbonylalkyl with 1 to 5 C-atoms, W⁷ and W⁸ being independently of each other H, Cl or alkyl with 1 to 5 C-atoms, Phe being 1,4-phenylene that is optionally substituted by one or more groups L as defined above, k₁, k₂ and k₃ being independently of each other 0 or 1, k₃ preferably being 1, and k₄ being an integer from 1 to 10.

Alternatively P is a protected derivative of these groups which is non-reactive under the conditions described for the process according to the present invention. Suitable protective groups are known to the ordinary expert and described in the literature, for example in Green, "Protective Groups in Organic Synthesis", John Wiley and Sons, New York (1981), like for example acetals or ketals.

Especially preferred groups P are CH₂=CH-C(O)-O-, CH₂=C(CH₃)-C(O)-O-, CH₂=CF-C(O)-O-, CH₂=CH-O-, (CH₂=CH)₂CH-O-C(O)-, (CH₂=CH)₂CH-O-, 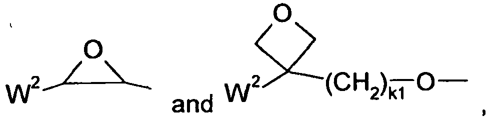 or protected derivatives thereof. Further preferred groups P are selected from the group consisting of vinyloxy, acrylate, methacrylate, fluoroacrylate, chloracrylate, oxetan and epoxy groups, very preferably from an acrylate or methacrylate group.

Polymerisation of group P can be carried out according to methods that are known to the ordinary expert and described in the literature, for example in D. J. Broer; G. Challa; G. N. Mol, *Macromol. Chem,* 1991, **192**, 59.

The term "spacer group" is known in prior art and suitable spacer groups Sp are known to the ordinary expert (see e.g. Pure Appl. Chem. 73(5), 888 (2001). The spacer group Sp is preferably of formula Sp'-X', such that P-Sp- is P-Sp'-X'-, wherein
- Sp': is alkylene with up to 30 C atoms which is unsubstituted or mono- or polysubstituted by F, Cl, Br, I or CN, it being also possible for one or more non-adjacent CH₂ groups to be replaced, in each case independently from one another, by-O-, -S-, -NH-, -NR⁰-, -SiR⁰R⁰⁰-, -C(O)-, -C(O)O-, -OC(O)-, - OC(O)-O-, -S-C(O)-, -C(O)-S-, -CH=CH- or -C≡C- in such a manner that O and/or S atoms are not linked directly to one another,
- X': is -O-, -S-, -C(O)-, -C(O)O-, -OC(O)-, -O-C(O)O-, -C(O)-NR⁰-, -NR⁰-C(O)-, -NR⁰-C(O)-NR⁰⁰-, -OCH₂-, -CH₂O-, -SCH₂-,-CH₂S-, -CF₂O-, -OCF₂-, -CF₂S-, -SCF₂-, -CF₂CH₂-, -CH₂CF₂-, -CF₂CF₂-, -CH=N-, -N=CH-, -N=N-, -CH=CR⁰-, -CY¹=CY²-,-C≡C-, -CH=CH-C(O)O-, -OC(O)-CH=CH- or a single bond,
- R⁰ and R⁰⁰: are independently of each other H or alkyl with 1 to 12 C-atoms, and
- Y¹ and Y²: are independently of each other H, F, Cl or CN.

X¹ is preferably -O-, -S-, -OCH₂-, -CH₂O-, -SCH₂-, -CH₂S-, -CF₂O-, -OCF₂-, -CF₂S-, -SCF₂-, -CH₂CH₂-, -CF₂CH₂-, -CH₂CF₂-, -CF₂CF₂-, -CH=N-, - N=CH-, -N=N-, -CH=CR⁰-, -CY¹=CY²-, -C≡C- or a single bond, in particular -O-, -S-, -C≡C-, -CY¹=CY²- or a single bond. In another preferred embodiment X' is a group that is able to form a conjugated system, such as -C≡C- or -CY¹=CY²-, or a single bond.

Typical groups Sp' are, for example, -(CH₂)ₚ-, -(CH₂CH₂O)_{q}-CH₂CH₂-,-CH₂CH₂-S-CH₂CH₂- or -CH₂CH₂-NH-CH₂CH₂- or -(SiR⁰R⁰⁰-O)ₚ-, with p being an integer from 2 to 12, q being an integer from 1 to 3 and R⁰ and R⁰⁰ having the meanings given above.

Preferred groups Sp' are ethylene, propylene, butylene, pentylene, hexylene, heptylene, octylene, nonylene, decylene, undecylene, dodecylene, octadecylene, ethyleneoxyethylene, methyleneoxybutylene, ethylene-thioethylene, ethylene-N-methyl-iminoethylene, 1-methylalkylene, ethenylene, propenylene and butenylene for example.

Preferably the units of formula I are selected from the group consisting of the following subformulae 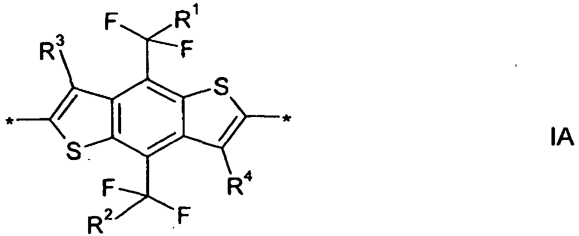 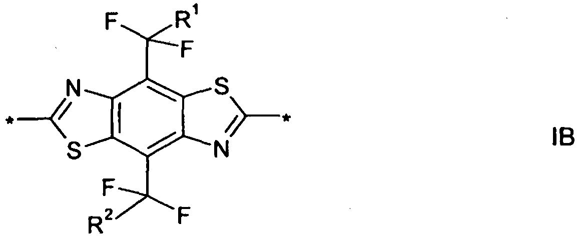 wherein R¹, R², R³ and R⁴ have the meanings given in formula I or one of the preferred meanings given above and below.

Very preferably the units of formula I are selected of subformula IA.

Preferred polymers according to the present invention comprise one or more repeating units of formula II:

-[(Ar¹)ₐ-(U)_{b}-(Ar²)_{c}-(Ar³)_{d}]- II

wherein
- U: is a unit of formula I,
- Ar¹, Ar², Ar³: are, on each occurrence identically or differently, and independently of each other, aryl or heteroaryl that is different from U, preferably has 5 to 30 ring atoms, and is optionally substituted, preferably by one or more groups R^{S},
- R^{S}: is on each occurrence identically or differently F, Br, Cl, -CN, - NC, -NCO, -NCS, -OCN, -SCN, -C(O)NR⁰R⁰⁰, -C(O)X⁰, - C(O)R⁰, -NH₂, -NR⁰R⁰⁰, -SH, -SR⁰, -SO₃H, -SO₂R⁰, -OH, -NO₂, -CF₃, -SF₅, optionally substituted silyl, carbyl or hydrocarbyl with 1 to 40 C atoms that is optionally substituted and optionally comprises one or more hetero atoms, or P-Sp-,
- R⁰ and R⁰⁰: are independently of each other H or optionally substituted C₁₋₄₀ carbyl or hydrocarbyl,
- P: is a polymerisable or crosslinkable group,
- Sp: is a spacer group or a single bond,
- X⁰: is halogen, preferably F, Cl or Br,
- a, b and c: are on each occurrence identically or differently 0, 1 or 2,
- d: is on each occurrence identically or differently 0 or an integer from 1 to 10,
wherein the polymer comprises at least one repeating unit of formula II wherein b is at least 1.

Further preferred polymers according to the present invention comprise, in addition to the units of formula I or II, one or more repeating units selected from monocyclic or polycyclic aryl or heteroaryl groups that are optionally substituted.

These additional repeating units are preferably selected of formula III

-[(Ar¹)ₐ-(A¹)_{b}-(Ar²)_{c}-(Ar³)_{d}]- III

wherein Ar¹, Ar², Ar³, a, b, c and d are as defined in formula II, and A¹ is an aryl or heteroaryl group that is different from U and Ar¹⁻³, preferably has 5 to 30 ring atoms, is optionally substituted by one or more groups R^{S} as defined above and below, and is preferably selected from aryl or heteroaryl groups having electron acceptor properties, wherein the polymer comprises at least one repeating unit of formula III wherein b is at least 1

The conjugated polymers according to the present invention are preferably selected of formula IV: 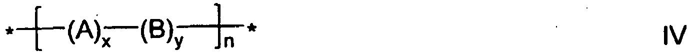 wherein
- A: is a unit of formula I or II or its preferred subformulae,
- B: is a unit that is different from A and comprises one or more aryl or heteroaryl groups that are optionally substituted, and is preferably selected of formula III,
- x: is > 0 and ≤ 1,
- y: is ≥ 0 and < 1,
- x + y: is 1, and
- n: is an integer >1.

Preferred polymers of formula IV are selected of the following formulae

*-[(Ar¹-U-Ar²)ₓ-(Ar³)_{y}]ₙ-* IVa

*-[(Ar¹-U-Ar²)ₓ-(Ar³-Ar³)y]n-* IVb

*-[(Ar¹-U-Ar²)ₓ-(Ar³-Ar³-Ar³)_{y}]ₙ-* IVc

*-[(Ar¹)ₐ-(U)_{b}-(Ar²)_{c}-(Ar³)_{d}]ₙ-* IVd

*-([(Ar¹)ₐ-(U)_{b}-(Ar²)_{c}-(Ar³)_{d}]ₓ-[(Ar¹)ₐ-(A¹)_{b}-(Ar²)_{c}(Ar³)_{d}]_{y})ₙ-* IVe

wherein U, Ar¹, Ar², Ar³, a, b, c and d have in each occurrence identically or differently one of the meanings given in formula II, A¹ has on each occurrence identically or differently one of the meanings given in formula III, and x, y and n are as defined in formula IV, wherein these polymers can be alternating or random copolymers, and wherein in formula IVd and IVe in at least one of the repeating units [(Ar¹)ₐ-(U)_{b}-(Ar²)_{c}-(Ar)_{d}] and in at least one of the repeating units [(Ar¹)ₐ-(A¹)_{b}-(Ar²)_{c}-(Ar³)_{d}] b is at least 1.

In the polymers according to the present invention, the total number of repeating units n is preferably from 2 to 10,000. The total number of repeating units n is preferably ≥ 5, very preferably ≥ 10, most preferably ≥ 50, and preferably ≤ 500, very preferably ≤ 1,000, most preferably ≤ 2,000, including any combination of the aforementioned lower and upper limits of n.

The polymers of the present invention include homopolymers and copolymers, like statistical or random copolymers, alternating copolymers and block copolymers, as well as combinations thereof.

Especially preferred are polymers selected from the following groups:
- Group A consisting of homopolymers of the unit U or (Ar¹-U) or (Ar¹-U-Ar²) or (Ar¹-U-Ar³) or (U-Ar²-Ar³) or (Ar¹-U-Ar²-Ar³), i.e. where all repeating units are identical, ,
- Group B consisting of random or alternating copolymers formed by identical units (Ar¹-U-Ar²) and identical units (Ar³),
- Group C consisting of random or alternating copolymers formed by identical units (Ar¹-U-Ar²) and identical units (A¹),
- Group D consisting of random or alternating copolymers formed by identical units (Ar¹-U-Ar²) and identical units (Ar¹-A¹-Ar²),
wherein in all these groups U, A¹, Ar¹, Ar² and Ar³ are as defined above and below, in groups A, B and C Ar¹, Ar² and Ar³ are different from a single bond, and in group D one of Ar¹ and Ar² may also denote a single bond.

Preferred polymers of formula IV and IVa to IVe are selected of formula V

R⁵-chain-R⁶ V

wherein "chain" denotes a polymer chain of formulae IV or IVa to IVe, and R⁵ and R⁶ have independently of each other one of the meanings of R³ as defined above, or denote, independently of each other, H, F, Br, Cl, I,-CH₂Cl, -CHO, -CR'=CR"₂, -SiR'R"R"', -SiR'X'X", -SiR'R"X', -SnR'R"R"',-BR'R", -B(OR')(OR"), -B(OH)₂, -O-SO₂-R', -C≡CH, -C≡C-SiR'₃, -ZnX', P-Sp- or an endcap group, wherein P and Sp are as defined in formula II, X' and X" denote halogen, R', R" and R"' have independently of each other one of the meanings of R⁰ given in formula II, and two of R', R" and R'" may also form a ring together with the hetero atom to which they are attached.

Preferred endcap groups R⁵ and R⁶ are H, C₁₋₂₀ alkyl, or optionally substituted C₆₋₁₂ aryl or C₂₋₁₀ heteroaryl, very preferably H or phenyl.

In the polymers represented by formula IV, IVa to IVe and V, x denotes the mole fraction of units A, y denotes the mole fraction of units B, and n denotes the degree of polymerisation or total number of units A and B. These formulae includes block copolymers, random or statistical copolymers and alternating copoymers of A and B, as well as homopolymers of A for the case when x is > 0 and y is 0.

Another aspect of the invention relates to monomers of formula VI

R⁷-(Ar¹)ₐ-U-(Ar²)_{c}-R⁸ VI

wherein U, Ar¹, Ar², a and c have the meanings of formula II, or one of the preferred meanings as described above and below, and R⁷ and R⁸ are, preferably independently of each other, selected from the group consisting of Cl, Br, I, O-tosylate, O-triflate, O-mesylate, O-nonaflate, -SiMe₂F,-SiMeF₂, -O-SO₂Z¹, -B(OZ²)₂ , -CZ³=C(Z³)₂, -C≡CH, - C≡CSi(Z¹)₃, -ZnX⁰ and -Sn(Z⁴)₃, wherein X⁰ is halogen, preferably Cl, Br or I, Z¹⁻⁴ are selected from the group consisting of alkyl and aryl, each being optionally substituted, and two groups Z² may also together form a cyclic group.

Especially preferred are monomers of the following formulae

R⁷-Ar¹-U-Ar²-R⁸ VI1

R⁷-U-R⁸ VI2

R⁷-Ar¹-U-R⁸ VI3

R⁷-U-Ar²-R⁸ VI4

wherein U, Ar₁, Ar², R⁷ and R⁸ are as defined in formula VI.

Preferably R¹ and/or R² denote independently of each other straight-chain or branched alkyl with 1 to 20 C atoms which is unsubstituted or substituted by one or more F atoms.

Especially preferred are repeating units, monomers and polymers of formulae I, II, III, IV, IVa to IVe, V, VI and their subformulae wherein one or more of Ar¹, Ar² and Ar³ denote aryl or heteroaryl, preferably having electron donor properties, selected from the group consisting of the following formulae 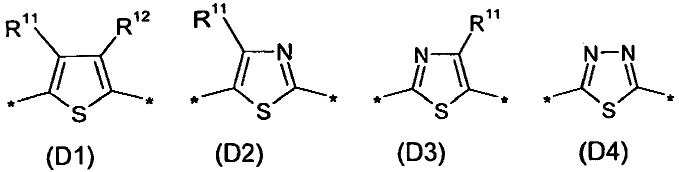 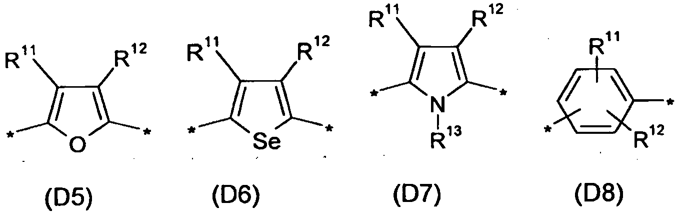 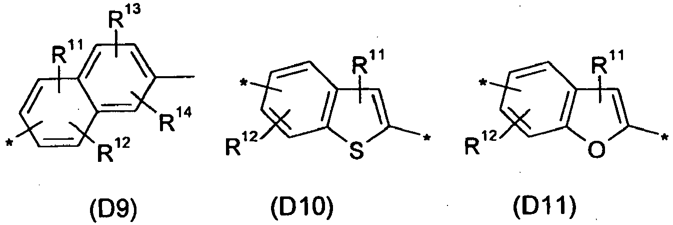 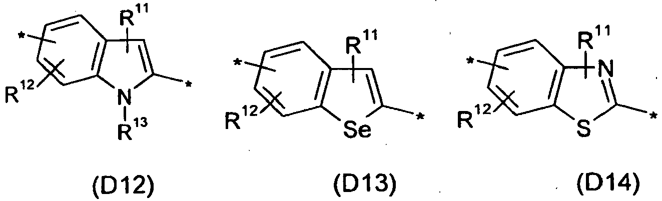 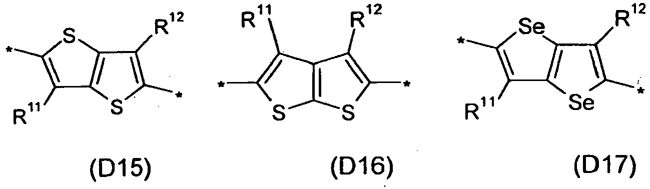 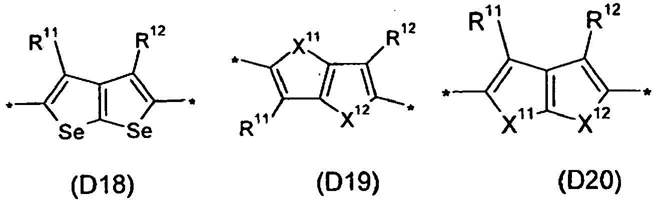 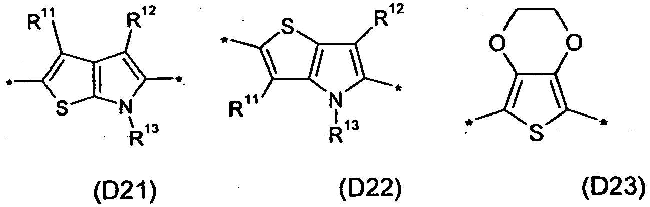 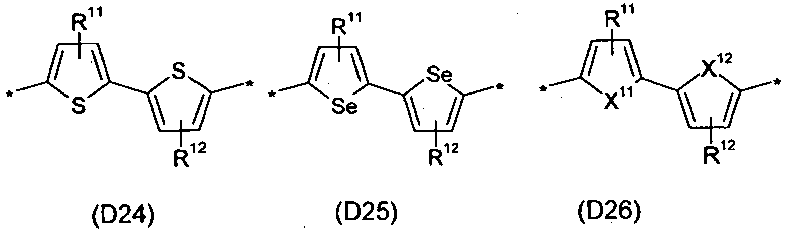 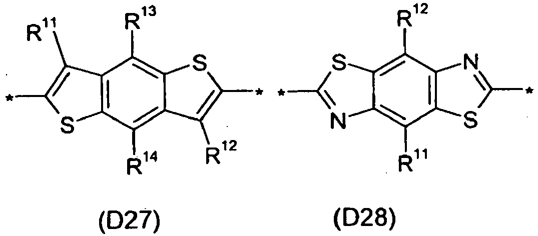 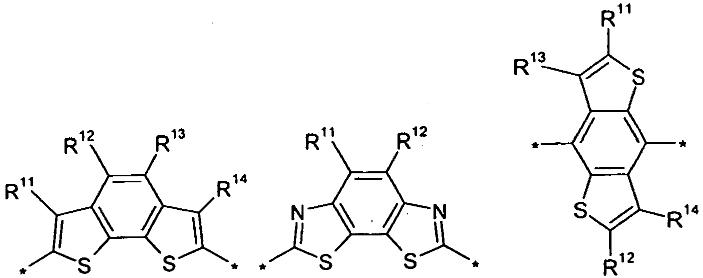 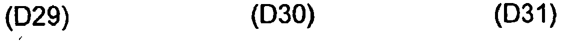 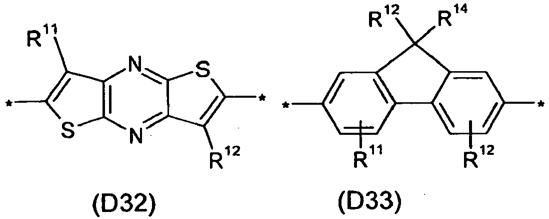 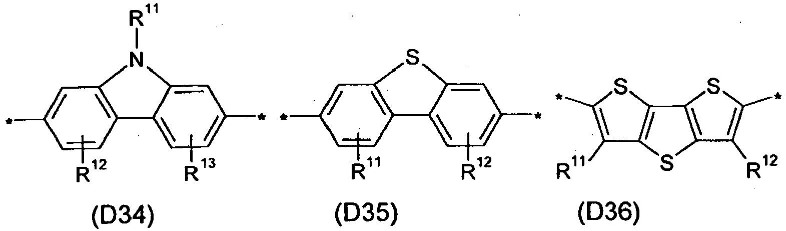 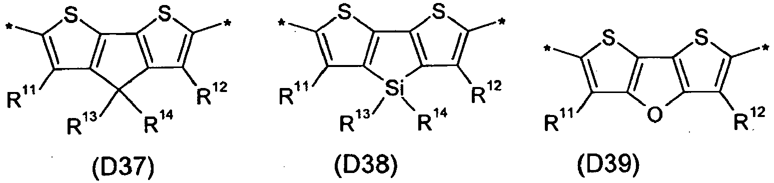 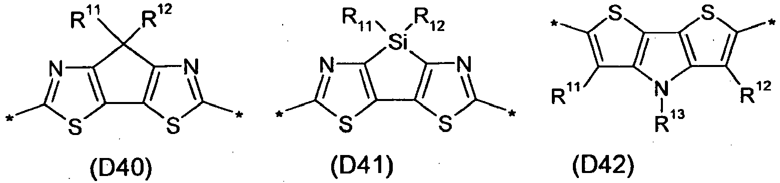 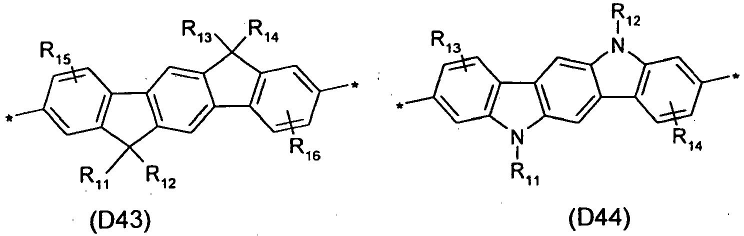 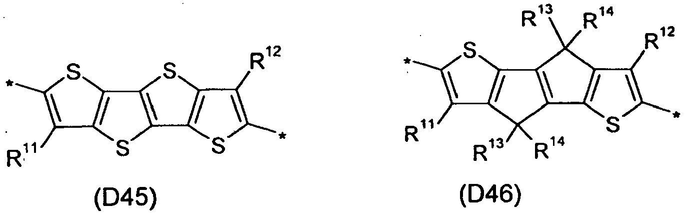 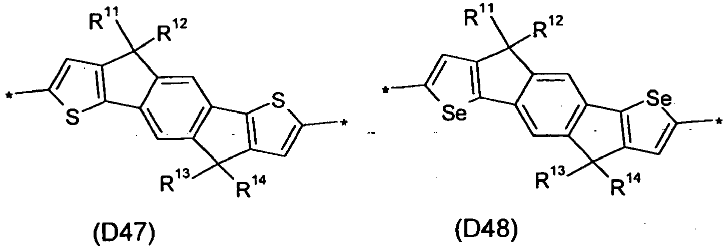 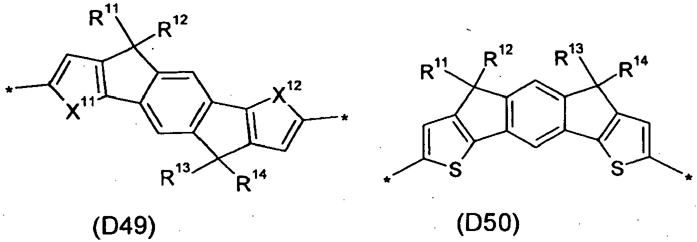 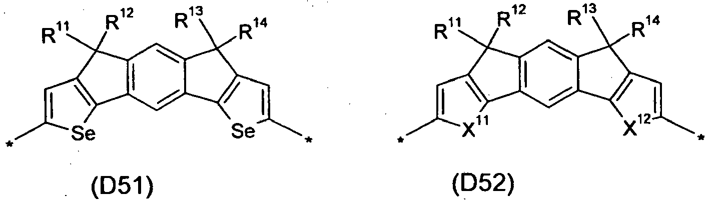 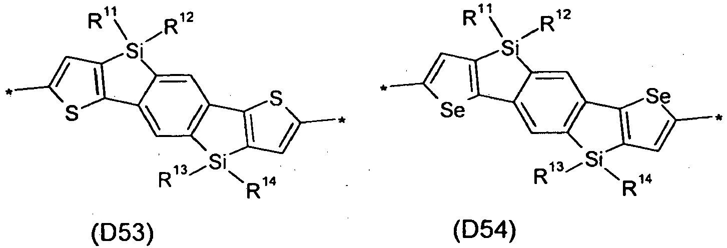 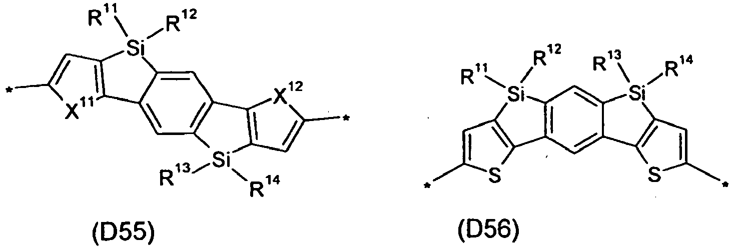 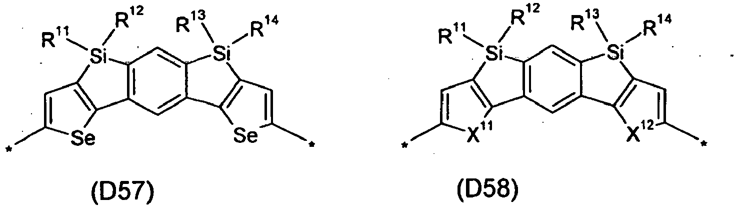 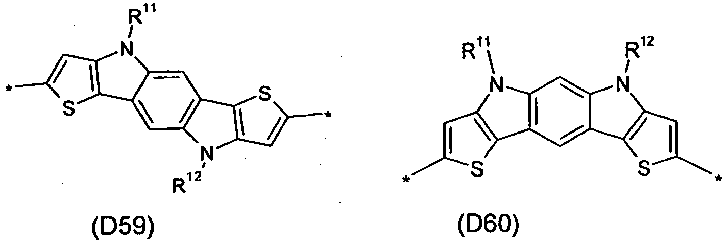 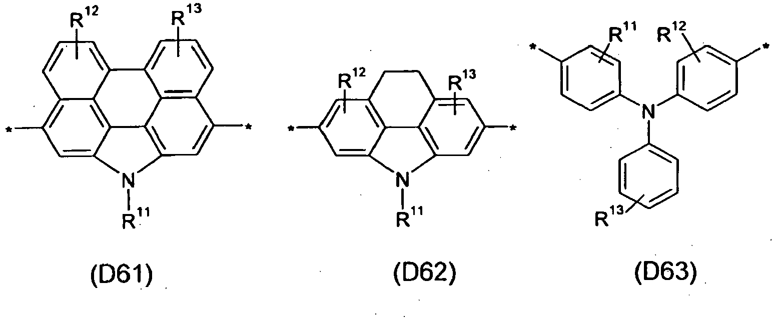 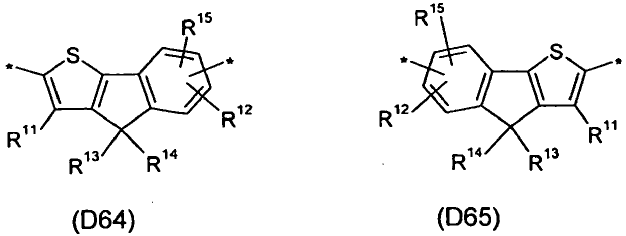 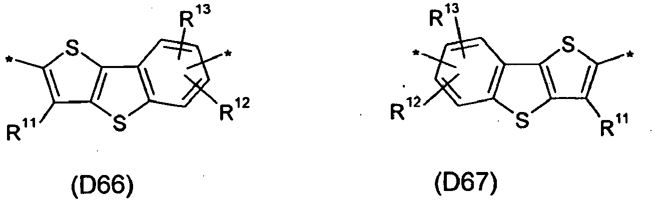 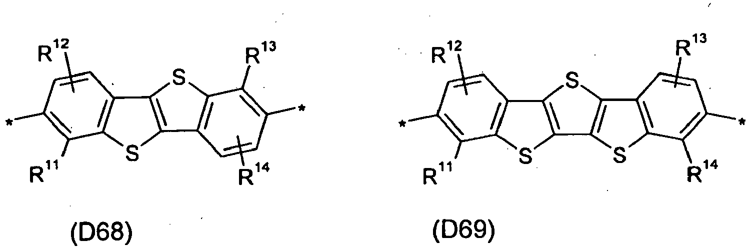 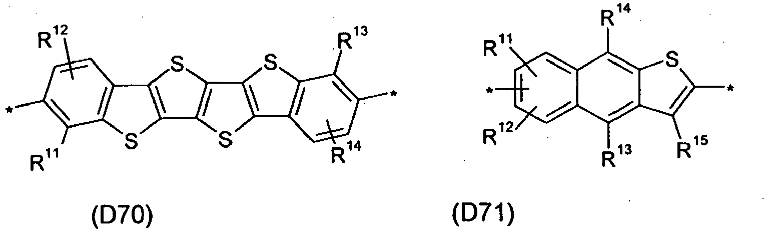 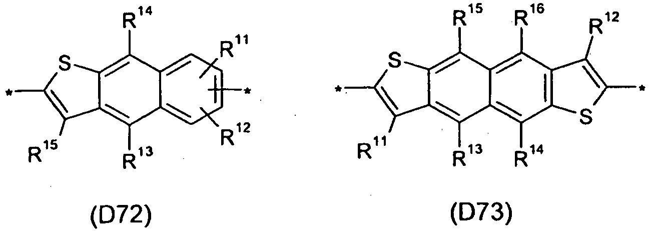 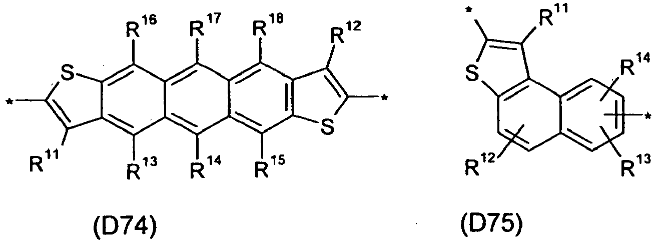 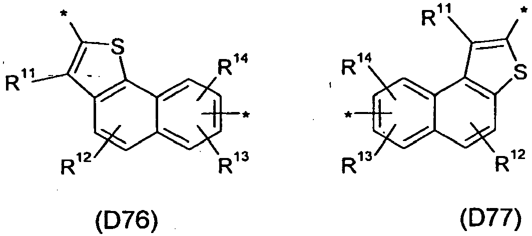 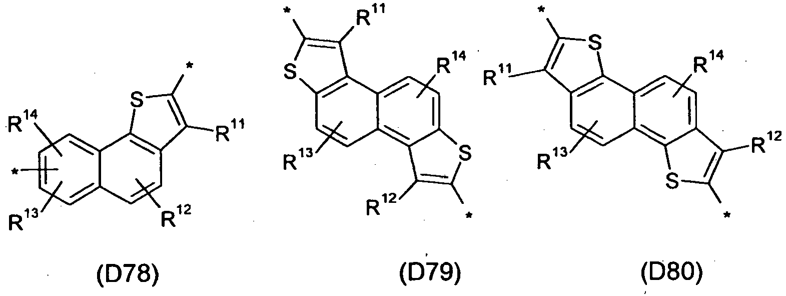 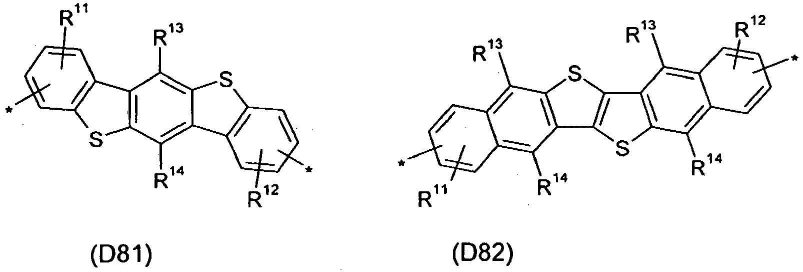 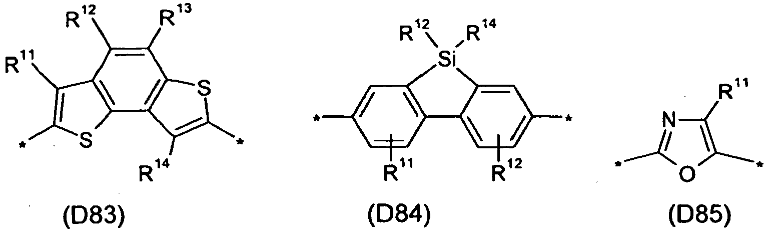 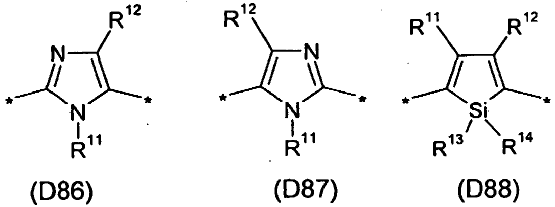 wherein one of X¹¹ and X¹² is S and the other is Se, and R¹¹, R¹², R¹³, R¹⁴, R¹⁵, R¹⁶ , R¹⁷ and R¹⁸ independently of each other denote H or have one of the meanings of R³ as defined above and below.

In a preferred embodiment of the present invention in formula D1 R¹¹ and R¹² denote H. In another preferred embodiment of the present invention in formulae D2, D5, D6, D15, D16 and D24 R¹¹ and R¹² denote H.

Preferably one or more of Ar¹, Ar² and Ar³ are selected from the group consisting of formulae D1, D2, D3, D4, D5, D6, D7, D15, D17, D19, D24, D25, D29 and D26, very preferably from formulae D1, D2, D3, D5, D15, D24 and D29.

Further preferred are repeating units, monomers and polymers of formulae I, II, III, IV, IVa to IVe, V, VI and their subformulae wherein one or more of Ar³ and A¹ denote aryl or heteroaryl, preferably having electron acceptor properties, selected from the group consisting of the following formulae 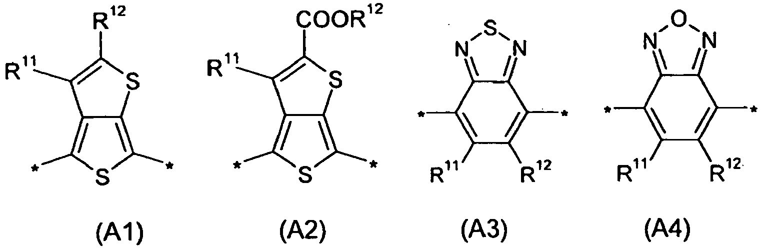 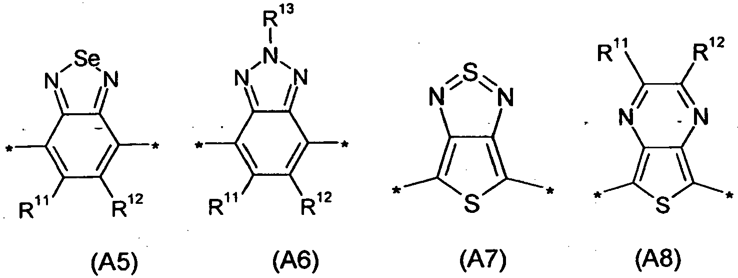 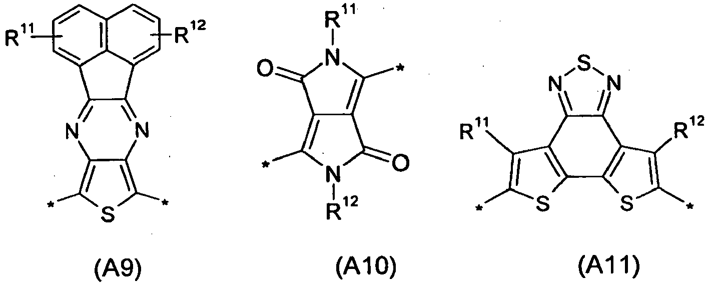 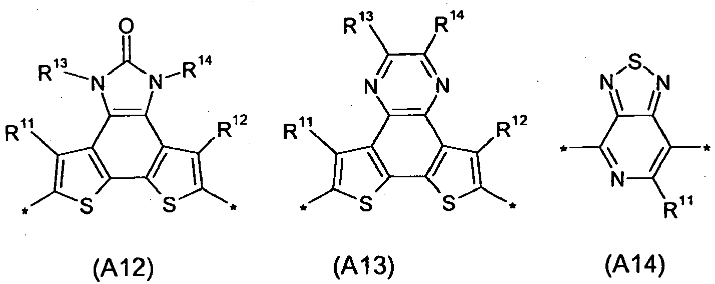 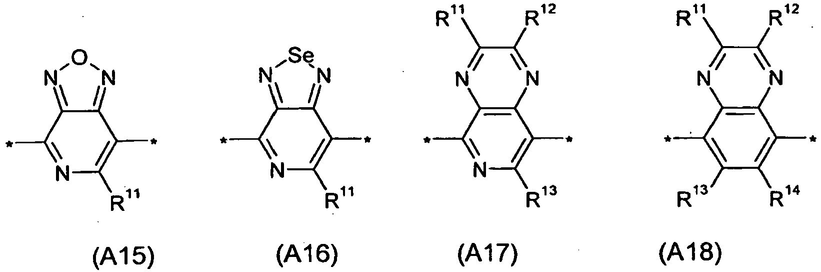 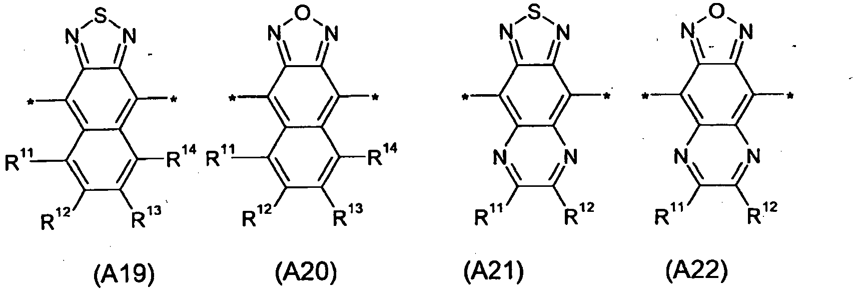 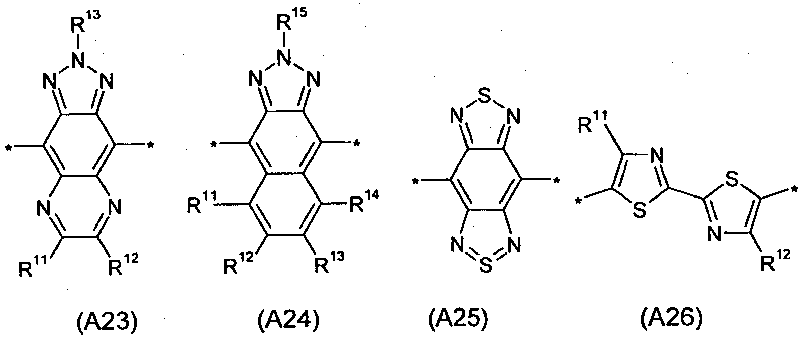 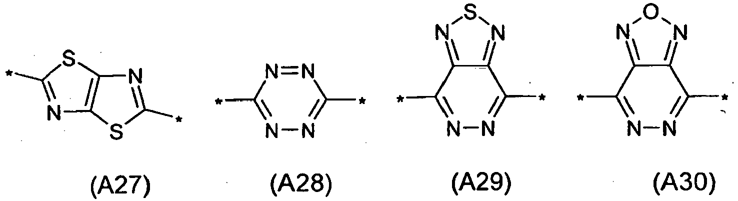 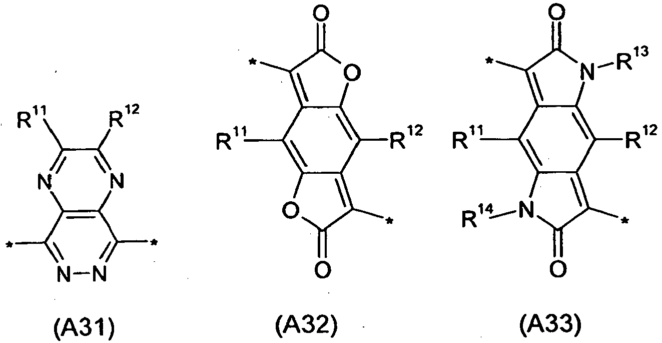 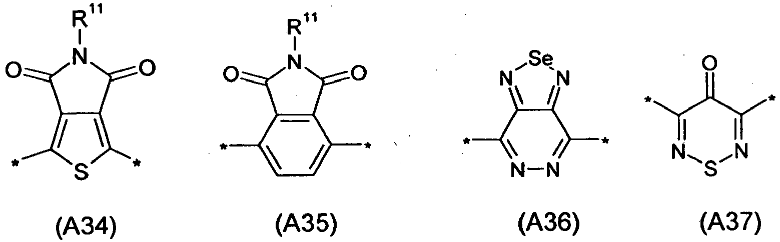 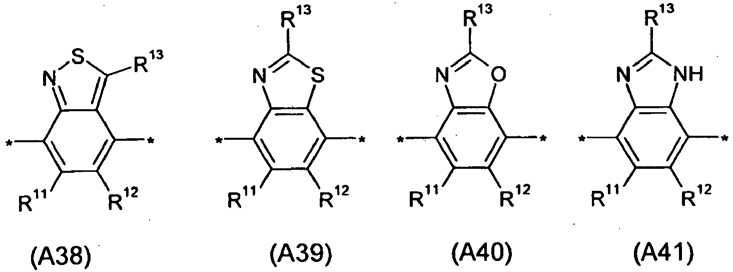 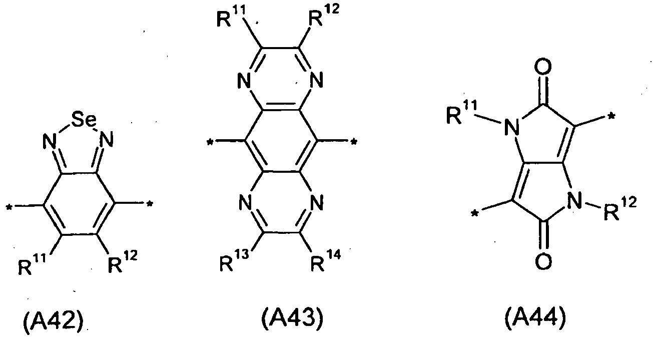 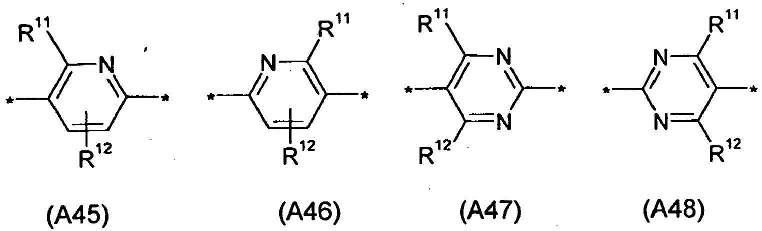 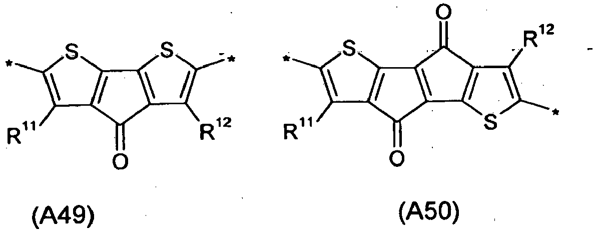 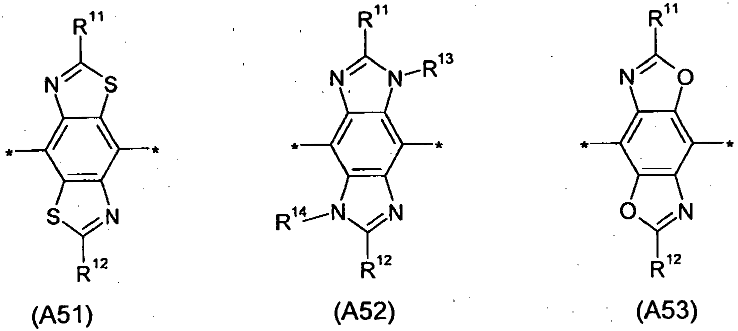 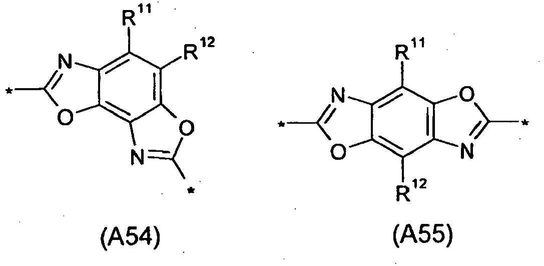 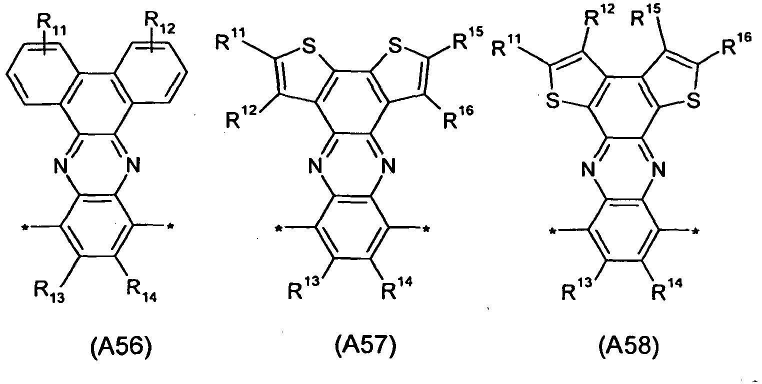 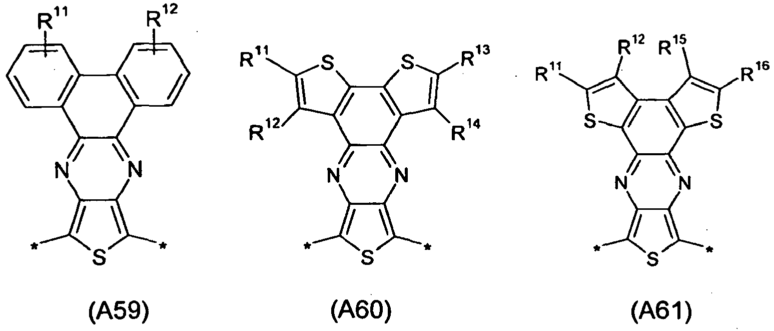 wherein one of X¹¹ and X¹² is S and the other is Se, and R¹¹, R¹², R¹³ , R¹⁴ and R¹⁵ independently of each other denote H or have one of the meanings of R³ as defined above and below.

Preferably A¹ and/or Ar³ is selected from the group consisting of formulae A1, A2, A3, A4, A5, A10, A34, A44, very preferably from formula A2 and A3.

Further preferred are repeating units, monomers and polymers of formulae I, II, III, IV, IVa to IVe, V, VI and their subformulae selected from the following list of preferred embodiments:
- the polymer does not contain a thiophene, selenophene, furan, dithiophene, thieno[2,3-b]thiophene or thieno[3,2-b]thiophene unit,
- if the polymer contains a thiophene group that is directly connected with the unit of formula I, the said thiophene group is unsubstituted,
- if the polymer contains a thiophene, selenophene, furan, dithiophene, thieno[2,3-b]thiophene or thieno[3,2-b]thiophene group that is directly connected with the unit of formula I, the said thiophene, selenophene, furan, dithiophene, thieno[2,3-b]thiophene or thieno[3,2-b]thiophene group is unsubstituted
- y is ≥ 0 and ≤ 1,
- b = d = 1 and a = c = 0, preferably in all repeating units,
- a = b = c = d = 1, preferably in all repeating units,
- a = b = d = 1 and c = 0, preferably in all repeating units,
- a = b = c = 1 and d = 0, preferably in all repeating units,
- a = c = 2, b = 1 and d = 0, preferably in all repeating units,
- a = c = 2 and b = d = 1, preferably in all repeating units,
- n is at least 5, preferably at least 10, very preferably at least 50, and up to 2,000, preferably up to 500.
- M_{w} is at least 5,000, preferably at least 8,000, very preferably at least 10,000, and preferably up to 300,000, very preferably up to 100,000,
- Y³ and Y⁴ are N,
- Y³ is CR³ and Y⁴ is CR⁴,
- R¹ and/or R² are independently of each other selected from the group consisting of primary alkyl with 1 to 30 C atoms, preferably 1 to 20 C atoms, secondary alkyl with 3 to 30 C atoms, and tertiary alkyl with 4 to 30 C atoms, wherein in all these groups one or more H atoms are optionally replaced by F,
- R³ and/or R⁴ denote H,
- R³ and/or R⁴ are independently of each other selected from the group consisting of primary alkyl or alkoxy with 1 to 30 C atoms, secondary alkyl or alkoxy with 3 to 30 C atoms, and tertiary alkyl or alkoxy with 4 to 30 C atoms, wherein in all these groups one or more H atoms are optionally replaced by F,
- R³ and/or R⁴ are independently of each other selected from the group consisting of aryl, heteroaryl, aryloxy, heteroaryloxy, each of which is optionally alkylated or alkoxylated and has 4 to 30 ring atoms,
- R³ and/or R⁴ are independently of each other selected from the group consisting of alkyl, alkoxy, alkylcarbonyl, alkoxycarbonyl and alkylcarbonyloxy, all of which are straight-chain or branched, are optionally fluorinated, and have from 1 to 30 C atoms, and aryl, aryloxy, heteroaryl and heteroaryloxy, all of which are optionally alkylated or alkoxylated and have 4 to 30 ring atoms,
- R³ and/or R⁴ denote independently of each other F, Cl, Br, I, CN, R⁹,-C(O)-R⁹, -C(O)-O-R⁹, or -O-C(O)-R⁹, wherein R⁹ is straight-chain, branched or cyclic alkyl with 1 to 30 C atoms, in which one or more non-adjacent C atoms are optionally replaced by -O-, -S-, -C(O)-, -C(O)-O-,-O-C(O)-, -O-C(O)-O-, -CR⁰=CR⁰⁰- or -C≡C- and in which one or more H atoms are optionally replaced by F, Cl, Br, I or CN, or R³ and/or R⁴ denote independently of each other aryl, aryloxy, heteroaryl or heteroaryloxy having 4 to 30 ring atoms which is unsubstituted or which is substituted by one or more halogen atoms or by one or more groups R⁹, -C(O)-R⁹, -C(O)-O-R⁹, or -O-C(O)-R⁹ as defined above,
- R⁹ is primary alkyl with 1 to 30 C atoms, very preferably with 1 to 15 C atoms, secondary alkyl with 3 to 30 C atoms, or tertiary alkyl with 4 to 30 C atoms, wherein in all these groups one or more H atoms are optionally replaced by F,
- R¹ and R⁰⁰ are selected from H or C₁-C₁₀-alkyl,
- R⁵ and R⁶ are selected from H, halogen, -CH₂Cl, -CHO, -CH=CH₂-SiR'R"R"', -SnR'R"R"', -BR'R", -B(OR')(OR"), -B(OH)₂, P-Sp, C₁-C₂₀-alkyl, C₁-C₂₀-alkoxy, C₂-C₂₀-alkenyl, C₁-C₂₀-fluoroalkyl and optionally substituted aryl or heteroaryl,
- R⁷ and R⁸ are, preferably independently of each other, selected from the group consisting of Cl, Br, I, O-tosylate, O-triflate, O-mesylate, O-nonaflate, -SiMe₂F, -SiMeF₂, -O-SO₂Z¹, -B(OZ²)₂, -CZ³=C(Z⁴)₂, -C≡CH and -Sn(Z⁴)₃, wherein Z¹⁻⁴ are selected from the group consisting of alkyl and aryl, each being optionally substituted, and two groups Z² may also form a cyclic group, very preferably from Br.

Further preferred are copolymers selected from the following subformulae 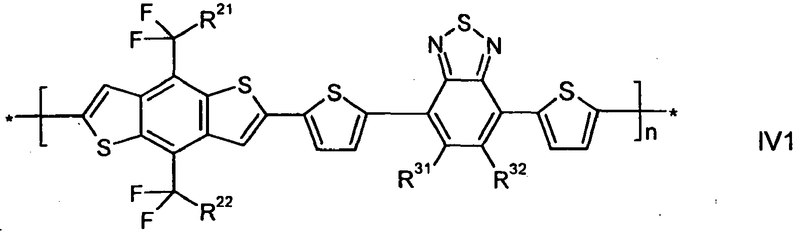 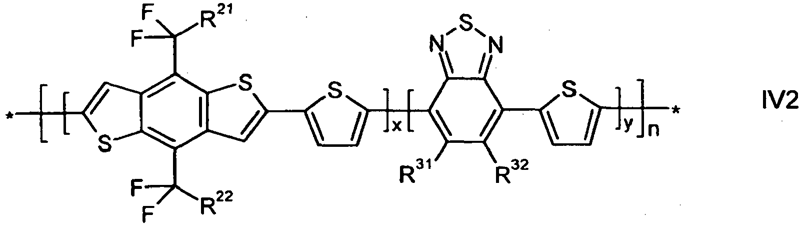 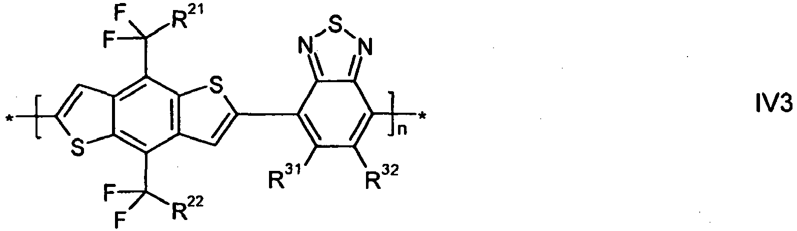 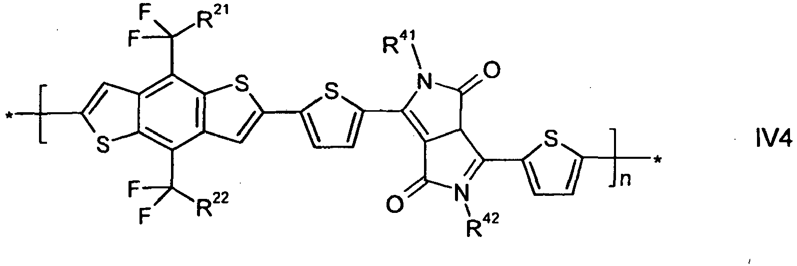 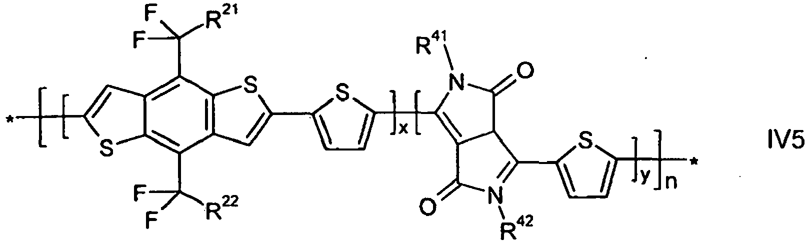 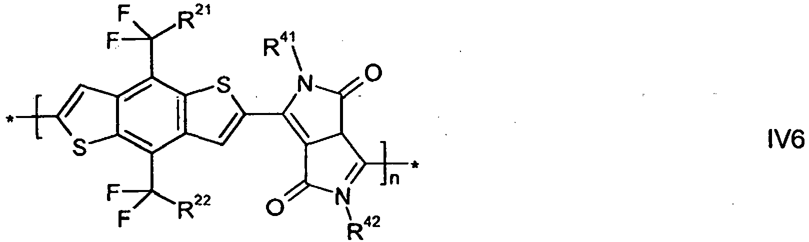 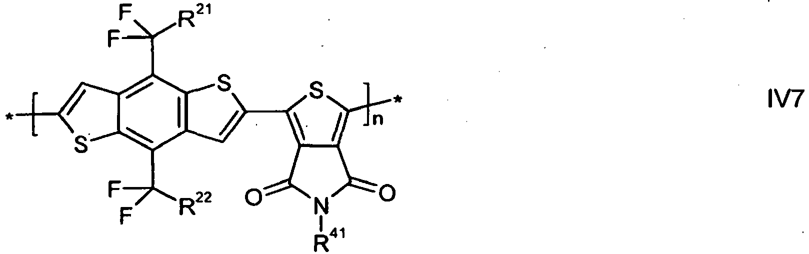 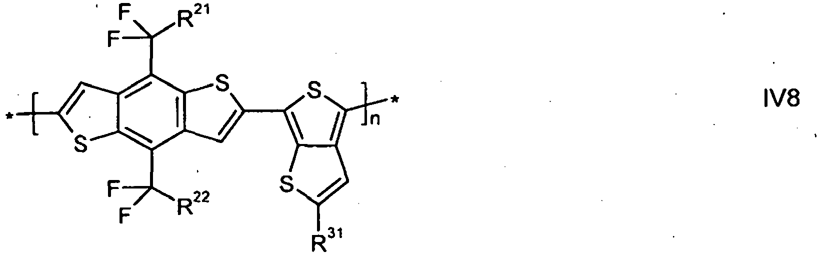 wherein n, x and y are as defined in formula IV, R²¹, and R²², have one of the meanings given for R¹ in formula I or its preferred meanings given above, R³¹, R³², R⁴¹ and R⁴² have one of the meanings of R³ in formula I or its preferred meanings given above, and the thiophene rings in formulae IV1, IV2, IV4, IV5 are optionally substituted by one or two groups R³¹.

The polymers of the present invention can be synthesized according to or in analogy to methods that are known to the skilled person and are described in the literature. Other methods of preparation can be taken from the examples. For example, they can be suitably prepared by aryl-aryl coupling reactions, such as Yamamoto coupling, Suzuki coupling, Stille coupling, Sonogashira coupling, Heck coupling or Buchwald coupling. Suzuki coupling and Yamamoto coupling are especially preferred.

The monomers which are polymerised to form the repeat units of the polymers can be prepared according to methods which are known to the person skilled in the art.

Preferably the polymers are prepared from monomers of formula la or its preferred embodiments as described above and below.

Another aspect of the invention is a process for preparing a polymer by coupling one or more identical or different monomeric units of formula I or monomers of formula la with each other and/or with one or more comonomers in a polymerisation reaction, preferably in an aryl-aryl coupling reaction.

Suitable and preferred comonomers are selected from the following formulae

R⁷-(Ar¹)ₐ-A¹-(Ar²)_{c}-R8 C

R⁷-Ar¹-R⁸ D

R⁷-Ar³-R⁸ E

wherein Ar¹, Ar², Ar³ a and c have one of the meanings of formula II or one of the preferred meanings given above and below, A¹ has one of the meanings of formula III or one of the preferred meanings given above and below, and R⁷ and R⁸ have the meanings of formula VI or one of the preferred meanings given above and below.

Preferred methods for polymerisation are those leading to C-C-coupling or C-N-coupling, like Suzuki polymerisation, as described for example in WO 00/53656, Yamamoto polymerisation, as described in for example in T. Yamamoto et al., Progress in Polymer Science 1993, 17, 1153-1205 or in WO 2004/022626 A1, and Stille coupling. For example, when synthesizing a linear polymer by Yamamoto polymerisation, monomers as described above having two reactive halide groups R⁷ and R⁸ is preferably used. When synthesizing a linear polymer by Suzuki polymerisation, preferably a monomer as described above is used wherein at least one reactive group R⁷ or R⁸ is a boronic acid or boronic acid derivative group.

Suzuki polymerisation may be used to prepare homopolymers as well as statistical, alternating and block random copolymers. Statistical or block copolymers can be prepared for example from the above monomers of formula V wherein one of the reactive groups R⁷ and R⁸ is halogen and the other reactive group is a boronic acid or boronic acid derivative group. The synthesis of statistical, alternating and block copolymers is described in detail for example in WO 03/048225 A2 or WO 2005/014688 A2.

Suzuki polymerisation employs a Pd(0) complex or a Pd(II) salt. Preferred Pd(0) complexes are those bearing at least one phosphine ligand such as Pd(Ph₃P)₄. Another preferred phosphine ligand is tris(*ortho-*tolyl)phosphine, i.e. Pd(o-Tol)₄. Preferred Pd(II) salts include palladium acetate, i.e. Pd(OAc)₂. Suzuki polymerisation is performed in the presence of a base, for example sodium carbonate, potassium phosphate or an organic base such as tetraethylammonium carbonate. Yamamoto polymerisation employs a Ni(0) complex, for example bis(1,5-cyclooctadienyl) nickel(0).

As alternatives to halogens as described above, leaving groups of formula -O-SO₃Z¹ can be used wherein Z¹ is as described above. Particular examples of such leaving groups are tosylate, mesylate and triflate.

Especially suitable and preferred synthesis methods of the repeating units, monomers, and polymers of formula I, II, III, IV, V and VI are illustrated in the synthesis schemes shown hereinafter, wherein R¹⁻⁴, Ar¹⁻³ are as defined in formula II, and R is an alkyl, aryl or heteroaryl group,.

The synthesis of the 4,8-bis(1,1-difluoralkyl)-benzo[1,2-b:4,5-b']dithiophene dibromide monomer is shown below in Scheme 1.

A fluorination agent such as diethylaminosulfur trifluoride (DAST), bis(2-methoxyethyl)amino]sulfur trifluoride (Deoxo-Fluor) or related amino-fluorosulfuranes can be use to convert the alkyl ketone to the 1,1-difluoralkyl.

The electrophilic bromation via a lithiated intermediate can be complete using, for example, tetrabromomethane, bromine, dibromoethane, dibromotetrachloroethane, N-bromosuccimide or brominil as Br⁺ source.

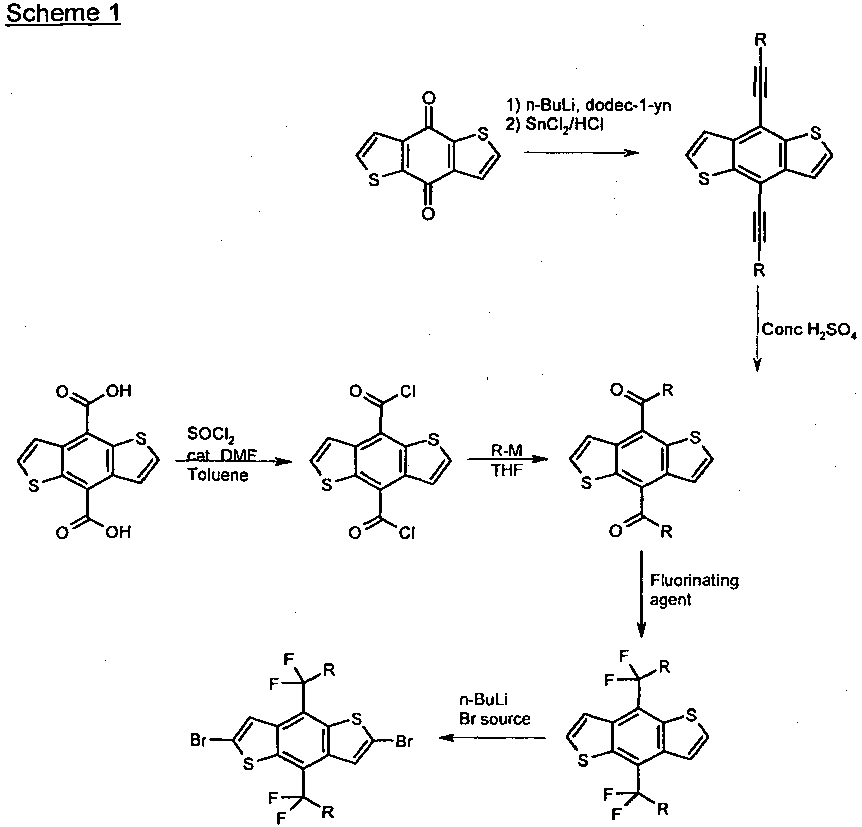

An alternative synthesis of the 4,8-bis(1,1-difluoralkyl)-benzo[1,2-b:4,5-b']dithiophene dibromide monomer is shown below in Scheme 2. The 2,6-bis(trimethylsilyl)-dibromobenzo[1,2-b:4,5-b']dithiophene synthesis has been described for example in Ralph Rieger et al., Chem. Mater. 2010, 22, 5314-5318.

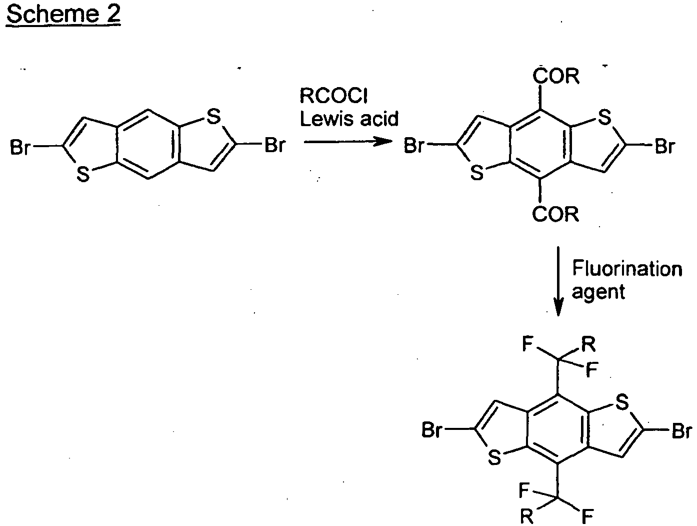

Another alternative synthesis of the 4,8-bis(1,1-difluoralkyl)-benzo[1,2-b:4,5-b']dithiophene dibromide monomer are shown below in Scheme 3. The LiCF₂CHCH₂ synthesis has been described, for example, in J. Org. Chem. 1980, 45, 2273-2274.

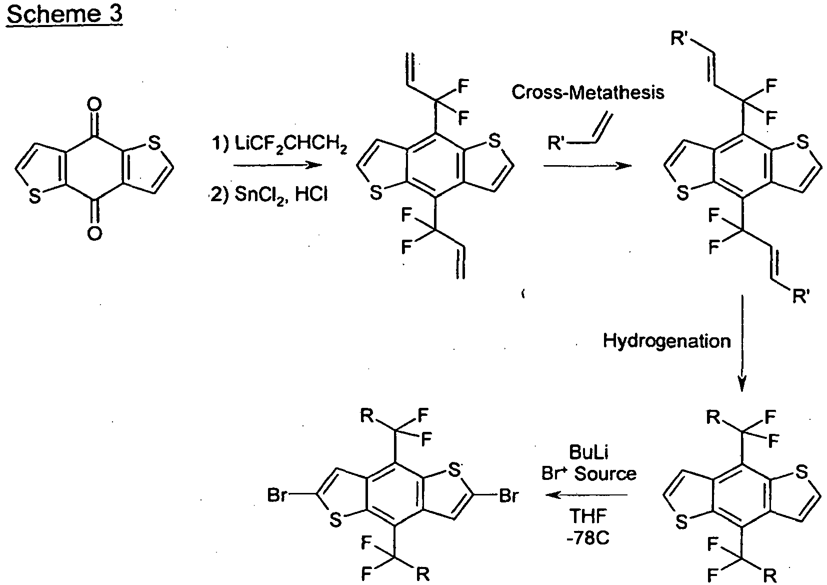

The synthesis for the alternating co-polymerisation of the 4,8-bis(1,1-difluoralkyl)-benzo[1,2-b:4,5-b']dithiophene is exemplarily shown in Scheme 4.

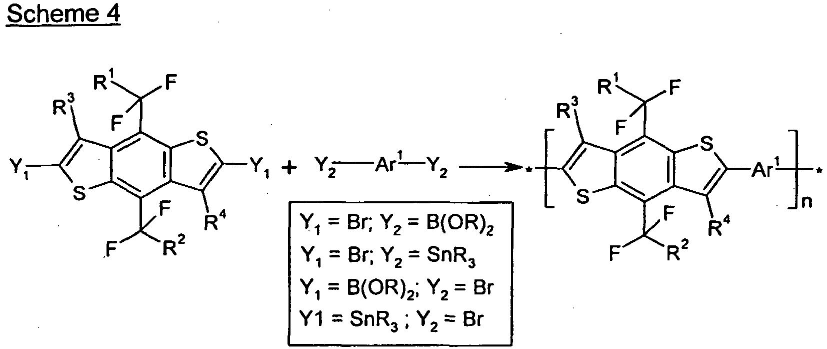

The synthesis for the random co-polymerisation of the 4,8-bis(1,1-difluoralkyl)-benzo[1,2-b:4,5-b']dithiophene is exemplarily shown in Scheme 5.

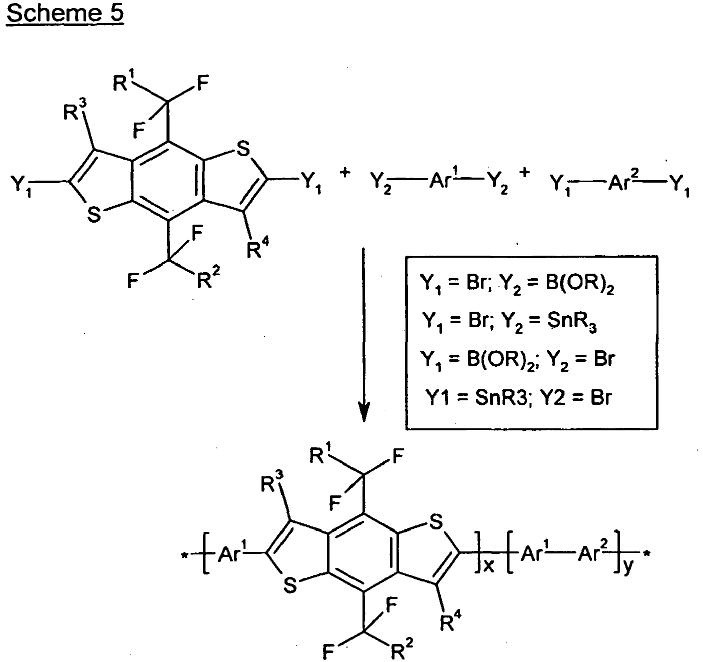

The novel methods of preparing monomers and polymers as described above and below are another aspect of the invention.

The polymers according to the present invention can also be used in mixtures or polymer blends, for example together with monomeric compounds or together with other polymers having charge-transport, semiconducting, electrically conducting, photoconducting and/or light emitting semiconducting properties, or for example with polymers having hole blocking or electron blocking properties for use as interlayers or charge blocking layers in OLED devices. Thus, another aspect of the invention relates to a polymer blend comprising one or more polymers according to the present invention and one or more further polymers having one or more of the above-mentioned properties. These blends can be prepared by conventional methods that are described in prior art and known to the skilled person. Typically the polymers are mixed with each other or dissolved in suitable solvents and the solutions combined. Another aspect of the invention relates to a formulation comprising one or more polymers, mixtures or polmyer blends as described above and below and one or more organic solvents.

Preferred solvents are aliphatic hydrocarbons, chlorinated hydrocarbons, aromatic hydrocarbons, ketones, ethers and mixtures thereof. Additional solvents which can be used include 1,2,4-trimethylbenzene, 1,2,3,4-tetramethyl benzene, pentylbenzene, mesitylene, cumene, cymene, cyclohexylbenzene, diethylbenzene, tetralin, decalin, 2,6-lutidine, 2-fluoro-m-xylene, 3-fluoro-o-xylene, 2-chlorobenzotrifluoride, dimethylformamide, 2-chloro-6fluorotoluene, 2-fluoroanisole, anisole, 2,3-dimethylpyrazine, 4-fluoroanisole, 3-fluoroanisole, 3-trifluoro-methylanisole, 2-methylanisole, phenetol, 4-methylanisole, 3-methylanisole, 4-fluoro-3-methylanisole, 2-fluorobenzonitrile, 4-fluoroveratrol, 2,6-dimethylanisole, 3-fluorobenzonitrile, 2,5-dimethylanisole, 2,4-dimethylanisole, benzonitrile, 3,5-dimethylanisole, N,N-dimethylaniline, ethyl benzoate, 1-fluoro-3,5-dimethoxybenzene, 1-methylnaphthalene, N-methylpyrrolidinone, 3-fluorobenzotrifluoride, benzotrifluoride, benzotrifluoride, diosane, trifluoromethoxybenzene, 4-fluorobenzotrifluoride, 3-fluoropyridine, toluene, 2-fluorotoluene, 2-fluorobenzotrifluoride, 3-fluorotoluene, 4-isopropylbiphenyl, phenyl ether, pyridine, 4-fluorotoluene, 2,5-difluorotoluene, 1-chloro-2,4-difluorobenzene, 2-fluoropyridine, 3-chlorofluorobenzene, 3-chlorofluorobenzene, 1-chloro-2,5-difluorobenzene, 4-chlorofluorobenzene, chlorobenzene, o-dichlorobenzene, 2-chlorofluorobenzene, p-xylene, m-xylene, o-xylene or mixture of o-, m-, and p-isomers. Solvents with relatively low polarity are generally preferred. For inkjet printing solvents with high boiling temperatures and solvent mixtures are preferred. For spin coating alkylated benzenes like xylene and toluene are preferred.

Examples of especially preferred solvents include, without limitation, dichloromethane, trichloromethane, monochlorobenzene, o-dichlorobenzene, tetrahydrofuran, anisole, morpholine, toluene, o-xylene, m-xylene, p-xylene, 1,4-dioxane, acetone, methylethylketone, 1,2-dichloroethane, 1,1,1-trichloroethane, 1,1,2,2-tetrachloroethane, ethyl acetate, n-butyl acetate, dimethylformamide, dimethylacetamide, dimethylsulfoxide, tetraline, decaline, indane, methyl benzoate, ethyl benzoate, mesitylene and/or mixtures thereof.

The concentration of the polymers in the solution is preferably 0.1 to 10% by weight, more preferably 0.5 to 5% by weight. Optionally, the solution also comprises one or more binders to adjust the rheological properties, as described for example in WO 2005/055248 A1.

After the appropriate mixing and ageing, solutions are evaluated as one of the following categories: complete solution, borderline solution or insoluble. The contour line is drawn to outline the solubility parameter-hydrogen bonding limits dividing solubility and insolubility. 'Complete' solvents falling within the solubility area can be chosen from literature values such as published in "Crowley, J.D., Teague, G.S. Jr and Lowe, J.W. Jr., Journal of Paint Technology, 38, No 496, 296 (1966)". Solvent blends may also be used and can be identified as described in "Solvents, W.H.Ellis, Federation of Societies for Coatings Technology, p9-10, 1986". Such a procedure may lead to a blend of 'non' solvents that will dissolve both the polymers of the present invention, although it is desirable to have at least one true solvent in a blend.

The polymers according to the present invention can also be used in patterned OSC layers in the devices as described above and below. For applications in modern microelectronics it is generally desirable to generate small structures or patterns to reduce cost (more devices/unit area), and power consumption. Patterning of thin layers comprising a polymer according to the present invention can be carried out for example by photolithography, electron beam lithography or laser patterning.

For use as thin layers in electronic or electrooptical devices the polymers, polymer blends or formulations of the present invention may be deposited by any suitable method. Liquid coating of devices is more desirable than vacuum deposition techniques. Solution deposition methods are especially preferred. The formulations of the present invention enable the use of a number of liquid coating techniques. Preferred deposition techniques include, without limitation, dip coating, spin coating, ink jet printing, letter-press printing, screen printing, doctor blade coating, roller printing, reverse-roller printing, offset lithography printing, flexographic printing, web printing, spray coating, brush coating or pad printing. Ink-jet printing is particularly preferred as it allows high resolution layers and devices to be prepared.

Selected formulations of the present invention may be applied to prefabricated device substrates by ink jet printing or microdispensing. Preferably industrial piezoelectric print heads such as but not limited to those supplied by Aprion, Hitachi-Koki, InkJet Technology, On Target Technology, Picojet, Spectra, Trident, Xaar may be used to apply the organic semiconductor layer to a substrate. Additionally semi-industrial heads such as those manufactured by Brother, Epson, Konica, Seiko Instruments Toshiba TEC or single nozzle microdispensers such as those produced by Microdrop and Microfab may be used.

In order to be applied by ink jet printing or microdispensing, the polymers should be first dissolved in a suitable solvent. Solvents must fulfil the requirements stated above and must not have any detrimental effect on the chosen print head. Additionally, solvents should have boiling points >100°C, preferably >140°C and more preferably >150°C in order to prevent operability problems caused by the solution drying out inside the print head. Apart from the solvents methoned above, suitable solvents include substituted and non-substituted xylene derivatives, di-C₁₋₂-alkyl formamide, substituted and non-substituted anisoles and other phenol-ether derivatives, substituted heterocycles such as substituted pyridines, pyrazines, pyrimidines, pyrrolidinones, substituted and non-substituted *N,N*-di-C₁₋₂-alkylanilines and other fluorinated or chlorinated aromatics.

A preferred solvent for depositing a polymer according to the present invention by ink jet printing comprises a benzene derivative which has a benzene ring substituted by one or more substituents wherein the total number of carbon atoms among the one or more substituents is at least three. For example, the benzene derivative may be substituted with a propyl group or three methyl groups, in either case there being at least three carbon atoms in total. Such a solvent enables an ink jet fluid to be formed comprising the solvent with the polymer, which reduces or prevents clogging of the jets and separation of the components during spraying. The solvent(s) may include those selected from the following list of examples: dodecylbenzene, 1-methyl-4-tert-butylbenzene, terpineol limonene, isodurene, terpinolene, cymene, diethylbenzene. The solvent may be a solvent mixture, that is a combination of two or more solvents, each solvent preferably having a boiling point >100°C, more preferably >140°C. Such solvent(s) also enhance film formation in the layer deposited and reduce defects in the layer.

The ink jet fluid (that is mixture of solvent, binder and semiconducting compound) preferably has a viscosity at 20°C of 1-100 mPa·s, more preferably 1-50 mPa·s and most preferably 1-30 mPa·s.

The polymers or formulations according to the present invention can additionally comprise one or more further components or additives selected for for example from surface-active compounds, lubricating agents, wetting agents, dispersing agents, hydrophobing agents, adhesive agents, flow improvers, defoaming agents, deaerators, diluents which may be reactive or non-reactive, auxiliaries, colourants, dyes or pigments, sensitizers, stabilizers, nanoparticles or inhibitors.

The polymers according to the present invention are useful as charge transport, semiconducting, electrically conducting, photoconducting or light mitting materials in optical, electrooptical, electronic, electroluminescent or photoluminescent components or devices. In these devices, the polymers of the present invention are typically applied as thin layers or films.

Thus, the present invention also provides the use of the semiconducting polymer, polymer blend, formulation or layer in an electronic device. The formulation may be used as a high mobility semiconducting material in various devices and apparatus. The formulation may be used, for example, in the form of a semiconducting layer or film. Accordingly, in another aspect, the present invention provides a semiconducting layer for use in an electronic device, the layer comprising a polymer, polymer blend or formulation according to the invention. The layer or film may be less than about 30 microns. For various electronic device applications, the thickness may be less than about 1 micron thick. The layer may be deposited, for example on a part of an electronic device, by any of the aforementioned solution coating or printing techniques.

The invention additionally provides an electronic device comprising a polymer, polymer blend, formulation or organic semiconducting layer according to the present invention. Especially preferred devices are OFETs, TFTs, ICs, logic circuits, capacitors, RFID tags, OLEDs, OLETs, OPEDs, OPVs, solar cells, laser diodes, photoconductors, photodetectors, electrophotographic devices, electrophotographic recording devices, organic memory devices, sensor devices, charge injection layers, Schottky diodes, planarising layers, antistatic films, conducting substrates and conducting patterns.

Especially preferred electronic device are OFETs, OLEDs and OPV devices, in particular bulk heterojunction (BHJ) OPV devices. In an OFET, for example, the active semiconductor channel between the drain and source may comprise the layer of the invention. As another example, in an OLED device, the charge (hole or electron) injection or transport layer may comprise the layer of the invention.

For use in OPV devices the compound or polymer according to the present invention is preferably used as photo-active layer. This implies the use in a formulation that comprises or contains, more preferably consists essentially of, very preferably exclusively of, a p-type (electron donor) semiconductor and an n-type (electron acceptor) semiconductor. The p-type semiconductor is constituted by a compound, preferably a polymer according to the present invention. The n-type semiconductor can be an inorganic material such as zinc oxide or cadmium selenide, or an organic material such as graphene or a fullerene or substituted fullerene, for example an indene-C₆₀-fullerene bisaduct like ICBA, or a (6,6)-phenyl-butyric acid methyl ester derivatized methano C₆₀ fullerene, also known as "PCBM" or "C₆₀PCBM", as disclosed for example in G. Yu, J. Gao, J.C. Hummelen, F. Wudl, A.J. Heeger, Science, 1995, 270, 1789 and having the structure shown below, or structural analogous compounds with e.g. a C₆₁ fullerene group, a C₇₀ fullerene group, or a C₇₁ fullerene group, or an organic polymer (see for example Coakley, K. M. and McGehee, M. D. Chem. Mater., 2004, 16, 4533).

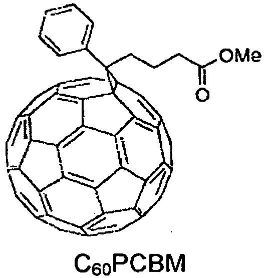

Very preferred is a blend or mixture of a polymer according to the present invention with a C₆₀, C₆₁, C₇₀ or C₇₁ fullerene or substituted fullerene like C₆₀PCBM, C₆₁PCBM, C₇₀PCBM, C₇₁PCBM, bis-PCBM-C₆₁, bis-PCBM-C₇₁, graphene or ICBA. Preferably the ratio polymer:fullerene is from 2:1 to 1:2 by weight, more preferably from 1.2:1 to 1:1.2 by weight, most preferably 1:1 by weight. For the blended mixture, an optional annealing step may be necessary to optimize blend morpohology and consequently OPV device performance.

The OPV device can for example be of any type known from the literature (see for example Waldauf et al., Appl. Phys. Lett. 89, 233517 (2006), or Coakley, K. M. and McGehee, M. D. Chem. Mater. 2004, 16, 4533).

A first preferred OPV device according to the invention comprises the following layers (in the sequence from bottom to top):
- a high work function electrode preferably comprising a metal oxide like for example ITO, serving as anode,
- an optional conducting polymer layer or hole transport layer, preferably comprising an organic poymer or polymer blend, for example of PEDOT:PSS (poly(3,4-ethylenedioxythiophene): poly(styrene-sulfonate),
- a layer, also referred to as "active layer", comprising a p-type and an n-type organic semiconductor, which can exist for example as a p-type/n-type bilayer or as distinct p-type and n-type layers, or as blend or p-type and n-type semiconductor, forming a BHJ,
- optionally a layer having electron transport properties, for example comprising LiF or NaF,
- a low work function electrode, preferably comprising a metal like for example aluminum, serving as cathode,
wherein at least one of the electrodes, preferably the anode, is transparent to visible light, and
wherein the p-type semiconductor is a polymer according to the present invention.

A second preferred OPV device according to the invention is an inverted OPV device and comprises the following layers (in the sequence from bottom to top):
- an electrode comprising for example ITO serving as cathode,
- optionally a layer having hole blocking properties, preferably comprising a metal oxide like ZnOₓ, ZTO, TiOₓ, MoOₓ, NiOₓ,
- an active layer comprising a p-type and an n-type organic semiconductor, situated between the electrodes, which can exist for example as a p-type/n-type bilayer or as distinct p-type and n-type layers, or as blend or p-type and n-type semiconductor, forming a BHJ,
- an optional conducting polymer layer or hole transport layer, preferably comprising an organic poymer or polymer blend, for example a conjugated polymer electerolyte like PEDOT:PSS,
- a high work function electrode, preferably comprising a metal like for example gold, serving as anode,
wherein at least one of the electrodes, preferably the cathode, is transparent or semitransparent to visible light, and wherein the p-type semiconductor is a polymer according to the present invention.

In the OPV devices of the present invent invention the p-type and n-type semiconductor materials are preferably selected from materials like the polymer/fullerene systems as described above. If the bilayer is a blend an optional annealing step may be necessary to optimize device performance. The compound, formulation and layer of the present invention are also suitable for use in an OFET as the semiconducting channel. Accordingly, the invention also provides an OFET comprising a gate electrode, an insulating (or gate insulator) layer, a source electrode, a drain electrode and an organic semiconducting channel connecting the source and drain electrodes, wherein the organic semiconducting channel comprises a polymer, polymer blend, formulation or organic semiconducting layer according to the present invention. Other features of the OFET are well known to those skilled in the art.

OFETs where an OSC material is arranged as a thin film between a gate dielectric and a drain and a source electrode, are generally known, and are described for example in US 5,892,244, US 5,998,804, US 6,723,394 and in the references cited in the background section. Due to the advantages, like low cost production using the solubility properties of the compounds according to the invention and thus the processibility of large surfaces, preferred applications of these FETs are such as integrated circuitry, TFT displays and security applications.

The gate, source and drain electrodes and the insulating and semiconducting layer in the OFET device may be arranged in any sequence, provided that the source and drain electrode are separated from the gate electrode by the insulating layer, the gate electrode and the semiconductor layer both contact the insulating layer, and the source electrode and the drain electrode both contact the semiconducting layer.

An OFET device according to the present invention preferably comprises:
- a source electrode,
- a drain electrode,
- a gate electrode,
- a semiconducting layer,
- one or more gate insulator layers,
- optionally a substrate.
wherein the semiconductor layer preferably comprises a polymer, polymer blend or formulation as described above and below.

The OFET device can be a top gate device or a bottom gate device. Suitable structures and manufacturing methods of an OFET device are known to the skilled in the art and are described in the literature, for example in US 2007/0102696 A1.

The gate insulator layer preferably comprises a fluoropolymer, like e.g. the commercially available Cytop 809M® or Cytop 107M® (from Asahi Glass). Preferably the gate insulator layer is deposited, e.g. by spin-coating, doctor blading, wire bar coating, spray or dip coating or other known methods, from a formulation comprising an insulator material and one or more solvents with one or more fluoro atoms (fluorosolvents), preferably a perfluorosolvent. A suitable perfluorosolvent is e.g. FC75® (available from Acros, catalogue number 12380). Other suitable fluoropolymers and fluorosolvents are known in prior art, like for example the perfluoropolymers Teflon AF® 1600 or 2400 (from DuPont) or Fluoropel® (from Cytonix) or the perfluorosolvent FC 43® (Acros, No. 12377). Especially preferred are organic dielectric materials having a low permittivity (or dielectric constant) from 1.0 to 5.0, very preferably from 1.8 to 4.0 ("low k materials"), as disclosed for example in US 2007/0102696 A1 or US 7,095,044.

In security applications, OFETs and other devices with semiconducting materials according to the present invention, like transistors or diodes, can be used for RFID tags or security markings to authenticate and prevent counterfeiting of documents of value like banknotes, credit cards or ID cards, national ID documents, licenses or any product with monetry value, like stamps, tickets, shares, cheques etc..

Alternatively, the materials according to the invention can be used in OLEDs, e.g. as the active display material in a flat panel display applications, or as backlight of a flat panel display like e.g. a liquid crystal display. Common OLEDs are realized using multilayer structures. An emission layer is generally sandwiched between one or more electron-transport and/ or hole-transport layers. By applying an electric voltage electrons and holes as charge carriers move towards the emission layer where their recombination leads to the excitation and hence luminescence of the lumophor units contained in the emission layer. The inventive compounds, materials and films may be employed in one or more of the charge transport layers and/ or in the emission layer, corresponding to their electrical and/ or optical properties. Furthermore their use within the emission layer is especially advantageous, if the compounds, materials and films according to the invention show electroluminescent properties themselves or comprise electroluminescent groups or compounds. The selection, characterization as well as the processing of suitable monomeric, oligomeric and polymeric compounds or materials for the use in OLEDs is generally known by a person skilled in the art, see, e.g., Meerholz, Synthetic Materials, 111-112, 2000, 31-34, Alcala, J. Appl. Phys., 88, 2000, 7124-7128 and the literature cited therein.

According to another use, the materials according to this invention, especially those showing photoluminescent properties, may be employed as materials of light sources, e.g. in display devices, as described in EP 0 889 350 A1 or by C. Weder et al., Science, 279, 1998, 835-837.

A further aspect of the invention relates to both the oxidised and reduced form of the compounds according to this invention. Either loss or gain of electrons results in formation of a highly delocalised ionic form, which is of high conductivity. This can occur on exposure to common dopants. Suitable dopants and methods of doping are known to those skilled in the art, e.g. from EP 0 528 662, US 5,198,153 or WO 96/21659.

The doping process typically implies treatment of the semiconductor material with an oxidating or reducing agent in a redox reaction to form delocalised ionic centres in the material, with the corresponding counterions derived from the applied dopants. Suitable doping methods comprise for example exposure to a doping vapor in the atmospheric pressure or at a reduced pressure, electrochemical doping in a solution containing a dopant, bringing a dopant into contact with the semiconductor material to be thermally diffused, and ion-implantantion of the dopant into the semiconductor material.

When electrons are used as carriers, suitable dopants are for example halogens (e.g., I₂, Cl₂, Br₂, ICl, ICl₃, IBr and IF), Lewis acids (e.g., PF₅, AsF₅, SbF₅, BF₃, BCl₃, SbCl₅, BBr₃ and SO₃), protonic acids, organic acids, or amino acids (e.g., HF, HCl, HNO₃, H₂SO₄, HClO₄, FSO₃H and ClSO₃H), transition metal compounds (e.g., FeCl₃, FeOCl, Fe(ClO₄)₃, Fe(4-CH₃C₆H₄SO₃)₃, TiCl₄, ZrCl₄, HfCl₄, NbF₅, NbCl₅, TaCl₅, MoF₅, MoCl₅, WF₅, WCl₆, UF₆ and LnCl₃ (wherein Ln is a lanthanoid), anions (e.g., Cl⁻, Br⁻, I⁻, I₃⁻, HSO₄⁻, SO₄²⁻, NO₃⁻, ClO₄⁻, BF₄⁻, PF₆⁻, AsF₆⁻, SbF₆⁻, FeCl₄⁻, Fe(CN)₆³⁻, and anions of various sulfonic acids, such as aryl-SO₃⁻). When holes are used as carriers, examples of dopants are cations (e.g., H⁺, Li⁺, Na⁺, K⁺, Rb⁺ and Cs⁺), alkali metals (e.g., Li, Na, K, Rb, and Cs), alkaline-earth metals (e.g., Ca, Sr, and Ba), O₂, XeOF₄, (NO₂⁺) (SbF₆⁻), (NO₂⁺) (SbCl₆⁻), (NO₂⁺) (BF₄⁻), AgClO₄, H₂IrCl₆. La(NO₃)₃ 6H₂O, FSO₂OOSO₂F, Eu, acetylcholine, R₄N⁺, (R is an alkyl group), R₄P⁺ (R is an alkyl group), R₆As⁺ (R is an alkyl group), and R₃S⁺ (R is an alkyl group).

The conducting form of the compounds of the present invention can be used as an organic "metal" in applications including, but not limited to, charge injection layers and ITO planarising layers in OLED applications, films for flat panel displays and touch screens, antistatic films, printed conductive substrates, patterns or tracts in electronic applications such as printed circuit boards and condensers.

The compounds and formulations according to the present invention amy also be suitable for use in organic plasmon-emitting diodes (OPEDs), as described for example in Koller et al., Nature Photonics 2008 (published online September 28, 2008).

According to another use, the materials according to the present invention can be used alone or together with other materials in or as alignment layers in LCD or OLED devices, as described for example in US 2003/0021913. The use of charge transport compounds according to the present invention can increase the electrical conductivity of the alignment layer. When used in an LCD, this increased electrical conductivity can reduce adverse residual dc effects in the switchable LCD cell and suppress image sticking or, for example in ferroelectric LCDs, reduce the residual charge produced by the switching of the spontaneous polarisation charge of the ferroelectric LCs. When used in an OLED device comprising a light emitting material provided onto the alignment layer, this increased electrical conductivity can enhance the electroluminescence of the light emitting material. The compounds or materials according to the present invention having mesogenic or liquid crystalline properties can form oriented anisotropic films as described above, which are especially useful as alignment layers to induce or enhance alignment in a liquid crystal medium provided onto said anisotropic film. The materials according to the present invention may also be combined with photoisomerisable compounds and/or chromophores for use in or as photoalignment layers, as described in US 2003/0021913.

According to another use the materials according to the present invention, especially their water-soluble derivatives (for example with polar or ionic side groups) or ionically doped forms, can be employed as chemical sensors or materials for detecting and discriminating DNA sequences. Such uses are described for example in L. Chen, D. W. McBranch, H. Wang, R. Helgeson, F. Wudl and D. G. Whitten, Proc. Natl. Acad. Sci. U.S.A. 1999, 96, 12287; D. Wang, X. Gong, P. S. Heeger, F. Rininsland, G. C. Bazan and A. J. Heeger, Proc. Natl. Acad. Sci. U.S.A. 2002, 99, 49; N. DiCesare, M. R. Pinot, K. S. Schanze and J. R. Lakowicz, Langmuir 2002, 18, 7785; D. T. McQuade, A. E. Pullen, T. M. Swager, Chem. Rev. 2000, 100, 2537.

Unless the context clearly indicates otherwise, as used herein plural forms of the terms herein are to be construed as including the singular form and vice versa.

Throughout the description and claims of this specification, the words "comprise" and "contain" and variations of the words, for example "comprising" and "comprises", mean "including but not limited to", and are not intended to (and do not) exclude other components.

It will be appreciated that variations to the foregoing embodiments of the invention can be made while still falling within the scope of the invention. Each feature disclosed in this specification, unless stated otherwise, may be replaced by alternative features serving the same, equivalent or similar purpose. Thus, unless stated otherwise, each feature disclosed is one example only of a generic series of equivalent or similar features.

All of the features disclosed in this specification may be combined in any combination, except combinations where at least some of such features and/or steps are mutually exclusive. In particular, the preferred features of the invention are applicable to all aspects of the invention and may be used in any combination. Likewise, features described in non-essential combinations may be used separately (not in combination).

It will be appreciated that many of the features described above, particularly of the preferred embodiments, are inventive in their own right and not just as part of an embodiment of the present invention. Independent protection may be sought for these features in addition to or alternative to any invention presently claimed.

Above and below, unless stated otherwise percentages are per cent by weight and temperatures are given in degrees Celsius. The values of the dielectric constant ε ("permittivity") refer to values taken at 20°C and 1,000 Hz.

The invention will now be described in more detail by reference to the following examples, which are illustrative only and do not limit the scope of the invention.

### Example 1

### 4,8-Di-dodec-1-ynyl-benzo[1,2-b:4,5-b']dithiophene (1.1)

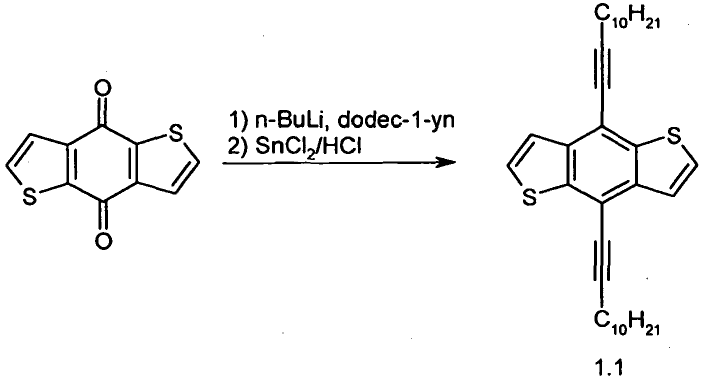

To a solution of dodec-1-yn (38.7 mL, 182 mmol) in tetrahydrofuran (160 cm³) is added dropwise n-butyllithium (68 cm³, 2.5 M in hexanes, 170 mmol) at 23 °C and the mixture is stirred for 30 minutes. Benzo[1,2-b;4,5-b']dithiophene-4,8-dione (10.0 g, 45.4 mmol) is added and the resulting mixture is stirred at 60 °C for 1 hour and then cooled to room temperature. A solution of tin chloride (II) (66.7 g, 351.8 mmol) in 10% aqueous hydrochloridic acid (170 cm³) is added dropwise and the reaction mixture is heated to 60 °C for 1 hour. The cooled reaction mixture is poured into water (200 cm³) and extracted with diethyl ether (3 x 100 cm³), the combined organic phases are dried over magnesium sulfate and concentrated *in vacuo.* The residue is triturated in isopropyl alcohol, collected by filtration and washed with isopropyl alcohol and acetonitrile to give a yellow solid (18.1 g, 34.9 mmol, 77%). ¹H NMR (300 MHz, CDCl₃): 0.89 (3H, t, *J* = 6.9 Hz), 1.24-1.45 (12H, m), 1.58 (2H, quin, *J* = 6.8 Hz), 1.74 (2H, quin, *J* = 7.0 Hz), 2.64 (2H, t, *J* = 6.9 Hz), 7.50 (1 H, d, *J* = 5.5 Hz), 7.58 (1 H, d, *J* = 5.6 Hz).

### 1-(8-Dodecanoyl-benzo[1,2-b;4,5-b']dithiophen-4-yl)-dodecan-1-one (1.2)

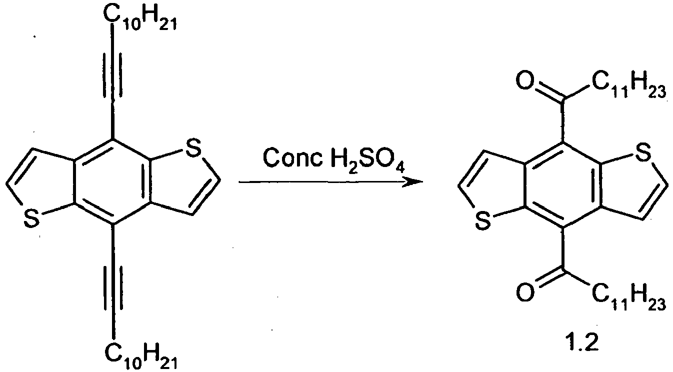

Concentrated sulfuric acid (76 cm³) is added dropwise to a stirred solution of 4,8-di-dodec-1-ynyl-benzo[1,2-b;4,5-b']dithiophene (18.0 g, 34.7 mmol) in 1,4-dioxane (760 cm³) at room temperature. After 30 minutes the reaction mixture is heated to 70 °C for 24 hours followed by 90 °C for a further 24 hours. The cooled reaction mixture is poured into ice and the resultant oil is extracted with dichloromethane (3 x 50 cm³). The combined organic phases are dried over magnesium sulfate and concentrated *in vacuo.* The residue is triturated in acetone and solid collected by filtration to give a yellow solid (11.0 g, 19.9 mmol, 57%). ¹H NMR (300 MHz, CDCl₃): 0.89 (6H, t, *J* = 7.0 Hz), 1.20-1.46 (32H, m), 1.88 (4H, quin, *J* = 7.4 Hz), 3.26 (4H, t, *J* = 7.4 Hz), 7.78 (4H, s).

### 4.8-Bis-(1,1-difluoro-tridecyl)-benzo[1,2-b;4,5-b']dithiophene (1.3)

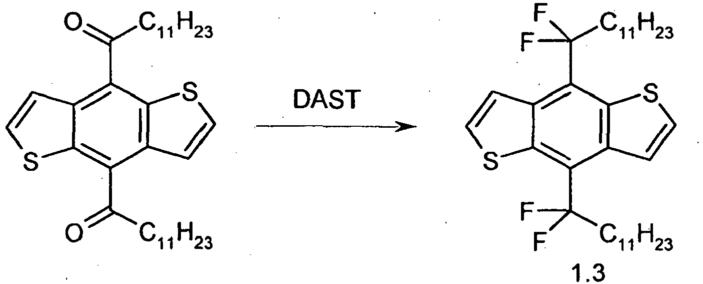

To a stirred suspension of 1-(8-Dodecanoyl-benzo[1,2-b;4,5-b']dithiophen-4-yl)-dodecan-1-one (8.89 g, 16.00 mmol) in anhydrous THF (180 mL) is added DAST (4.24 cm³ , 32.00 mmol) at room temperature and the resulting mixture is stirred at 80°C for 90 minutes. The mixture is cooled for 5 minutes and then more diethylaminosulfur trifluoride (DAST) (4.2 cm³, 32.00 mmol) is added and the mixture is heated at 80°C for a further 90 minutes. This process is repeated a further four times on day 1 and the mixture stirred overnight at 80°C. The procedure is repeated on day 2 a further six times until the total volume of diethylaminosulfur trifluoride used is (51 cm³, 24 equivalents). The reaction mixture is cooled to room temperature and poured carefully into saturated sodium bicarbonate solution (1000 cm³). The mixture is then extracted with dichloromethane (3 x 300 cm³) and the combined organic layers are dried over sodium sulfate, filtered and the volatile is evaporated under *vacuo* to give a black solid. This solid is dry loaded onto silica and purified by flash column chromatography on silica using light petroleum as eluent to give a pale yellow solid (2.71g, 8.51 mmol, 28%). ¹H NMR (400MHz, CDCl₃): δ 0.80 (m, 6H), 1.14-1.22 (m, 32H), 1.45 (m, 4H), 2.29 (m, 4H), 7.53 (d, 2H), 7.59 (d, 2H).

### 2,6-Dibromo-4,8-bis-(1,1-difluoro-dodecyl)-benzo[1,2-b;4,5-b']dithiophene (1.4)

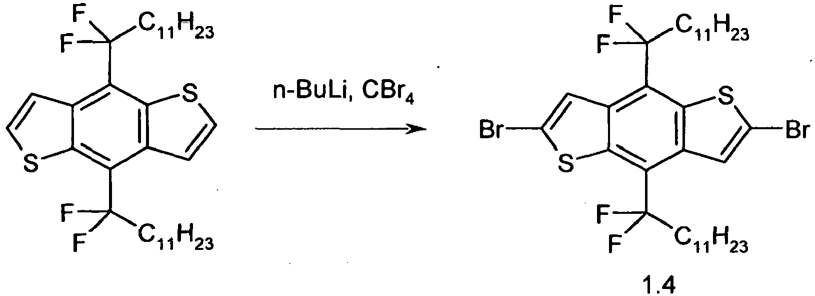

4,8-Bis-(1,1-difluoro-tridecyl)-benzo[1,2-b;4,5-b']dithiophene (0.780 g, 1.30 mmol) is dissolved in THF (33 cm³) and the solution is cooled to -78 °C. N-Butyl lithium (1.8 cm³, 2.5 M in hexanes, 4.6 mmol) is added dropwise over 5-10 minutes and the resulting mixture is stirred at -78 °C for 5 minutes and at 23 °C for 35 minutes. The mixture is cooled back to -78 °C and a solution of carbon tetracarbon (1.73 g, 5.21 mmol) in THF (4.0 cm³) is added in one portion. After 30 minutes the cooling bath is removed and the resulting solution is stirred at room temperature for 45 minutes. The reaction mixture is quenched with water (50 cm³) and extracted into dichloromethane (3 x 30 cm³). The combined organic phases are dried over magnesium sulfate and concentrated *in vacuo.* The residue is triturated in methanol, filtered and the resulting solid is further purified by recrystallistion from tetrahydrofuran / acetronitrile to give a yellow solid (612 mg, 0.809 mmol, 62 %). ¹H NMR (300 MHz, CDCl₃): 0.88 (6H, t, 7.0 Hz), 1.20-1.33 (32H, m), 1.43-1.55 (4H, m), 2.20-2.40 (4H, m), 7.61 (2H, broad s).

### Poly{[2-(2-thien-5-yl)-4,8-di(1,1-difluoro-dodecyl)benzo[1,2-b:4,5-b']dithiophen-6-yl]-co-[4-(2-thien-5-yl)-5,6-dioctyloxy-2,1,3-benzothiadiazol-7-yl]}(1.5)

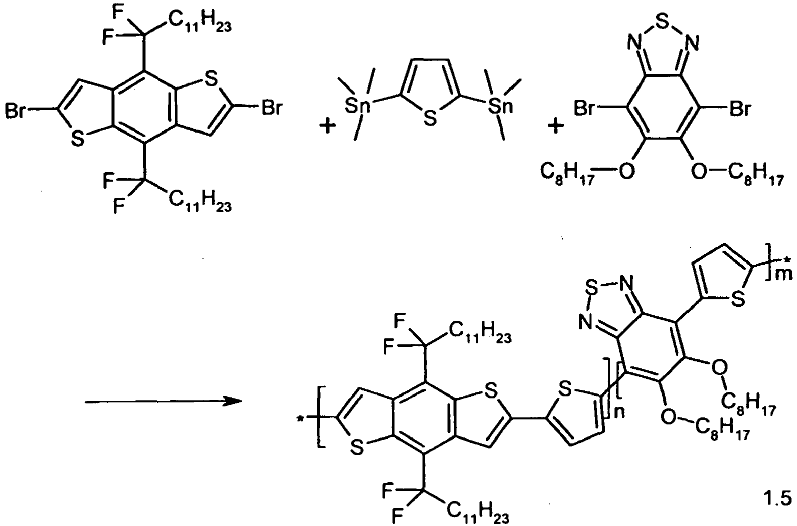

2,6-Dibromo-4,8-bis-(1,1-difluoro-dodecyl)-benzo[1,2-b;4,5-b']dithiophene (305.0 mg, 0.4031 mmol), 2,5-bis-trimethylstannanyl-thiophene (330.3 mg, 0.8062 mmol), 4,7-dibromo-5,6-bis-octyloxy-benzo[1,2,5]thiadiazole (221.8 mg, 0.4031 mmol), Pd₂(dba)₃ (14.8 mg, 0.0161 mmol) and tri-*o*-tolyl-phosphine (19.6 mg, 0.0645 mmol) are placed in a microwave vial. The microwave vial is subjected to three successive cycles of vacuum followed by refilling with nitrogen. Degassed chlorobenzene (3.4 cm³) is added and the mixture is purged with nitrogen for 5 minutes. The reaction mixture is placed in a microwave reactor (Biotage Initiator) and heated sequentially at 140 °C (60 seconds), 160 °C (60 seconds) and 165 °C (1800 seconds). Immediately after completion of the reaction, the reaction mixture is allowed to cool to 65 °C and bromobenzene (0.085 cm³, 0.81 mmol) is added. The reaction mixture is placed back in the microwave reactor and heated back to 165 °C (600 seconds). Immediately after completion of the first end-capping reaction, the reaction mixture was allowed to cool to 65 °C and tributyl phenyl stannane (0.40 cm³, 1.2 mmol) is added. The reaction mixture is placed back in the microwave reactor and heated back to 165 °C (600 seconds). After completion of the second end-capping reaction, the reaction mixture is allowed to cool to 65 °C and is precipitated into stirred methanol (100 cm³) with methanol washings of the reaction tube. The mixture is stirred for 10 minutes, the polymer is collected by filtration and washed with methanol (100 cm³). The polymer is subjected to Soxhlet extraction with acetone (orange solution), cyclohexane (purple solution) and chloroform (purple solution). Methanol (200 cm³) is dropwise to the chloroform fraction (150 cm³), and the precipitate collected by filtration to give a black solid (310 m). GPC (140 °C, trichlorobenzene): Mₙ = 29.8 kg/mol, M_{w} = 60.6 kg/mol, PDI = 2.03.

### Example 2

### 4,8-Bis-(1,1-difluoro-dodecyl)-2,6-bis-trimethylstannanyl-benzo[1,2-b;4,5-b']dithiophene (2.1)

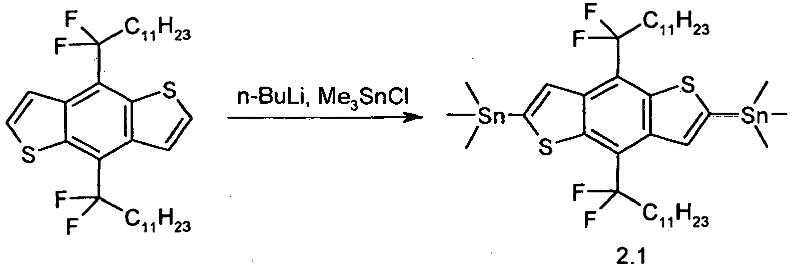

2,6-Dibromo-4,8-bis-(1,1-difluoro-dodecyl)-benzo[1,2-b;4,5-b']dithiophene (2.40 g, 4.00 mmol) is dissolved in THF (60 cm³) and the solution is cooled to -78 °C. N-Butyl lithium (3.4 cm³, 2.5 M in hexane, 8.4 mmol) is added dropwise over 5 minutes and the resulting mixture is stirred at -78 °C for 30 minutes and then at 23 °C for 30 minutes. The mixture is cooled back to -78 °C and a solution of trimethyltinchloride (8.8 cm³, 1.0 M in hexane, 8.8 mmol) is added in one portion. The cooling bath is removed and the resulting solution is stirred at room temperature for 2 hours. The reaction mixture is poured into water (100 cm³) and extracted into diethyl ether (3 x 100 cm³). The combined organic fractions are dried over sodium sulfate and concentrated *in vacuo* to give an orange oil (2.75 g, 2.98 mmol, 75%, 75 % purity). ¹H NMR (300 MHz, CDCl₃): 0.48 (18H, s), 0.88 (6H, t, *J* = 7.0 Hz), 1.20-1.35 (32H, m), 1.48-1.72 (4H, m), 2.28-2.48 (4H, m), 7.65 (2H, s).

### Poly{2,6-[4,8-di(1,1-difluoro-dodecyl)benzo[1,2-b:4.5-b']dithiophene]-alt-5',5"-[4,7-bis(thien-2-yl)-5,6-dioctyloxy-2,1,3-benzothiadiazole]} (2.2)

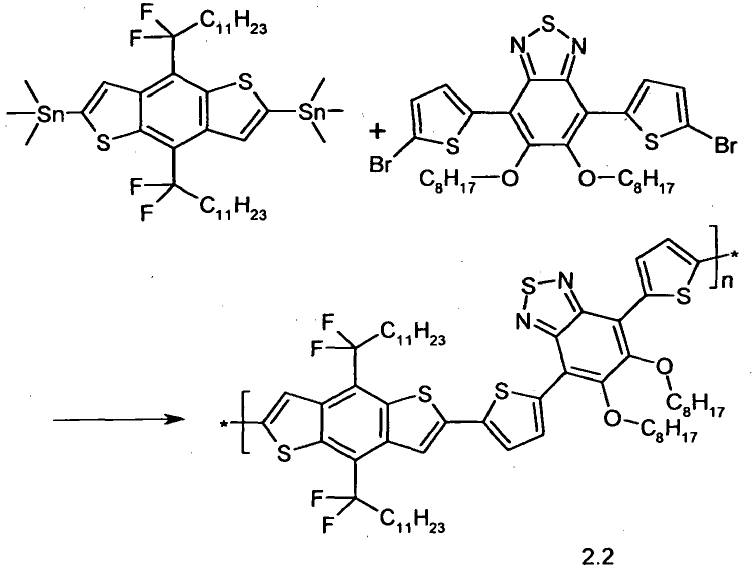

4,8-Bis-(1,1-difluoro-dodecyl)-2,6-bis-trimethylstannanyl-benzo[1,2-b;4,5-b']dithiophene (738.9 mg, 0.5994 mmol, 75 % purity), 4,7-bis(5-bromo-thiophen-2-yl)-5,6-bis-octyloxy-benzo[1,2,5]thiadiazole (428.4 mg, 0.5994 mmol), Pd₂(dba)₃ (11.0 mg, 0.0120 mmol) and tri-o-tolyl-phosphine (14.6 mg, 0.0480 mmol) were placed in a microwave vial. The microwave vial is subjected to three successive cycles of vacuum followed by refilling with nitrogen. Degassed chlorobenzene (5.0 cm³) is added and the mixture is degassed for 5 minutes. The reaction mixture is placed in a microwave reactor (Biotage Initiator)and heated sequentially at 140 °C (60 seconds), 160°C (60 seconds) and 165°C (1800 seconds). Immediately after completion of the reaction, the reaction mixture is allowed to cool to 65 °C and bromobenzene (0.13 cm³, 1.20 mmol) is added. The reaction mixture is placed back in the microwave reactor and heated back to 165 °C (600 seconds). Immediately after completion of the first end-capping reaction, the reaction mixture was allowed to cool to 65°C and tributyl phenyl stannane (0.59 cm³, 1.8 mmol) is added. The reaction mixture is placed back in the microwave reactor and heated back to 165°C (600 seconds). After completion of the second end-capping reaction, the reaction mixture is allowed to cool to 65°C and is precipitated into stirred methanol (100 cm³). The mixture is stirred for 10 minutes, the polymer is collected by filtration and washed with methanol (100 cm³) to give a black solid (778 mg). GPC (50°C, chlorobenzene): Mₙ = 4.6 kg/mol, M_{w} = 8.1 kg/mol, PDI = 1.77

### Example 3

### Poly{2,6-[4,8-di(1,1-difluoro-dodecyl)benzo[1,2-b:4,5-b']dithiophene]-alt-5',5"-[3,6-Bis-(thiophen-2-yl)-2,5-bis-(2-ethyl-hexyl)-2,5-dihydro-pyrrolo[3,4-c]pyrrole-1,4-dione]} (3.1)

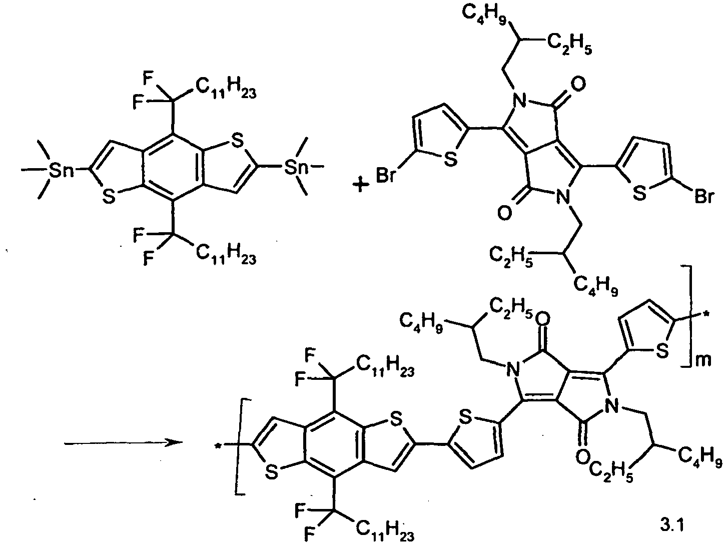

4,8-Bis-(1,1-difluoro-dodecyl)-2,6-bis-trimethylstannanyl-benzo[1,2-b;4,5-b']dithiophene (335.8 mg, 0.2724 mmol, 75 % purity), 3,6-Bis-(5-bromo-thiophen-2-yl)-2,5-bis-(2-ethyl-hexyl)-2,5-dihydro-pyrrolo[3,4-c]pyrrole-1,4-dione (185.9 mg, 0.2724 mmol), Pd₂(dba)₃ (5.0 mg, 0.0054 mmol) and tri-o-tolyl-phosphine (6.6 mg, 0.022 mmol) were placed in a microwave vial. The microwave vial is subjected to three successive cycles of vacuum followed by refilling with nitrogen. Degassed chlorobenzene (2.3 cm³) is added and the mixture is degassed for 5 minutes. The reaction mixture is placed in a microwave reactor (Biotage Initiator) and heated sequentially at 140 °C (60 seconds), 160 °C (60 seconds) and 170 °C (1800 seconds). Immediately after completion of the reaction, the reaction mixture is allowed to cool to 65 °C and bromobenzene (0.057 cm³, 0.55 mmol) is added. The reaction mixture is placed back in the microwave reactor and heated back to 170 °C (600 seconds). Immediately after completion of the first end-capping reaction, the reaction mixture was allowed to cool to 65 °C and tributyl phenyl stannane (0.27 cm³, 0.82 mmol) is added. The reaction mixture is placed back in the microwave reactor and heated back to 170 °C (600 seconds). Immediately after completion of the second end-capping reaction, the reaction mixture is allowed to cool to 65 °C and is precipitated into stirred methanol (100 cm³). The mixture is stirred for 10 minutes, the polymer is collected by filtration and washed with methanol (100 cm³) to give a black solid (343 mg). GPC (50 °C, chlorobenzene): Mₙ = 5.0 kg/mol, M_{w} = 12.4 kg/mol, PD = 2.49.

### Example 4

### Poly{2,6-[4,8-di(1,1-difluoro-dodecyl)benzo[1,2-b:4,5-b']dithiophene]-alt-1,3-[5-octyl-thieno[3,4-c]pyrrole-4,6-dione]} (4.1)

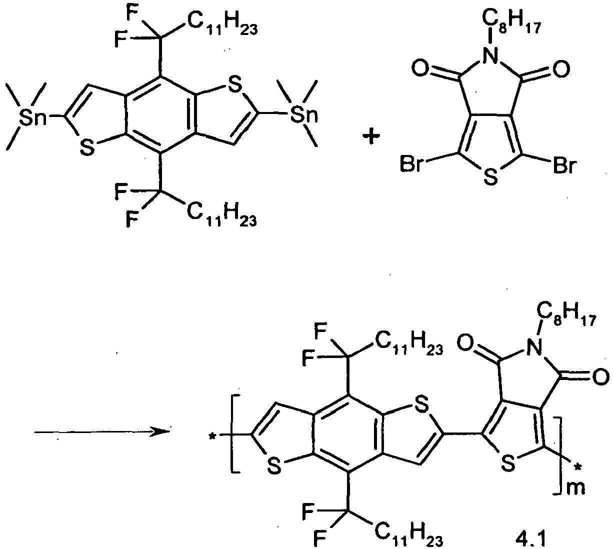

4,8-Bis-(1,1-difluoro-dodecyl)-2,6-bis-trimethylstannanyl-benzo[1,2-b;4,5-b']dithiophene (374.6 mg, 0.3039 mmol, 75 % purity), 1,3-dibromo-5-octyl-thieno[3,4-c]pyrrole-4,6-dione (128.6 mg, 0.3039 mmol), Pd₂(dba)₃ (5.6 mg, 0.0061 mmol) and tri-o-tolyl-phosphine (7.4 mg, 0.024 mmol) were placed in a microwave vial. The microwave vial is subjected to three successive cycles of vacuum followed by refilling with nitrogen. Degassed chlorobenzene (2.5 cm³) is added and the mixture is degassed for 5 minutes. The reaction mixture is placed in a microwave reactor (Biotage Initiator)and heated sequentially at 140 °C (60 seconds), 160 °C (60 seconds) and 170 °C (1800 seconds). Immediately after completion of the reaction, the reaction mixture is allowed to cool to 65 °C and bromobenzene (0.064 cm³, 0.61 mmol) is added. The reaction mixture is placed back in the microwave reactor and heated back to 170 °C (600 seconds). Immediately after completion of the first end-capping reaction, the reaction mixture was allowed to cool to 65 °C and tributyl phenyl stannane (0.30 cm³, 0.91 mmol) is added. The reaction mixture is placed back in the microwave reactor and heated back to 170 °C (600 seconds). Immediately after completion of the second end-capping reaction, the reaction mixture is allowed to cool to 65 °C and is precipitated into stirred methanol (100 cm³). The mixture is stirred for 10 minutes, the polymer is collected by filtration and washed with methanol (100 cm³) to give a red solid (329 mg). GPC (50 °C, chlorobenzene): Mn = 3.4 kg/mol, Mw = 6.6 kg/mol, PD = 1.92.

### Example 5

### Poly{2,6-[4,8-di(1,1-difluoro-dodecyl)benzo[1,2-b:4,5-b']dithiophene]-alt-4,6[1-(thieno[3,4-b]thiophen-2-yl)-2-ethyl-hexan-1-one]} (5.1)

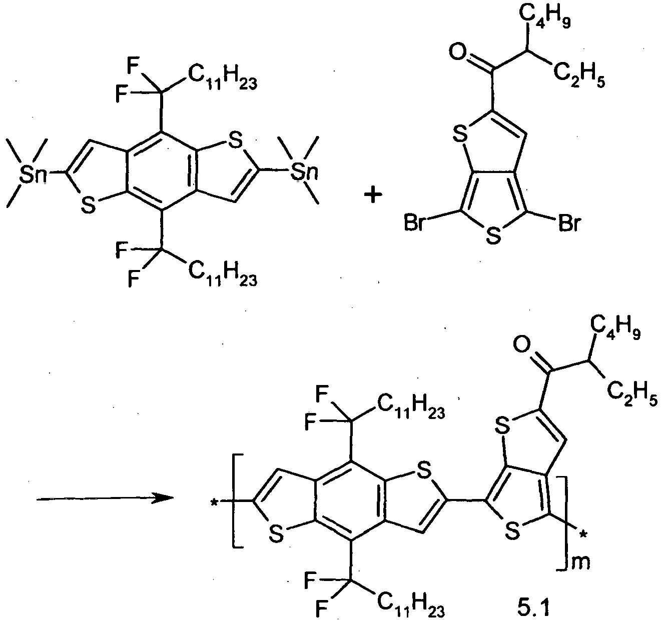

4,8-Bis-(1,1-difluoro-dodecyl)-2,6-bis-trimethylstannanyl-benzo[1,2-b;4,5-b']dithiophene (290.0 mg, 0.2353 mmol), 1-(4,6-dibromo-thieno[3,4-b]thiophen-2-yl)-2-ethyl-hexan-1-one (99.8 mg, 0.235mmol), Pd₂(dba)₃ (4.3 mg, 0.0047 mmol) and tri-*o*-tolyl-phosphine (5.7 mg, 0.019 mmol) were placed in a microwave vial. The microwave vial is subjected to three successive cycles of vacuum followed by refilling with nitrogen. Degassed chlorobenzene (2.0 cm³) is added and the mixture is degassed for 5 minutes. The reaction mixture is placed in a microwave reactor (Biotage Initiator)and heated sequentially at 140 °C (60 seconds), 160 °C (60 seconds) and 170 °C (1800 seconds). Immediately after completion of the reaction, the reaction mixture is allowed to cool to 65 °C and bromobenzene (0.050 cm³, 0.47 mmol) is added. The reaction mixture is placed back in the microwave reactor and heated back to 170 °C (600 seconds). Immediately after completion of the first end-capping reaction, the reaction mixture was allowed to cool to 65 °C and tributyl phenyl stannane (0.23 cm³, 0.71 mmol) is added. The reaction mixture is placed back in the microwave reactor and heated back to 170 °C (600 seconds). Immediately after completion of the second end-capping reaction, the reaction mixture is allowed to cool to 65 °C and is precipitated into stirred methanol (100 cm³). The mixture is stirred for 10 minutes, the polymer is collected by filtration and washed with methanol (100 cm³) to give a black solid (250 mg). GPC (50 °C, chlorobenzene): Mₙ = 2.8 kg/mol, M_{w} = 4.3 kg/mol, PD = 1.57.

### Example 6

### Bulk heterojunction OPV devices containing a polymer of Example 1

OPV devices are fabricated on ITO-glass substrates (13Ω/□), purchased from Zencatec. The substrates are subjected to a conventional photolithography process to define the bottom electrodes (anodes) before cleaning using common solvents (acetone, IPA, DI water) in an ultrasonic bath.

A conducting polymer poly(ethylene dioxythiophene) doped with poly(styrene sulfonic acid) [Clevios VPAI 4083 (H.C. Starck)] is mixed in a 1:1 ratio with DI-water. This solution is sonicated for 20 minutes to ensure proper mixing and filtered using a 0.2 µm filter before spin coating to a thickness of 20 nm. The substrates are exposed to a UV-ozone treatment prior to the spin-coating process to ensure good wetting properties. The films are then annealed at 130 °C for 30 minutes in an inert atmosphere.

Photoactive material solutions, containing the polymer of example 1 as p-type material and C₆₀PCBM as n-type material in the solvent, are prepared at the concentrations and component ratios as shown in Tabel 1 below, and stirred overnight. Thin films are either spin coated or blade coated in an inert atmosphere to achieve thicknesses between 100 and 200 nm, measured using a profilemeter. A short drying period followes to ensure removal of excess solvent. Typically, spin coated films are dried at 23°C for 10 minutes. Blade coated films are dried at 70°C for 3 minutes on the hotplate.

As the last step of the device fabrication, Calcium (30nm)/Al (200nm) cathodes are thermally evaporated through a shadow mask to define cells. Samples are measured at 23°C using a Solar Simulator from Newport Ltd (model 91160) as a light source, calibrated to 1 sun using a Si reference cell.

The device performance is described in Table 1. A typical J-V curve for one of the OPV devices is shown in **Figure 1****.**

**Table 1: Average open circuit potential (V_{oc}), current density (J_{sc}), fill factor (FF), power conversion efficiency (PCE) and best power conversion efficiency for specific ratios of the polymer of Example 1 and C₆₀PCBM.**

| **ratio** | **conc.** | **Voc.** | **Jsc** | **FF** | **PCE** | **PCE SD** | **Best PCE** |
|---|---|---|---|---|---|---|---|
| **Polymer: PCBM** | **mg·ml⁻¹** | **mV** | **mA·cm⁻²** | **%** | **%** | | **%** |
| 1.0:1.0 | 30 | 888 | -6.96 | 36.8 | 2.29 | 0.75 | 3.06 |
| 1.0:1.5 | 30 | 872 | -8.15 | 45.0 | 3.19 | 0.89 | 3.60 |
| 1.0:2.0 | 30 | 869 | -8.11 | 47.3 | 3.34 | 0.95 | 3.51 |
| 1.0:3.0 | 30 | 862 | -6.95 | 46.2 | 2.77 | 0.90 | 3.08 |

## Claims

1. A polymer comprising one or more divalent units of formula I 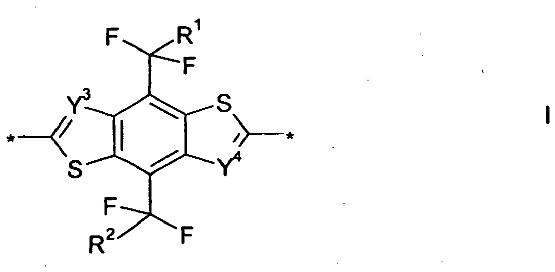 wherein
Y³ is N or CR³,
Y⁴ is N or CR⁴.
R¹, R² denote independently of each other, and on each occurrence identically or differently, straight-chain, branched or cyclic alkyl with 1 to 30 C atoms, preferably 1 to 20 C atoms, in which one or more non-adjacent C atoms are optionally replaced by -O-, -S-, -C(O)-, -C(O)-O-, -O-C(O)-, -CH=CH- or -C=C- and which are unsubstituted or substituted by F, Cl, Br, I or CN,
R³, R⁴ denote independently of each other, and on each occurrence identically or differently, H, halogen, or an optionally substituted carbyl or hydrocarbyl group, wherein one or more C atoms are optionally replaced by a hetero atom.

2. The polymer according to claim 1, **characterized in that** the units of formula I are selected from the group consisting of the following subformulae 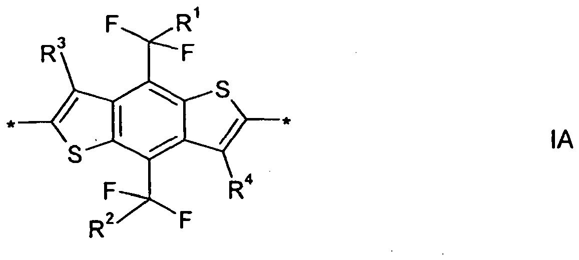 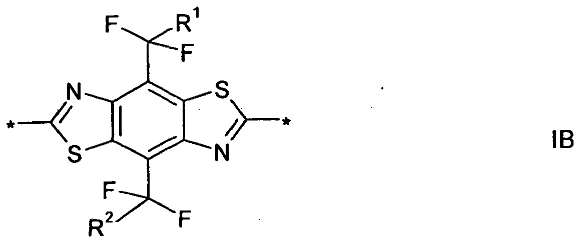 wherein R¹, R², R³ and R⁴ have the meanings given in claim 1.

3. The polymer according to claim 1 or 2, **characterized in that** it comprises one or more units of formula II
-[(Ar¹)ₐ-(U)_{b}-(Ar²)_{c}-(Ar³)_{d}]- II
wherein
U is a unit of formula I as defined in claim 1,
Ar¹, Ar², Ar³ are, on each occurrence identically or differently, and independently of each other, aryl or heteroaryl that is different from U, preferably has 5 to 30 ring atoms and is optionally substituted, preferably by one or more groups R¹,
R¹ is on each occurrence identically or differently F, Br, Cl, -CN, -NC, -NCO, -NCS, -OCN, -SCN, -C(O)NR⁰R⁰⁰,-C(O)X⁰, -C(O)R⁰, -NH₂, -NR⁰R⁰⁰, -SH, -SR⁰, -SO₃H-SO₂R⁰, -OH, -NO₂, -CF₃, -SF₅, optionally substituted silyl, carbyl or hydrocarbyl with 1 to 40 C atoms that is optionally substituted and optionally comprises one or more hetero atoms, or P-Sp-,
R⁰ and R⁰⁰ are independently of each other H or optionally substituted C₁₋₄₀ carbyl or hydrocarbyl,
P is a polymerisable or crosslinkable group,
Sp is a spacer group or a single bond,
X⁰ is halogen, preferably F, Cl or Br,
a, b, c are on each occurrence identically or differently 0, 1 or 2,
d is on each occurrence identically or differently 0 or an integer from 1 to 10,
wherein the polymer comprises at least one repeating unit of formula II wherein b is at least 1.

4. The polymer according to one or more of claims 1 to 3, **characterized in that** it additionally comprises one or more repeating units selected of formula III
-[(Ar¹)ₐ-(A¹)_{b}-(Ar²)_{c}-(Ar³)_{d}]- III
wherein Ar¹, Ar², Ar³, a, b, c and d are as defined in claim 3, and A¹ is an aryl or heteroaryl group that is different from U and Ar¹⁻³, has 5 to 30 ring atoms, is optionally substituted by one or more groups R¹ as defined in claim 1, and is selected from aryl or heteroaryl groups having electron donor properties, wherein the polymer comprises at least one repeating unit of formula III wherein b is at least 1.

5. The polymer according to one or more of claims 1 to 4, **characterized in that** it is selected of formula IV: 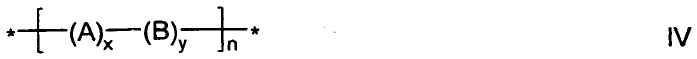 wherein
A is a unit of formula I, IA, IB or II as defined in claim 1, 2 or 3,
B is a unit that is different from A and comprises one or more aryl or heteroaryl groups that are optionally substituted, and is preferably selected of formula III as defined in claim 4,
x is > 0 and ≤ 1,
y is ≥ 0 and < 1,
x + y is 1, and
n is an integer >1.

6. The polymer according to one or more of claims 1 to 5, **characterized in that** it is selected from the following formulae
*-[(Ar¹-U-Ar²)ₓ-(Ar³)_{y}]ₙ- * IVa
*-[(Ar¹-U Ar²)ₓ-(Ar³-Ar³)_{y}]n-* IVb
*-[(Ar¹-U-Ar²)ₓ-(Ar³-Ar³-Ar³)_{y}]ₙ- * IVc
*-[(Ar¹)ₐ-(U)_{b}-(Ar²)_{c}-(Ar³)_{d}]ₙ-* IVd
*-([(Ar¹)ₐ-(U)_{b}-(Ar²)_{c}-(Ar³)_{d}]ₓ-[(Ar¹)ₐ-(A¹)_{b}-(Ar²)_{c}-(Ar³)_{d}]_{y})ₙ-* IVe
wherein U, Ar¹, Ar², Ar³, a, b, c and d have in each occurrence identically or differently one of the meanings given in claim 3, A¹ has on each occurrence identically or differently one of the meanings given in claim 4, and x, y and n are as defined in claim 5, wherein these polymers can be alternating or random copolymers, and wherein in formula IVd and IVe in at least one of the repeating units [(Ar¹)ₐ-(U)_{b}-(Ar²)_{c}-(Ar³)_{d}] and in at least one of the repeating units [(Ar¹)ₐ-(D)_{b}-(Ar²)_{c}-(Ar³)_{d}] b is at least 1.

7. The polymer according to one or more of claims 1 to 6, **characterized in that** it is selected of formula V
R⁵-chain-R⁶ V
wherein "chain" is a polymer chain of formula IV or of the formulae IVa to IVf as defined in claim 4 or 5, and R⁵ and R⁶ denote independently of each other F, Br, Cl, H, -CH₂Cl, -CHO, -CH=CH₂, -SiR'R"R"', -SnR'R"R"', -BR'R", -B(OR')(OR"), -B(OH)₂, or P-Sp-, wherein P and Sp are as defined in claim 3, R', R" and R'" have independently of each other one of the meanings of R⁰ given claim 3, and two of R', R" and R"' may also form a ring together with the hetero atom to which they are attached.

8. The polymer according to one or more of claims 1 to 7, **characterized in that** R¹ and R² independently of each other denote straight-chain or branched alkyl with 1 to 20 C atoms which is unsubsituted or substituted by one or more F atoms.

9. The polymer according to one or more of claims 3 to 8, wherein one or more of Ar¹, Ar² and Ar³ denote aryl or heteroaryl selected from the group consisting of the following formulae 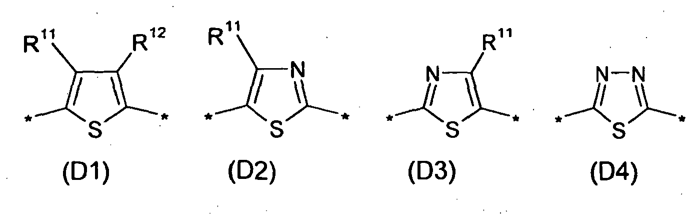 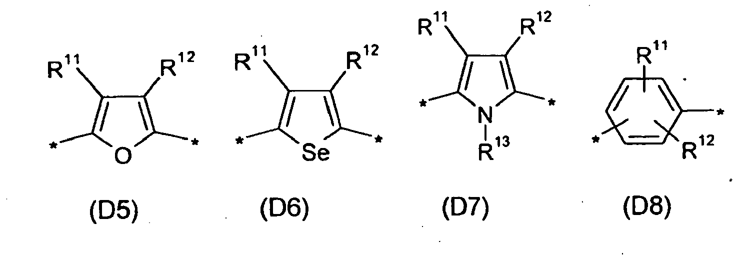 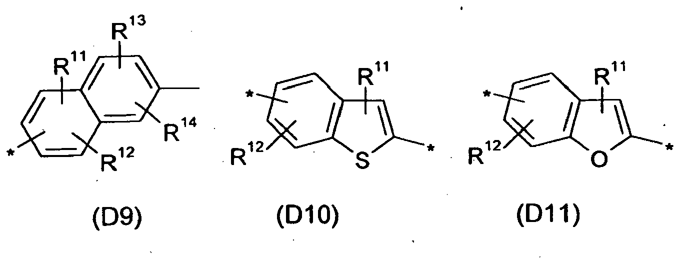 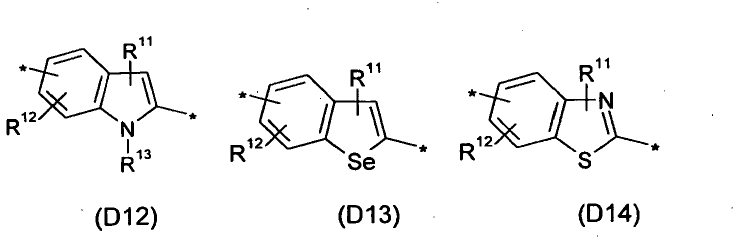 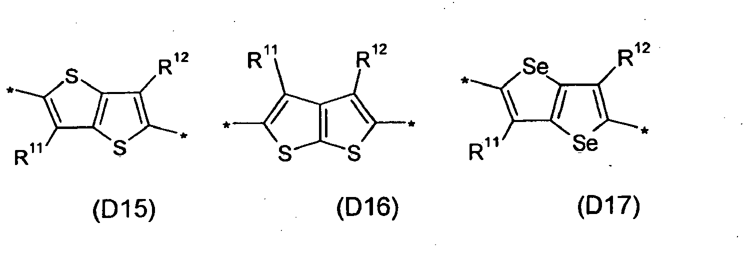 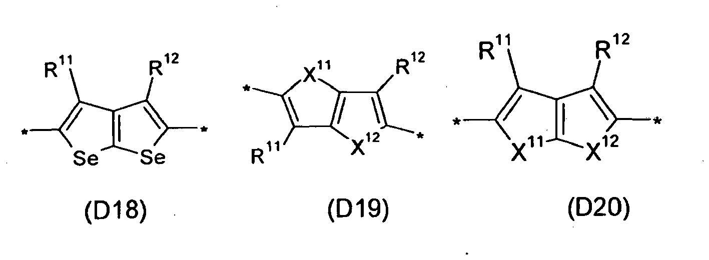 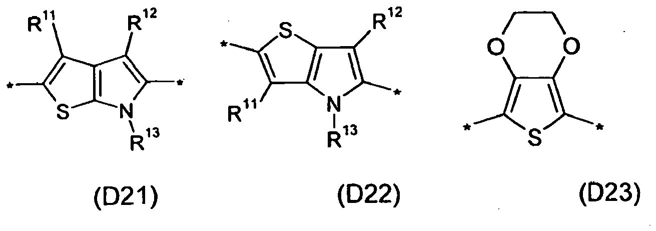 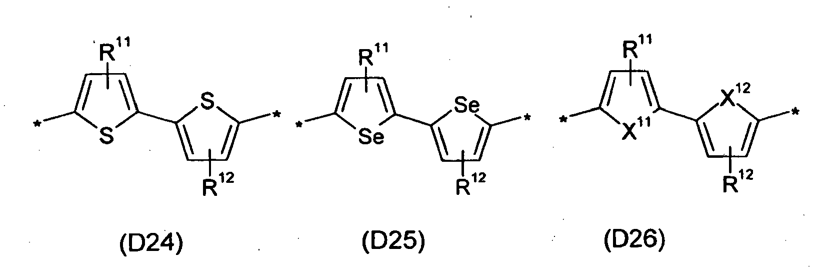 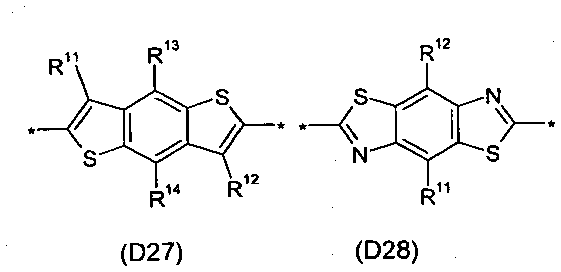 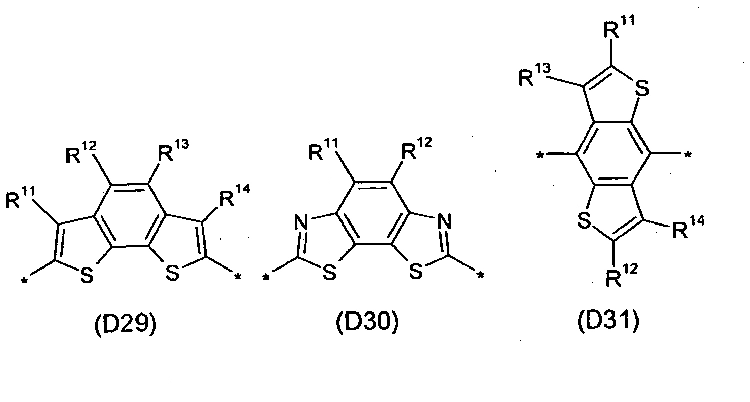 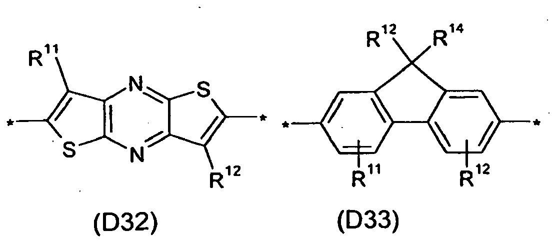 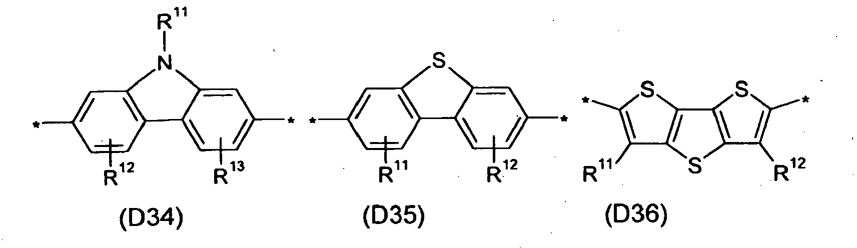 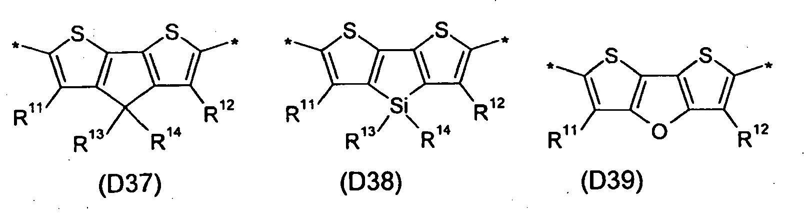 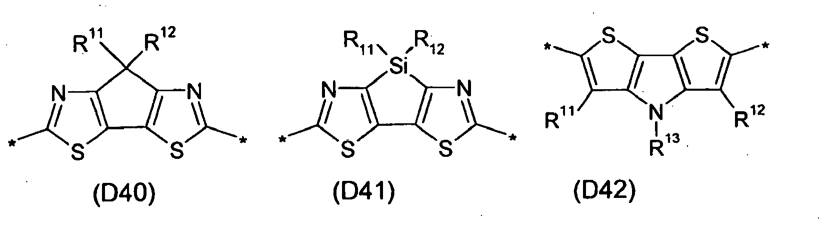 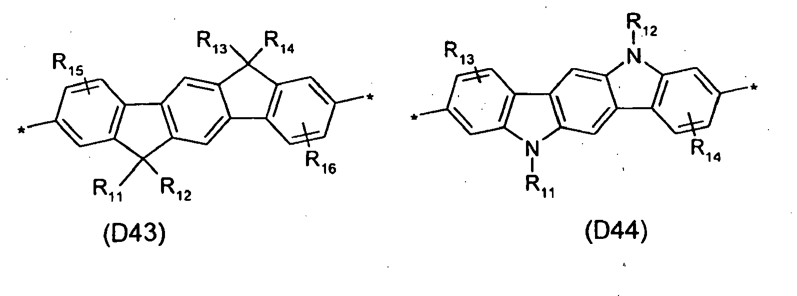 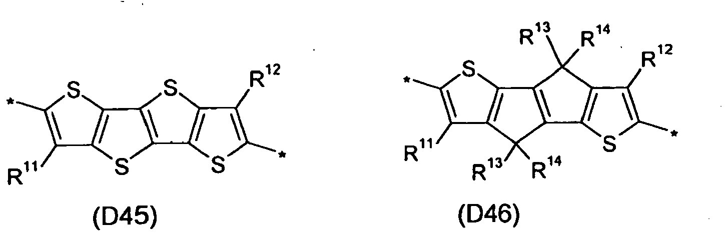 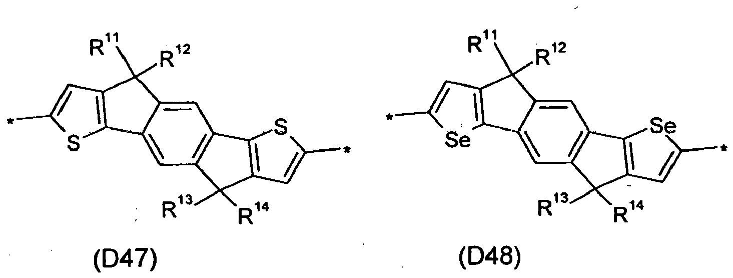 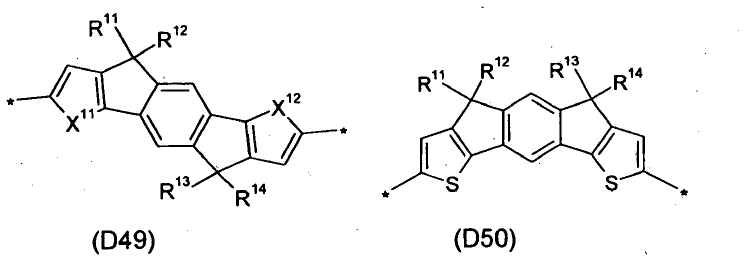 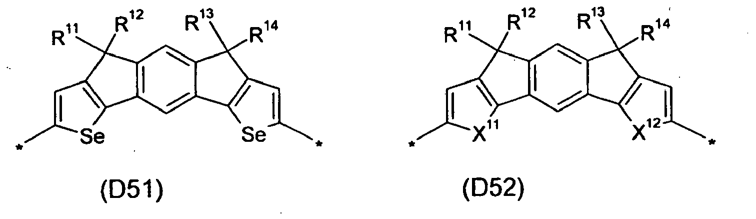 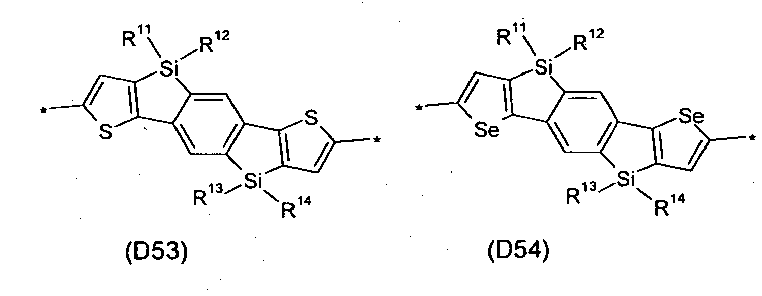 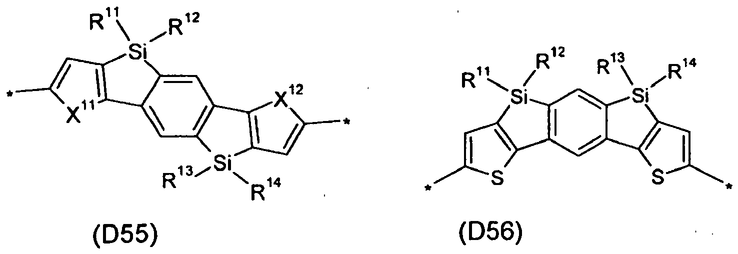 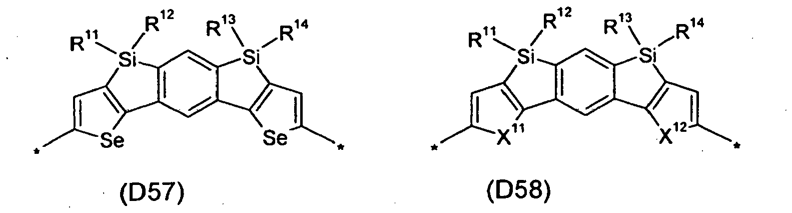 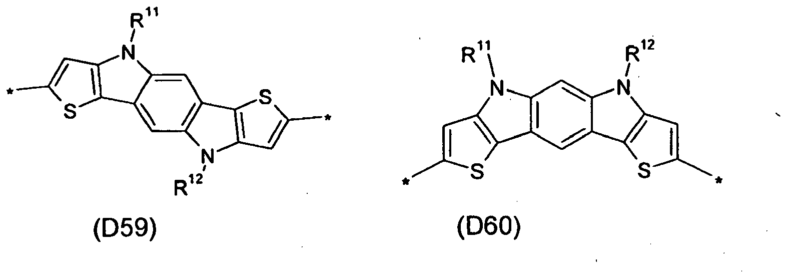 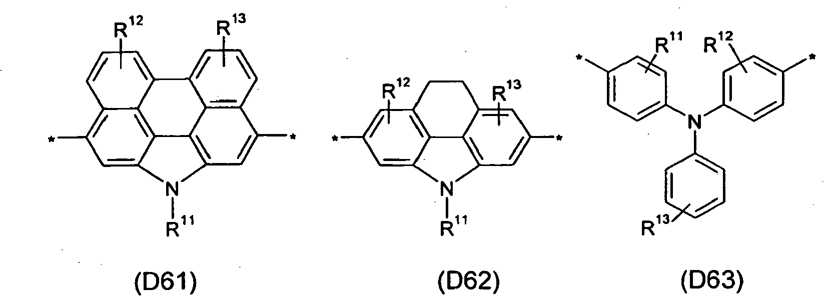 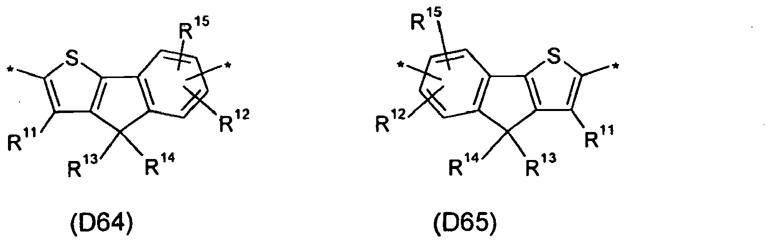 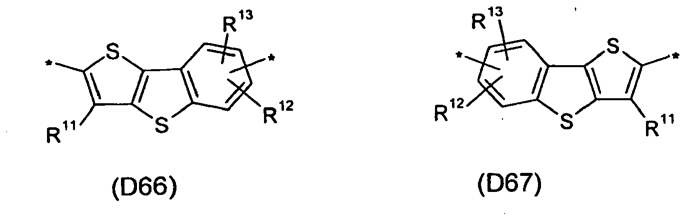 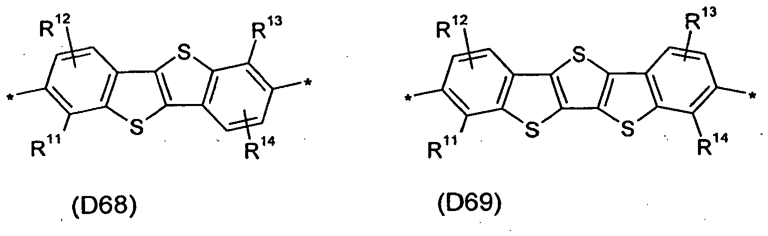 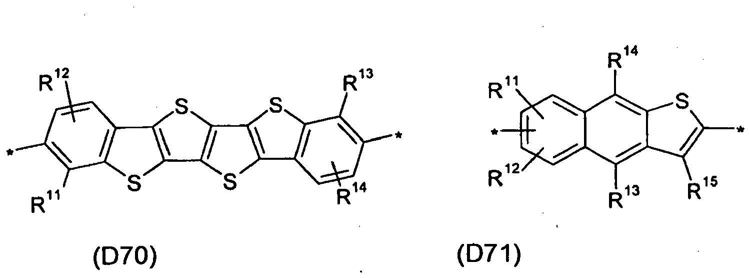 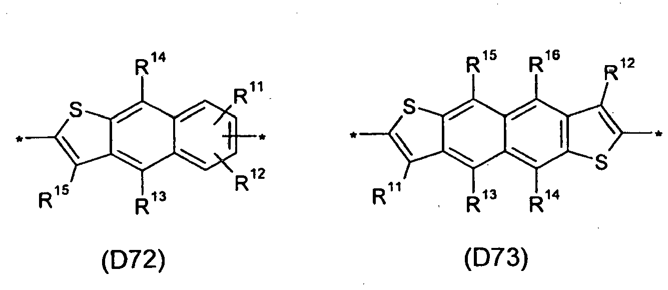 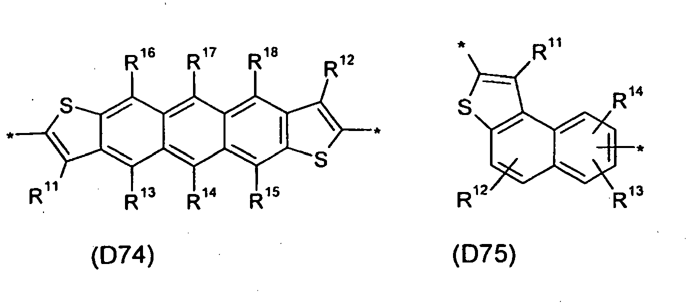 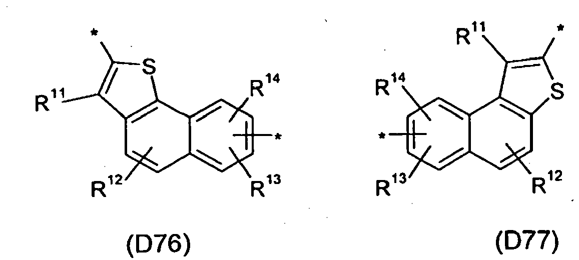 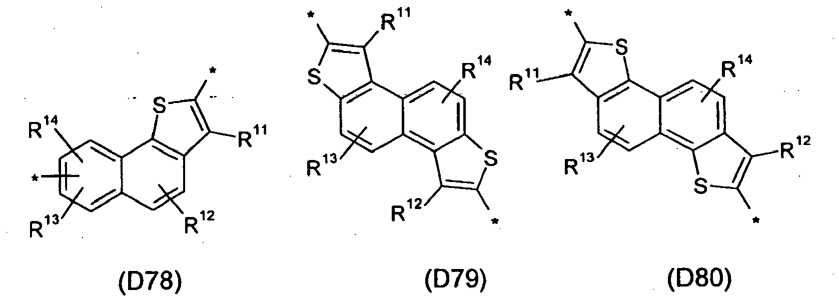 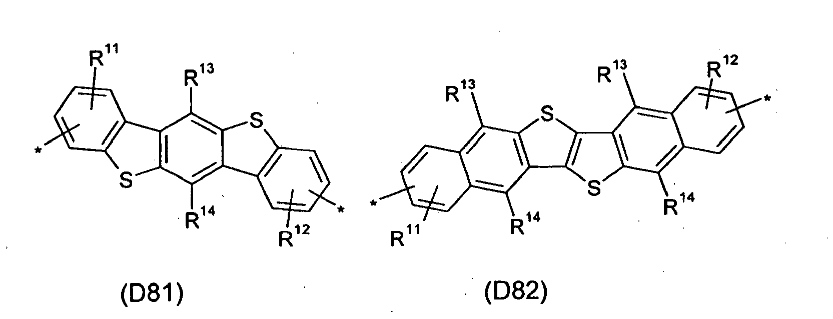 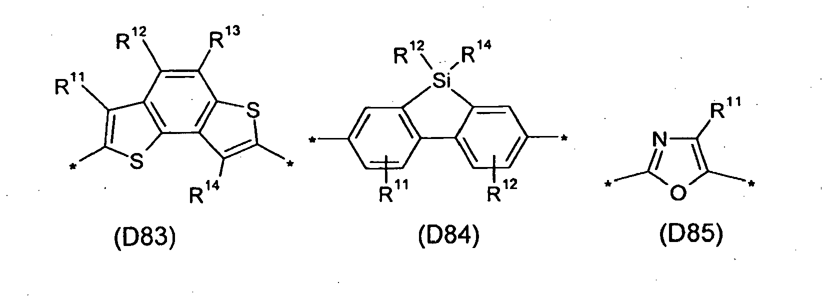 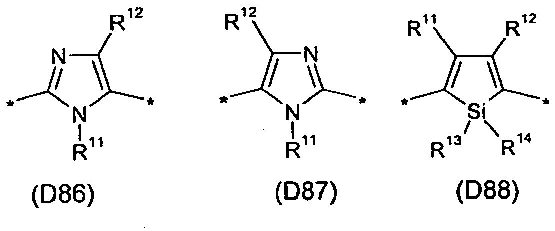 wherein one of X¹¹ and X¹² is S and the other is Se, and R¹¹, R¹², R¹³, R¹⁴, R¹⁵, R¹⁶, R¹⁷ and R¹⁸ independently of each other denote H or have one of the meanings of R¹ as defined in claim 1.

10. The polymer according to one or more of claims 3 to 9, wherein one or more of Ar³ and A¹ denote aryl or heteroaryl selected from the group consisting of the following formulae 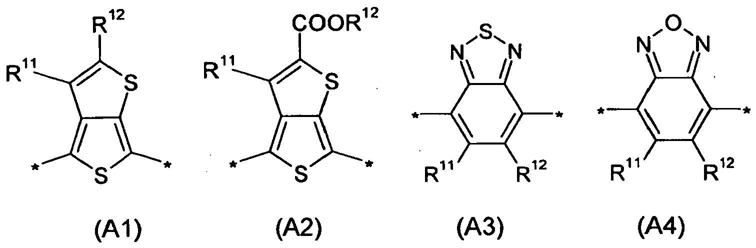 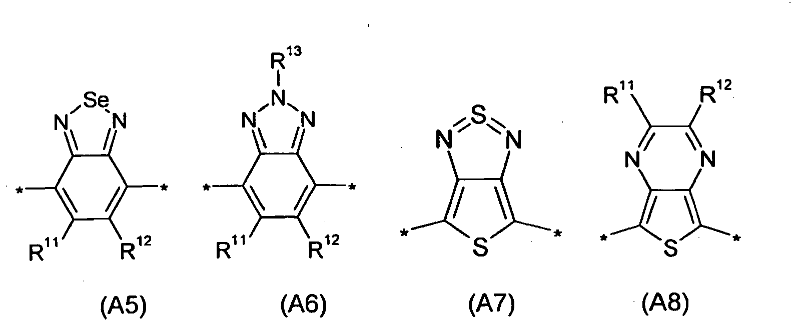 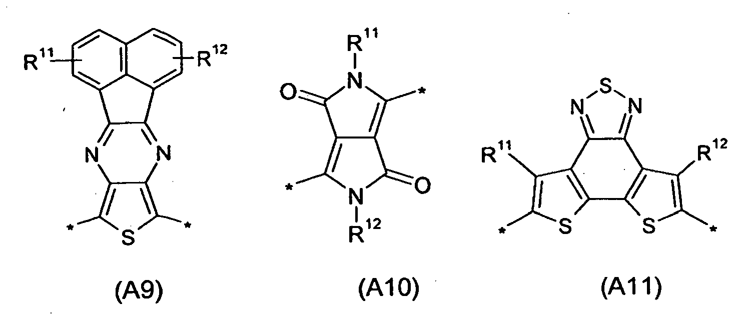 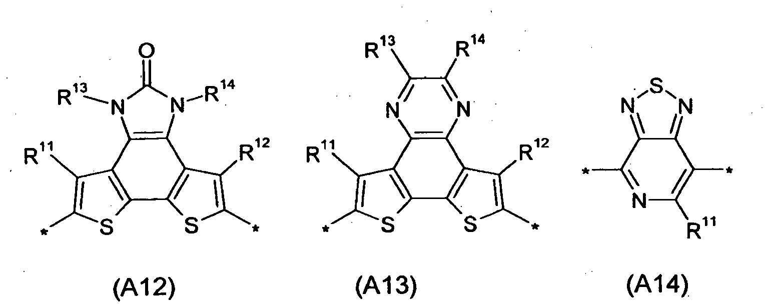 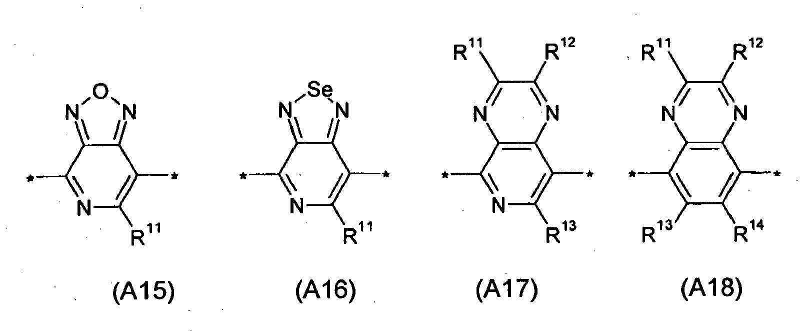 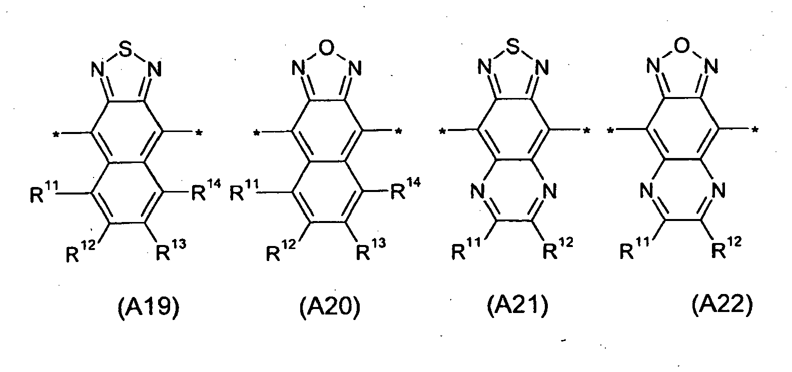 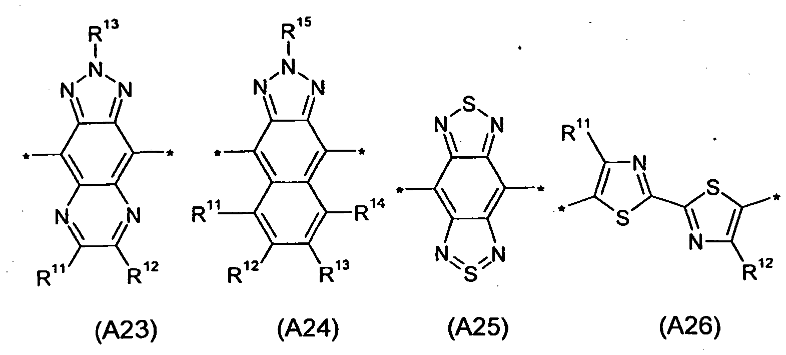 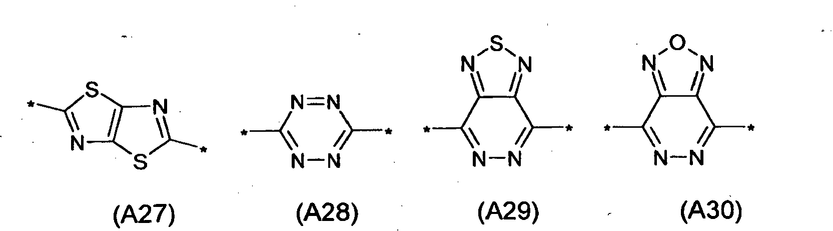 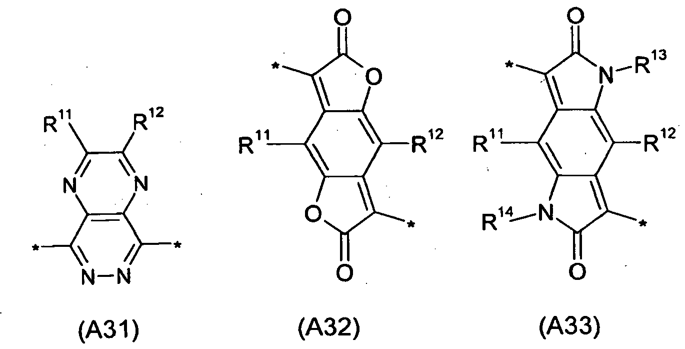 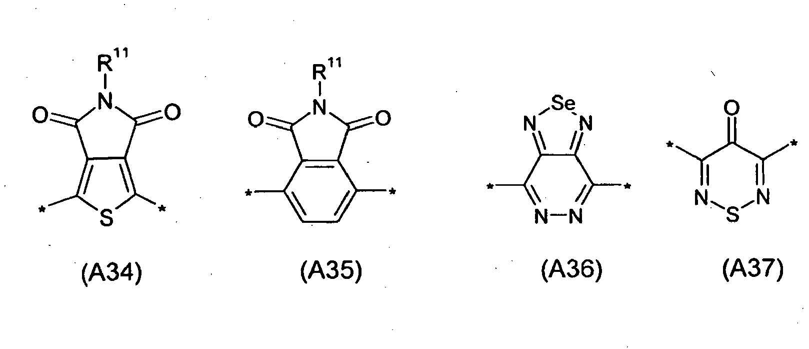 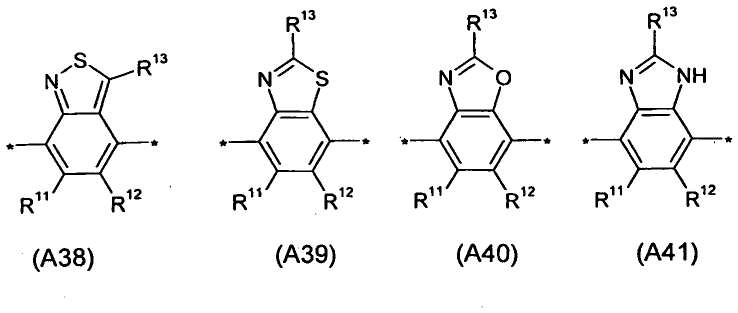 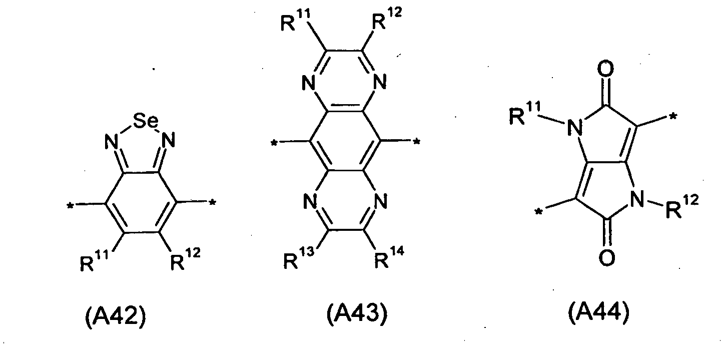 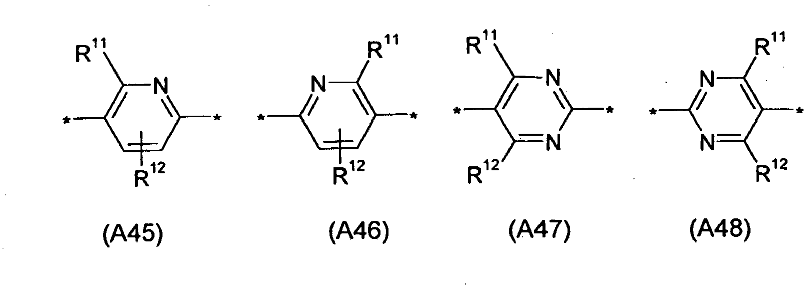 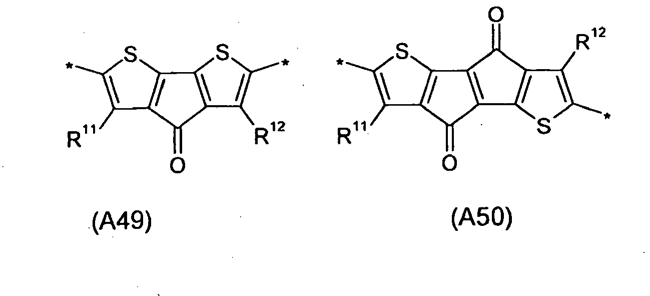 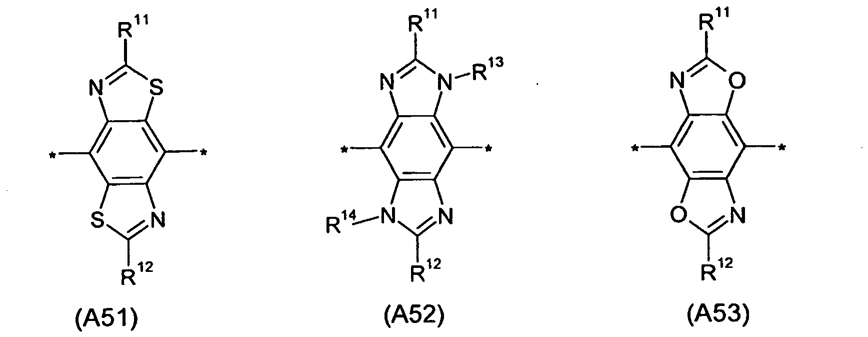 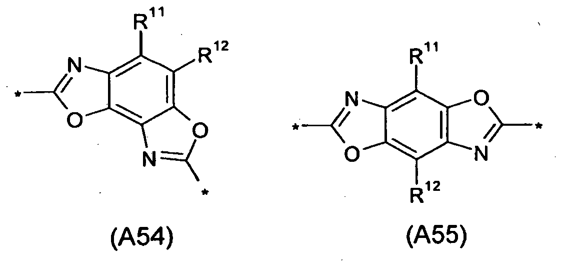 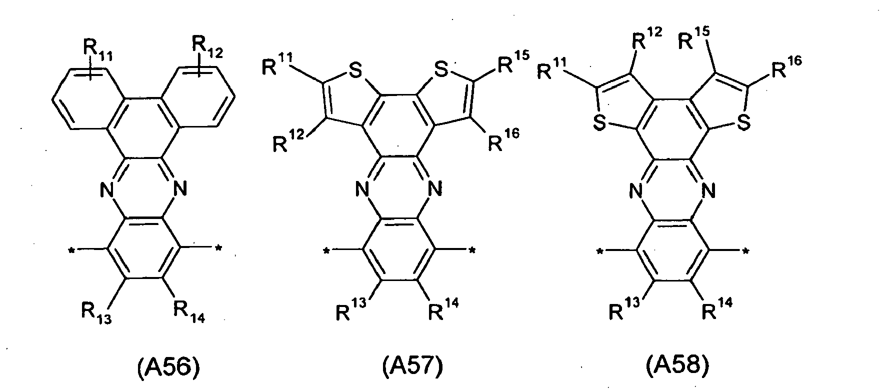 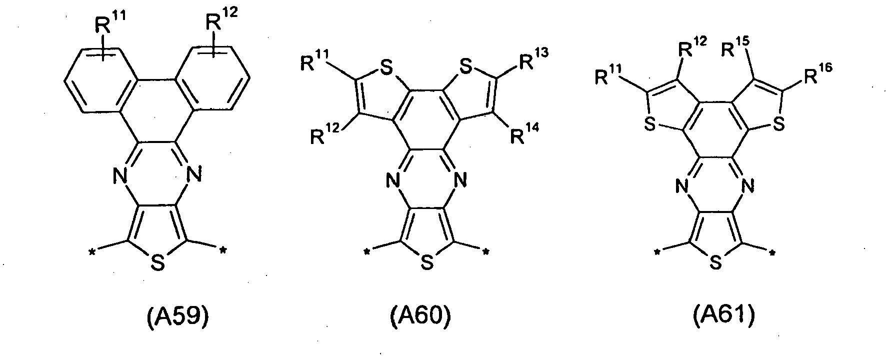 wherein one of X¹¹ and X¹² is S and the other is Se, and R¹¹, R¹², R¹³, R¹⁴ and R¹⁵ independently of each other denote H or have one of the meanings of R¹ as defined in claim 1.

11. The polymer according to one or more of claims 1 to 10, which is selected from the following formulae 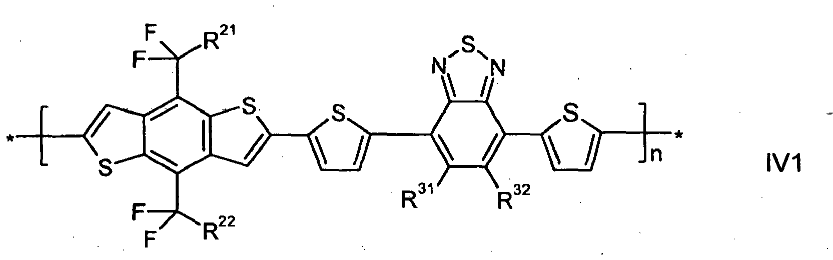 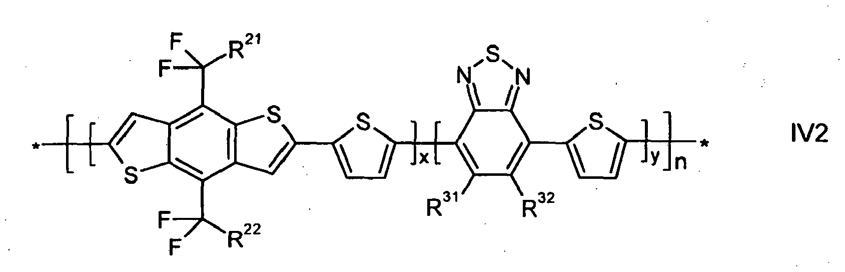 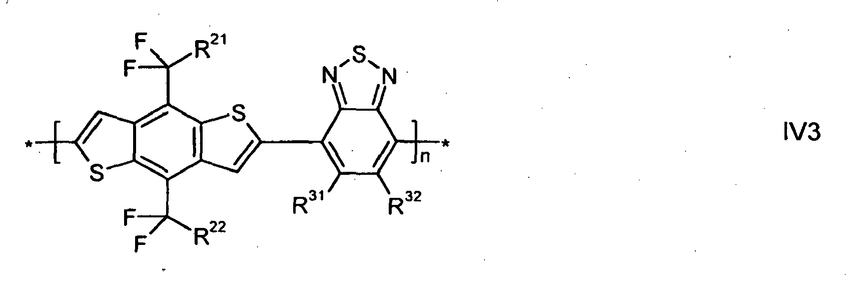 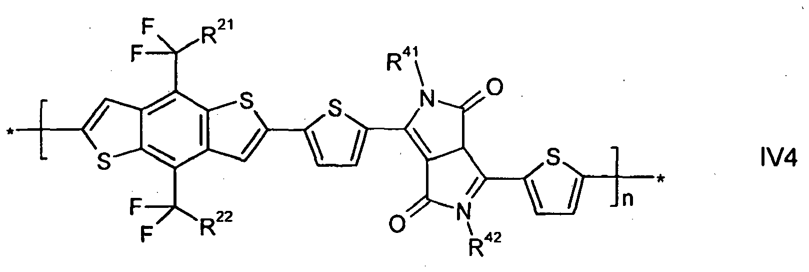 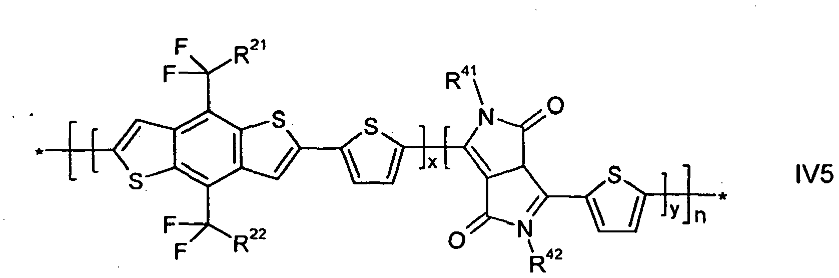 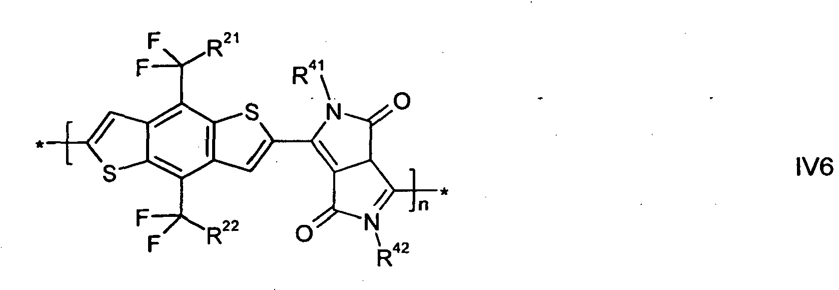 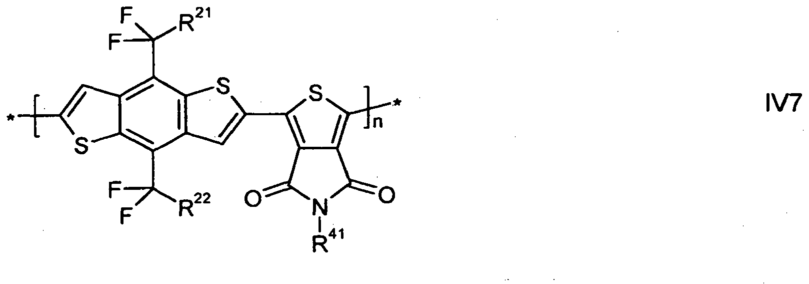 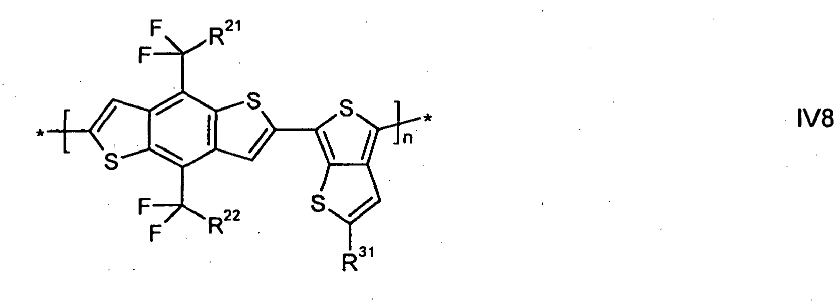 wherein n, x and y are as defined in claim 5, R²¹ and R²² have one of the meanings given for R¹ in claim 1, and R³¹, R³², R⁴¹ and R⁴² have one of the meanings given for R³ in claim 1, and wherein the thiophene rings are optionally substituted by one or two groups R³¹.

12. The polymer according to one or more of claims 1 to 11, wherein R¹ and/or R² denote independently of each other straight-chain or branched alkyl with 1 to 20 C atoms which is unsubstituted or substituted by one or more F atoms.

13. The polymer according to one or more of claims 1 to 12, wherein R³ and/or R⁴ are independently of each other selected from the group consisting of alkyl, alkoxy, alkylcarbonyl, alkoxycarbonyl and alkylcarbonyloxy, all of which are straight-chain or branched, are optionally fluorinated, and have from 1 to 30 C atoms, and aryl, aryloxy, heteroaryl and heteroaryloxy, all of which are optionally alkylated or alkoxylated and have 4 to 30 ring atoms.

14. A mixture or polymer blend comprising one or more polymers according to one or more of claims 1 to 13 and one or more compounds or polymers having semiconducting, charge transport, hole/electron transport, hole/electron blocking, electrically conducting, photoconducting or light emitting properties.

15. The mixture or polymer blend according to claim 14, **characterized in that** it comprises one or more polymers according to one or more of claims 1 to 13 and one or more n-type organic semiconductor compounds.

16. The mixture or polymer blend according to claim 15, **characterized in that** the n-type organic semiconductor compound is selected from the group consisting of fullerenes, substituted fullerenes and graphene.

17. The mixture or polymer blend according to claim 16, **characterized in that** the n-type organic semiconductor compound is selected from the group consisting of PCBM-C₆₀, PCBM-C₇₀, PCBM-C₆₁, PCBM-C₇₁, bis-PCBM-C₆₁, bis-PCBM-C₇₁, ICBA and graphene.

18. A formulation comprising one or more polymers, mixtures or polymer blends according to one or more of claims 1 to 17, and one or more solvents, preferably selected from organic solvents.

19. Use of a polymer, mixture, polymer blend or formulation according to one or more of claims 1 to 18 as charge transport, semiconducting, electrically conducting, photoconducting or light emitting material in an optical, electrooptical, electronic, electroluminescent or photoluminescent device, or in a component of such a device, or in an assembly comprising such a device or component.

20. A charge transport, semiconducting, electrically conducting, photoconducting or light emitting material comprising a polymer, mixture, polymer blend or formulation according to one or more of claims 1 to 18.

21. An optical, electrooptical, electronic, electroluminescent or photoluminescent device, or a component thereof, or an assembly comprising it, which comprises a charge transport, semiconducting, electrically conducting, photoconducting or light emitting material, or comprises a polymer, mixture, polymer blend or formulation, according to one or more of claims 1 to 18.

22. The optical, electrooptical, electronic, electroluminescent or photoluminescent device according to claim 21, which is selected from organic field effect transistors (OFET), organic thin film transistors (OTFT), organic light emitting diodes (OLED), organic light emitting transistors (OLET), organic photovoltaic devices (OPV), organic solar cells, laser diodes, organic plasmon-emitting diodes (OPEDs), Schottky diodes, organic photoconductors (OPCs) and organic photodetectors (OPDs).

23. The component according to claim 21, which is selected from charge injection layers, charge transport layers, interlayers, planarising layers, antistatic films, polymer electrolyte membranes (PEM), conducting substrates and conducting patterns.

24. The assembly according to claim 21, which is selected from integrated circuits (IC), radio frequency identification (RFID) tags or security markings or security devices containg them, flat panel displays or backlights thereof, electrophotographic devices, electrophotographic recording devices, organic memory devices, sensor devices, biosensors and biochips.

25. Use of a polymer, mixture, polymer blend or formulation according to one or more of claims 1 to 18 as electrode materials in batteries, or in components or devices for detecting and discriminating DNA sequences.

26. The device according to claim 21 or 22, which is an OFET, bulk heterojunction (BHJ) OPV device or inverted BHJ OPV device.

27. A monomer of formula VI
R⁷-(Ar¹)ₐ-U-(Ar²)_{c}-R⁸ VI
wherein U, Ar¹, Ar², a and c are as defined in claim 3 or 9, and R⁷ and R⁸ are selected from Cl, Br, I, O-tosylate, O-triflate, O-mesylate, O-nonaflate, -SiMe₂F, -SiMeF₂, -O-SO₂Z¹, -B(OZ²)₂, -CZ³=C(Z³)₂, -C≡CH, - C≡CSi(Z¹)₃, -ZnX⁰ and -Sn(Z⁴)₃, wherein X⁰ is halogen, preferably Cl, Br or I, Z¹⁻⁴ are selected from the group consisting of alkyl and aryl, each being optionally substituted, and two groups Z² may also together form a cyclic group.

28. A process of preparing a polymer according to one or more of claims 1 to 13, by coupling one or more monomers according to claim 27 with each other, and/or with one or more monomers selected from the following formulae
R⁷-(Ar¹)ₐ-A¹-(Ar²)_{c-}R⁸ C
R⁷-Ar¹-R⁸ D
R⁷-Ar³-R⁸ E
wherein Ar¹, Ar², Ar³ a and c are as defined in claim 3, 9 or 10, A¹ is as defined in claim 4 or 10, and R⁷ and R⁸ are as defined in claim 27, in an aryl-aryl coupling reaction.

## Patentansprüche

1. Polymer enthaltend eine oder mehrere zweiwertige Einheiten der Formel I 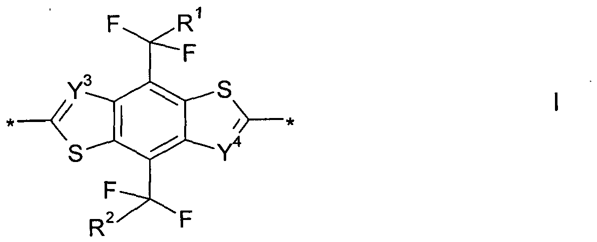 in der
Y³ N oder CR³ bedeutet,
Y⁴ N oder CR⁴ bedeutet,
R¹, R² unabhängig voneinander und bei jedem Auftreten gleich oder verschieden geradkettiges, verzweigtes oder cyclisches Alkyl mit 1 bis 30 C-Atomen, vorzugsweise 1 bis 20 C-Atomen bedeuten, in dem gegebenenfalls ein oder mehrere nicht benachbarte C-Atome durch -O-, -S-, -C(O)-, -C(O)-O-, -O-C(O)-, -CH=CH- oder -C=C- ersetzt sind und die unsubstituiert oder durch F, Cl, Br, I oder CN substituiert sind,
R³, R⁴ unabhängig voneinander und bei jedem Auftreten gleich oder verschieden H, Halogen oder eine gegebenenfalls substituierte Carbyl- oder Hydrocarbylgruppe bedeuten, in der gegebenenfalls ein oder mehrere C-Atome durch ein Heteroatom ersetzt sind.

2. Polymer nach Anspruch 1, **dadurch gekennzeichnet, dass** die Einheiten der Formel I aus der Gruppe ausgewählt sind, die aus den folgenden Unterformeln besteht 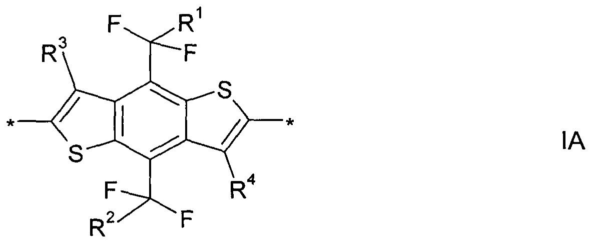 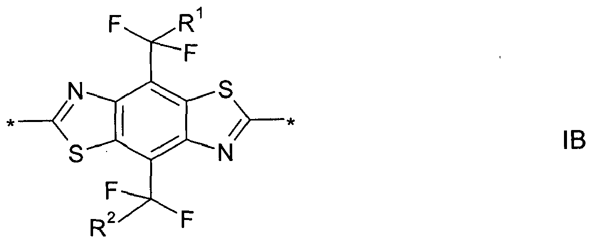 in denen R¹, R², R³ und R⁴ die in Anspruch 1 angegebenen Bedeutungen besitzen.

3. Polymer nach Anspruch 1 oder 2, **dadurch gekennzeichnet, dass** es eine oder mehrere Einheiten der Formel II
-[(Ar¹)ₐ-(U)_{b}-(Ar²)_{c}-(Ar³)_{d}]- II
enthält, in der
U eine Einheit der Formel I wie in Anspruch 1 definiert bedeutet,
Ar¹, Ar², Ar³ bei jedem Auftreten gleich oder verschieden und unabhängig voneinander Aryl oder Heteroaryl bedeuten, das von U verschieden ist, vorzugsweise 5 bis 30 Ringatome aufweist und gegebenenfalls substituiert ist, vorzugsweise durch eine oder mehrere Gruppen R¹,
R¹ bei jedem Auftreten gleich oder verschieden F, Br, Cl, -CN, -NC, -NCO, -NCS, -OCN, -SCN, -C(O)NR⁰R⁰⁰, -C(O)X⁰, -C(O)R⁰, -NH₂, -NR⁰R⁰⁰, -SH, -SR⁰, -SO₃H, -SO₂R⁰, -OH, -NO₂, -CF₃, -SF₅, gegebenenfalls substituiertes Silyl, Carbyl oder Hydrocarbyl mit 1 bis 40 C-Atomen, das gegebenenfalls substituiert ist und gegebenenfalls ein oder mehrere Heteroatome enthält, oder P-Sp- bedeutet,
R⁰ und R⁰⁰ unabhängig voneinander H oder gegebenenfalls substituiertes C₁₋₄₀-Carbyl oder -Hydrocarbyl bedeuten,
P eine polymerisierbare oder vernetzbare Gruppe bedeutet,
Sp eine Spacergruppe oder eine Einfachbindung bedeutet,
X⁰ Halogen, vorzugsweise F, Cl oder Br bedeutet,
a, b, c bei jedem Auftreten gleich oder verschieden für 0, 1 oder 2 stehen,
d bei jedem Auftreten gleich oder verschieden für 0 oder eine ganze Zahl von 1 bis 10 steht,
wobei das Polymer mindestens eine Wiederholungseinheit der Formel II enthält, in der b für mindestens 1 steht.

4. Polymer nach einem oder mehreren der Ansprüche 1 bis 3, **dadurch gekennzeichnet, dass** es zusätzlich eine oder mehrere Wiederholungseinheiten enthält, die aus der Formel III
-[(Ar¹)ₐ-(A¹)_{b}-(Ar²)_{c}-(Ar³)_{d}]- III
ausgewählt sind, in der Ar¹, Ar², Ar³, a, b, c und d wie in Anspruch 3 definiert sind und A¹ eine Aryl- oder Heteroarylgruppe bedeutet, die von U verschieden ist, und Ar¹⁻³ 5 bis 30 Ringatome aufweist, gegebenenfalls durch eine oder mehrere Gruppen R¹ wie in Anspruch 1 definiert substituiert ist und aus Aryl- oder Heteroarylgruppen mit Elektronendonoreigenschaften ausgewählt ist, wobei das Polymer mindestens eine Wiederholungseinheit der Formel III enthält, in der b für mindestens 1 steht.

5. Polymer nach einem oder mehreren der Ansprüche 1 bis 4, **dadurch gekennzeichnet, dass** es aus der Formel IV ausgewählt ist: 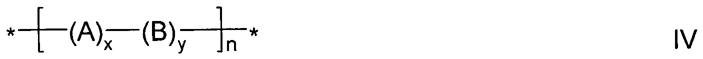 in der
A eine Einheit der Formel I, IA, IB oder II wie in Anspruch 1, 2 oder 3 definiert bedeutet,
B eine Einheit bedeutet, die von A verschieden ist und eine oder mehrere Aryl- oder Heteroarylgruppen enthält, die gegebenenfalls substituiert sind, und vorzugsweise aus der der Formel III wie in Anspruch 4 definiert ausgewählt ist,
x > 0 und ≤ 1 ist,
y ≥ 0 und < 1 ist,
x+y für 1 steht und
n für eine ganze Zahl >1 steht.

6. Polymer nach einem oder mehreren der Ansprüche 1 bis 5, **dadurch gekennzeichnet, dass** es aus den folgenden Formeln ausgewählt ist
*-[(Ar¹-U-Ar²)ₓ-(Ar³)_{y}]ₙ-* IVa
*-[(Ar¹-U-Ar²)ₓ-(Ar³-Ar³)_{y}]ₙ-* IVb
*-[(Ar¹-U-Ar²)ₓ-(Ar³-Ar³-Ar³)_{y}]ₙ-* IVc
*-[(Ar¹)ₐ-(U)_{b}-(Ar²)_{c}-(Ar³)_{d}]ₙ-* IVd
*-([(Ar¹)ₐ-(U)_{b}-(Ar²)_{c}-(Ar³)_{d}]ₓ-[(Ar¹)ₐ-(A¹)_{b}-(Ar²)_{c}-(Ar³)_{d}]_{y})ₙ-* IVe
in denen U, Ar¹ Ar², Ar³, a, b, c und d bei jedem Auftreten gleich oder verschieden eine der in Anspruch 3 angegebenen Bedeutungen besitzen, A¹ bei jedem Auftreten gleich oder verschieden eine der in Anspruch 4 angegebenen Bedeutungen besitzt und x, y und n wie in Anspruch 5 definiert sind, wobei es sich bei diesen Polymeren um alternierende oder statistische Copolymere handeln kann und wobei in Formel IVd und IVe in mindestens einer der Wiederholungseinheiten [(Ar¹)ₐ-(U)_{b}-(Ar²)_{c}-(Ar³)_{d}] und in mindestens einer der Wiederholungseinheiten [(Ar¹)ₐ-(D)_{b}-(Ar²)_{c}-(Ar³)_{d}] b für mindestens 1 steht.

7. Polymer nach einem oder mehreren der Ansprüche 1 bis 6, **dadurch gekennzeichnet, dass** es aus der Formel V
R⁵-Kette-R⁶ V
ausgewählt ist, in der "Kette" eine Polymerkette der Formel IV oder der Formeln IVa bis IVf wie in Anspruch 4 oder 5 definiert bedeutet und R⁵ und R⁶ unabhängig voneinander F, Br, Cl, H, -CH₂C, -CHO, -CH=CH₂, -SiR'R"R"', -SnR'R"R"', -BR'R", -B(OR')(OR"), -B(OH)₂, oder P-Sp- bedeuten, in denen P und Sp wie in Anspruch 3 definiert sind, R', R" und R'" unabhängig voneinander eine der in Anspruch 3 angegebenen Bedeutungen von R⁰ besitzen und zwei von R', R" und R"' zusammen mit dem Heteroatom, an das sie gebunden sind, auch einen Ring bilden können.

8. Polymer nach einem oder mehreren der Ansprüche 1 bis 7, **dadurch gekennzeichnet, dass** R¹ und R² unabhängig voneinander geradkettiges oder verzweigtes Alkyl mit 1 bis 20 C-Atomen bedeuten, das unsubstituiert oder durch ein oder mehrere F-Atome substituiert ist.

9. Polymer nach einem oder mehreren der Ansprüche 3 bis 8, bei dem ein oder mehrere von Ar¹, Ar² und Ar³ Aryl oder Heteroaryl bedeuten, das aus der Gruppe ausgewählt ist, die aus den folgenden Formeln besteht 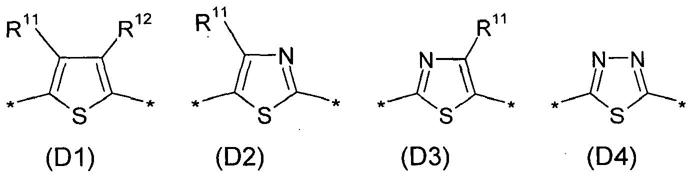 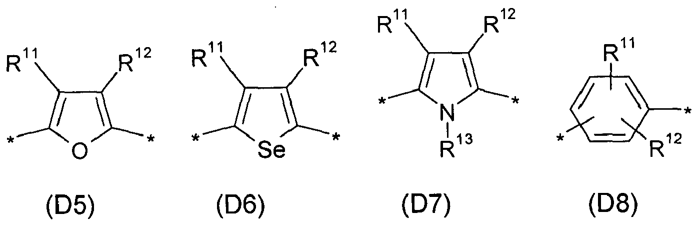 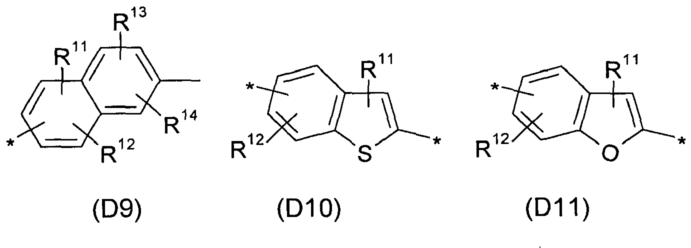 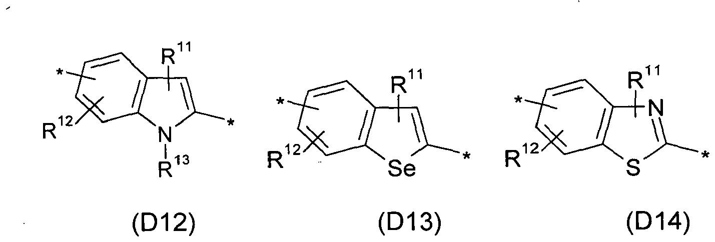 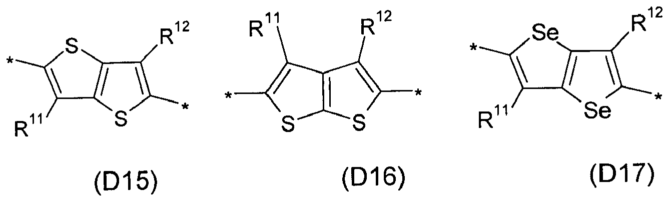 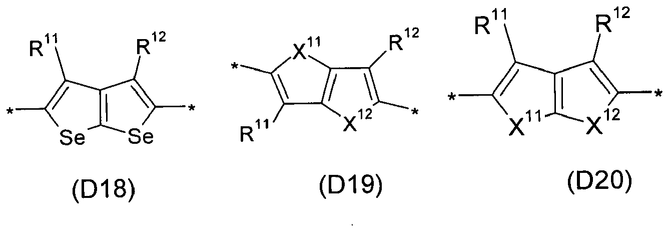 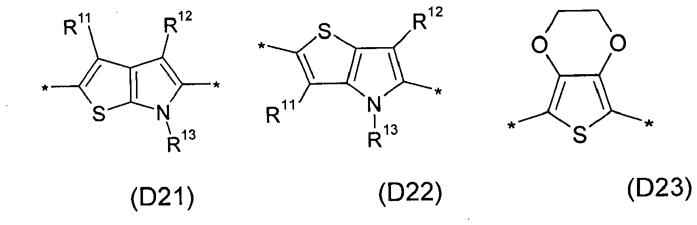 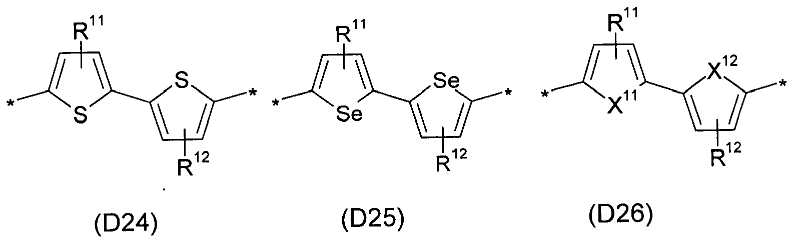 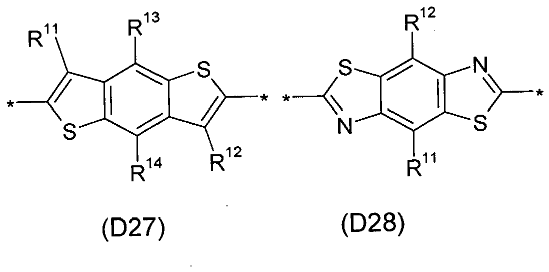 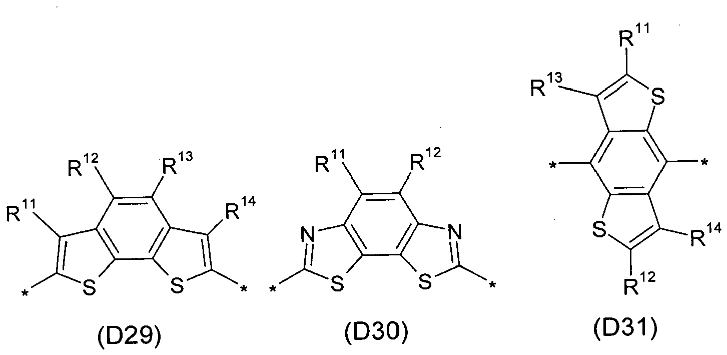 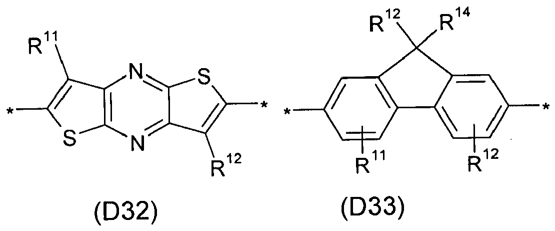 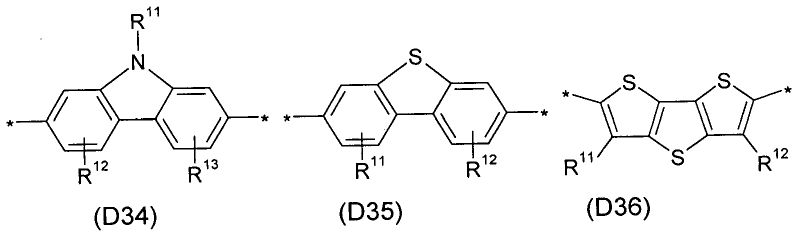 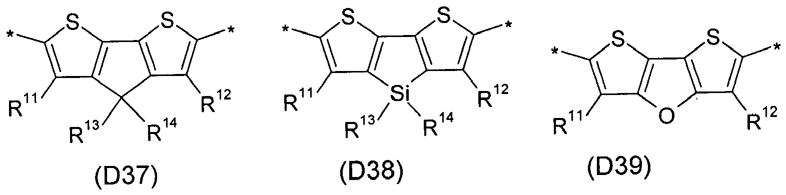 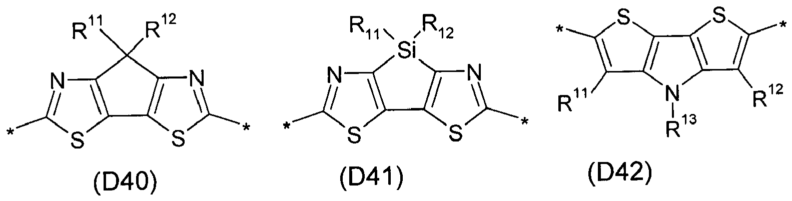 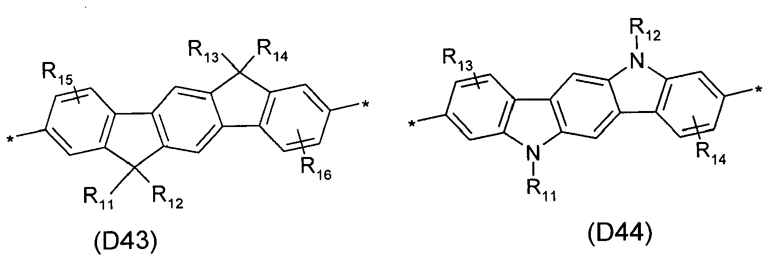 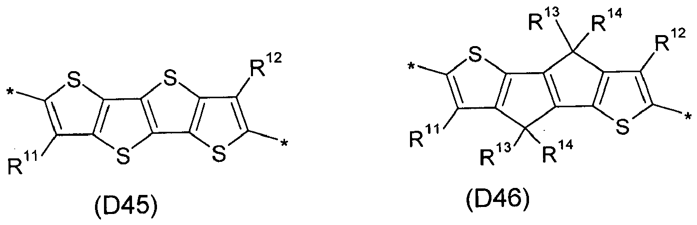 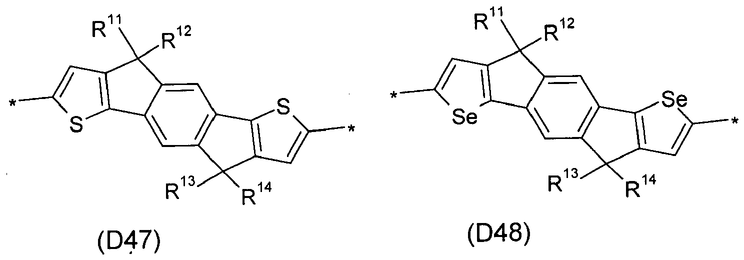 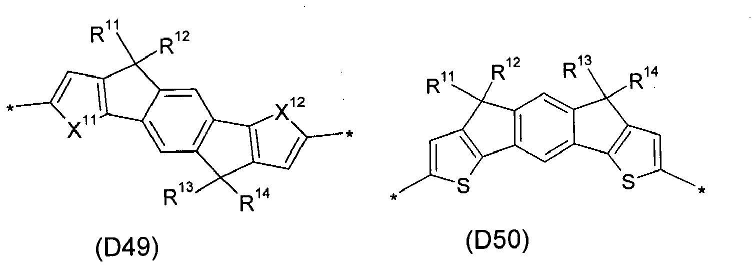 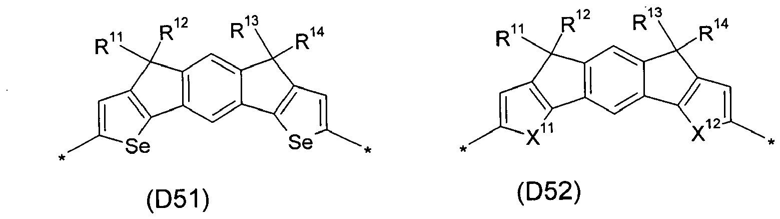 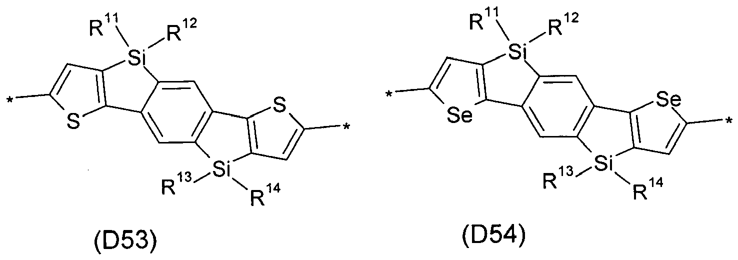 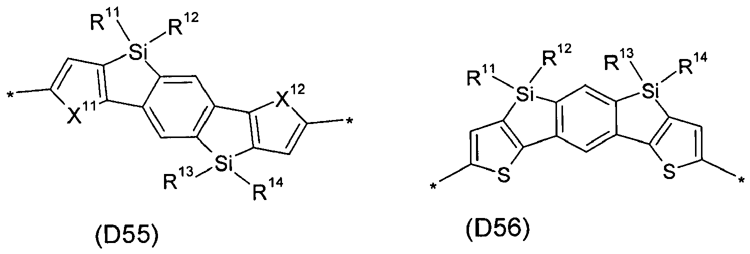 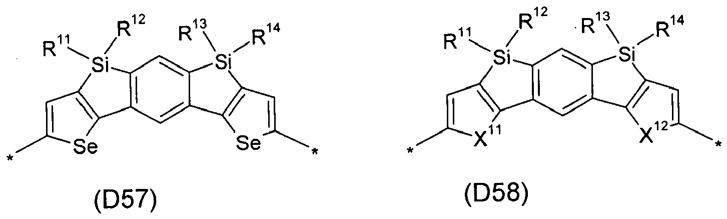 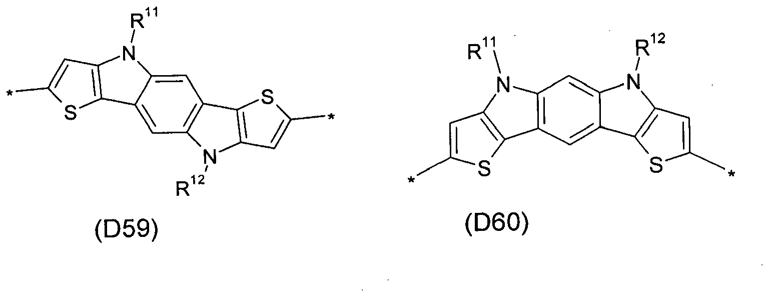 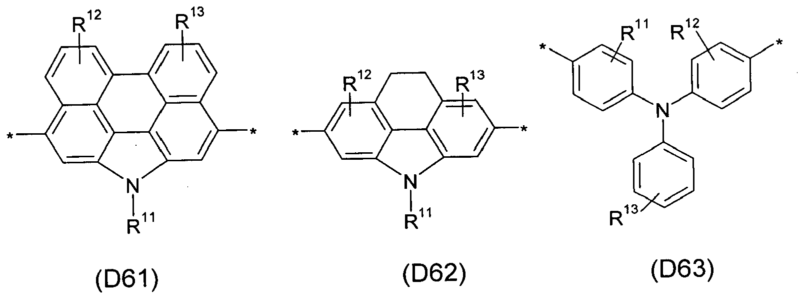 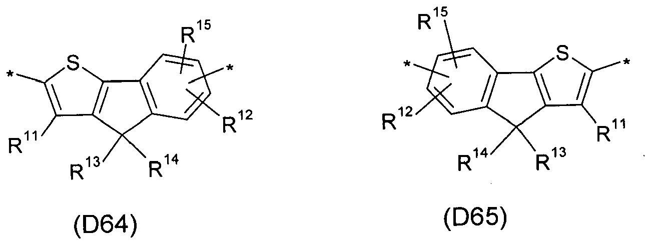 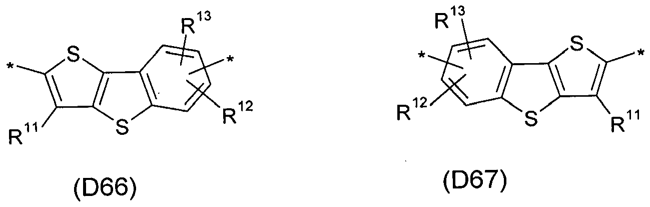 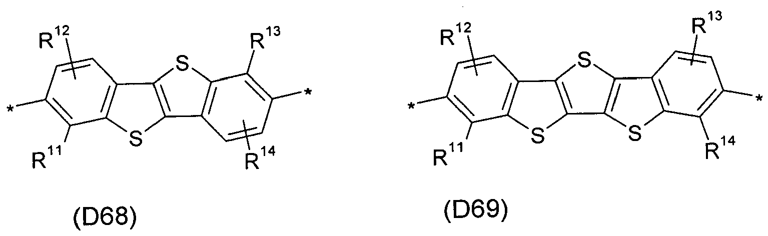 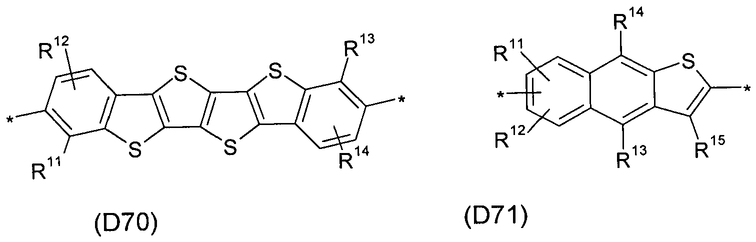 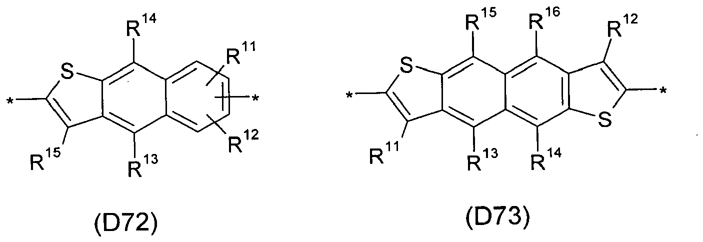 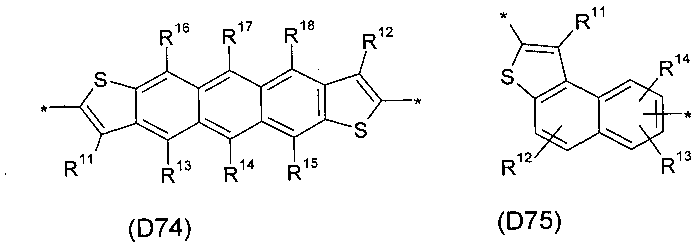 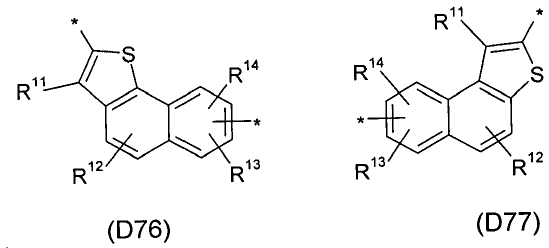 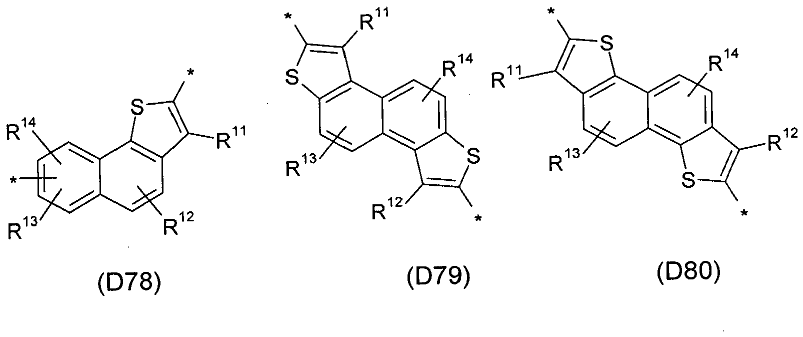 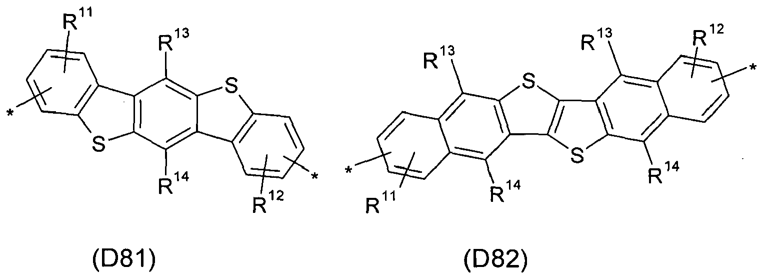 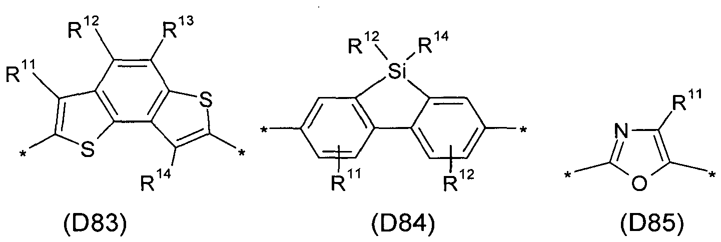 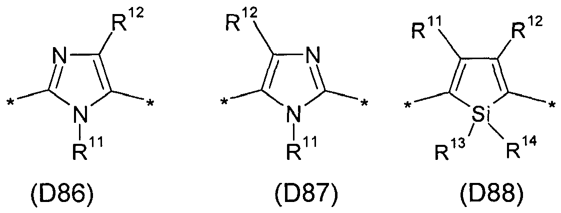 in denen eines von X¹¹ und X¹² S und das andere Se bedeutet und R¹¹, R¹² , R¹³, R¹⁴, R¹⁵, R¹⁶, R¹⁷ und R¹⁸ unabhängig voneinander H bedeuten oder eine der Bedeutungen von R¹ wie in Anspruch 1 definiert besitzen.

10. Polymer nach einem oder mehreren der Ansprüche 3 bis 9, bei dem eines oder mehrere von Ar³ und A¹ Aryl oder Heteroaryl bedeuten, das aus der Gruppe ausgewählt ist, die aus den folgenden Formeln besteht 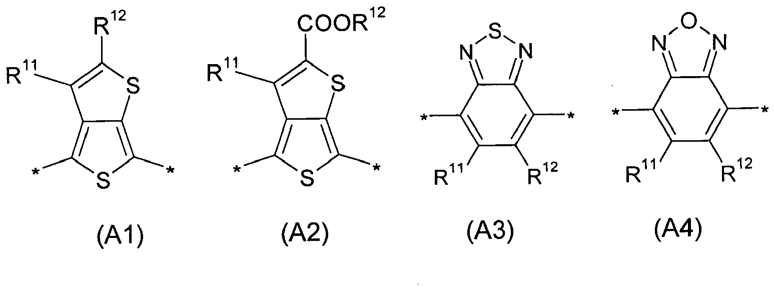 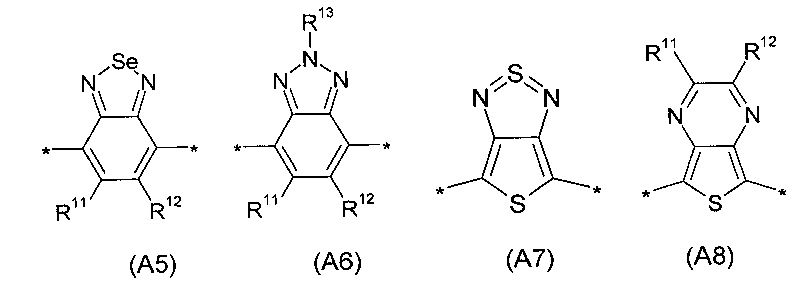 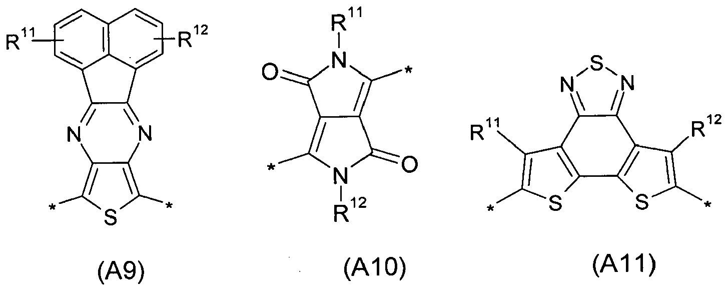 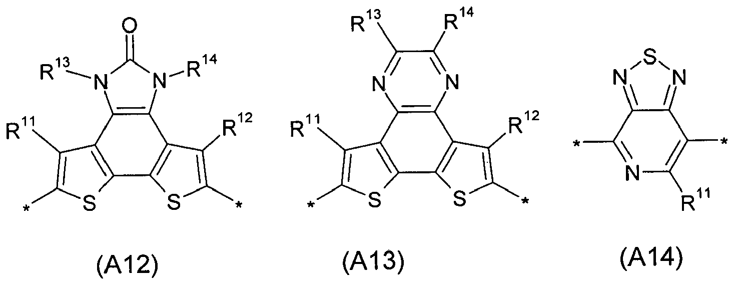 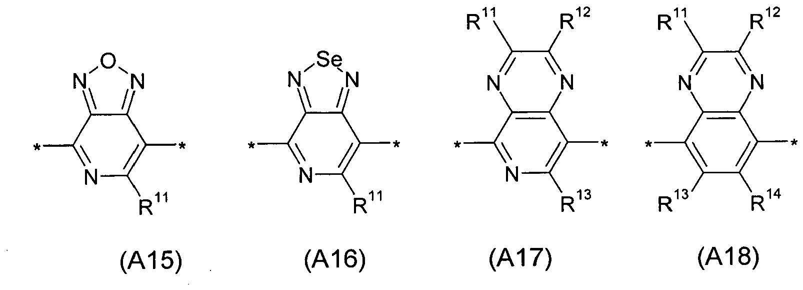 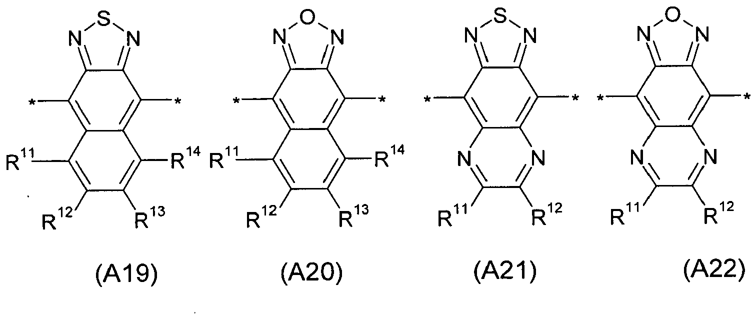 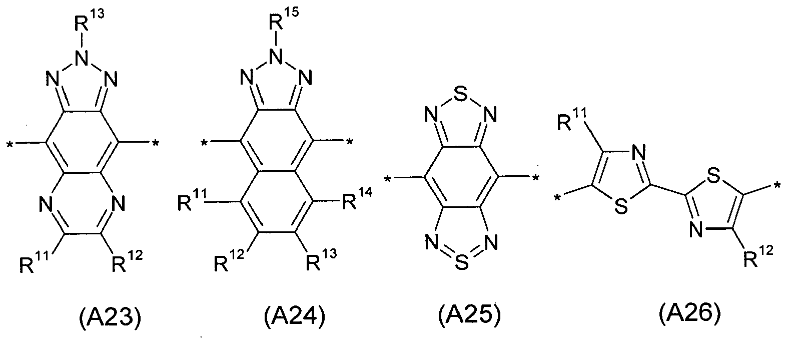 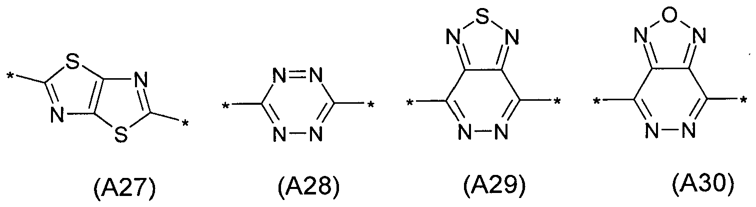 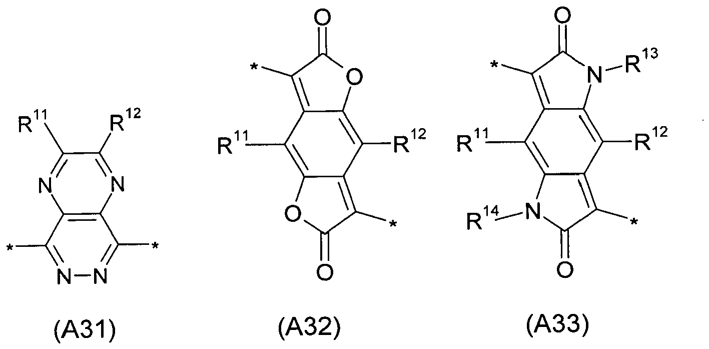 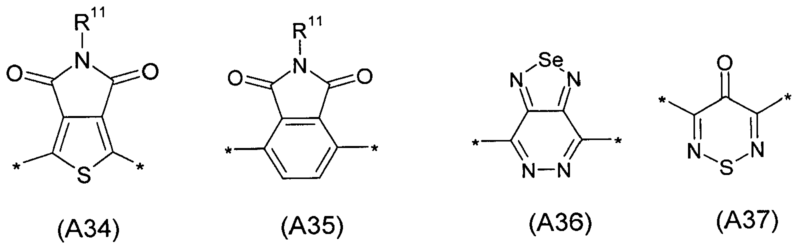 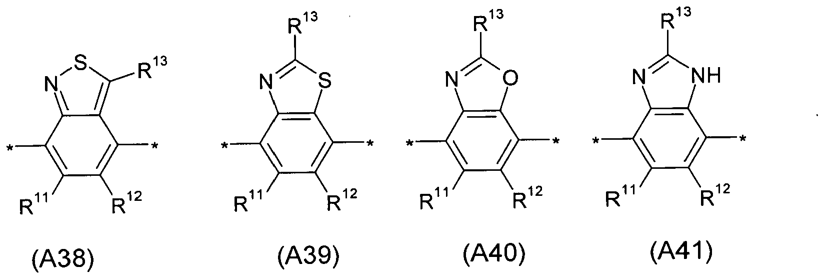 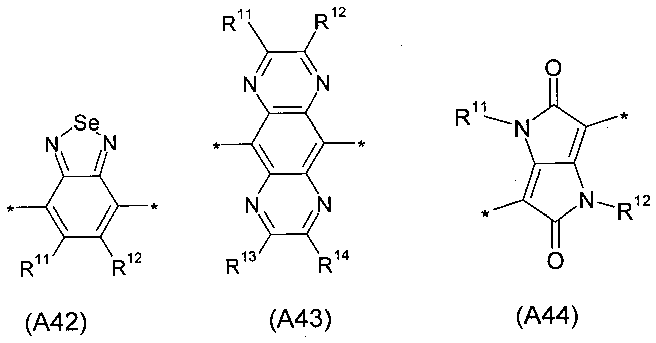 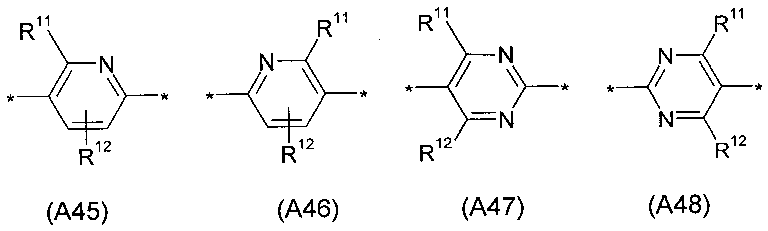 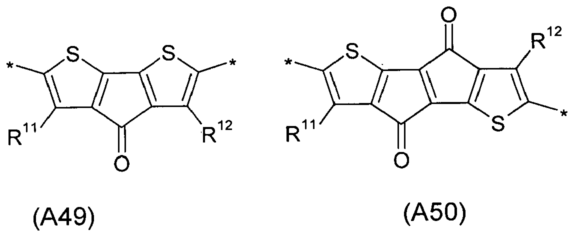 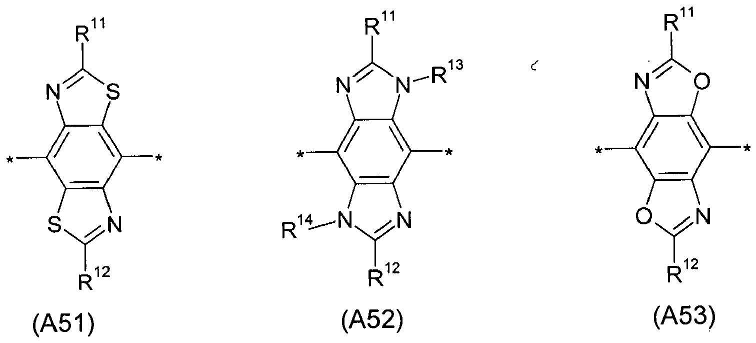 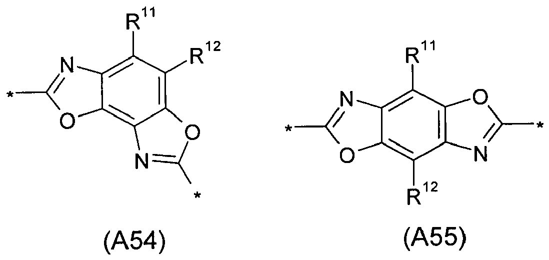 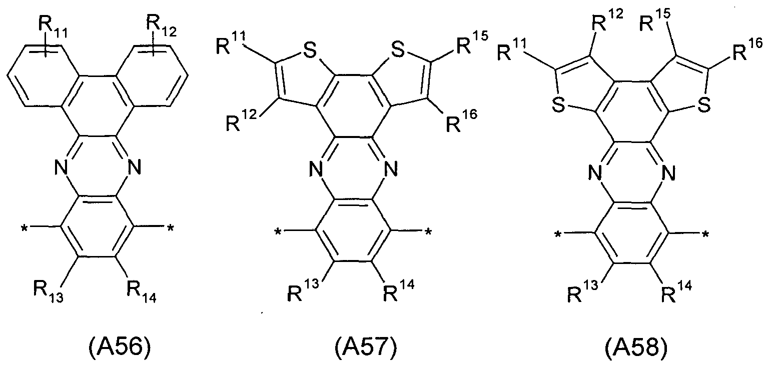 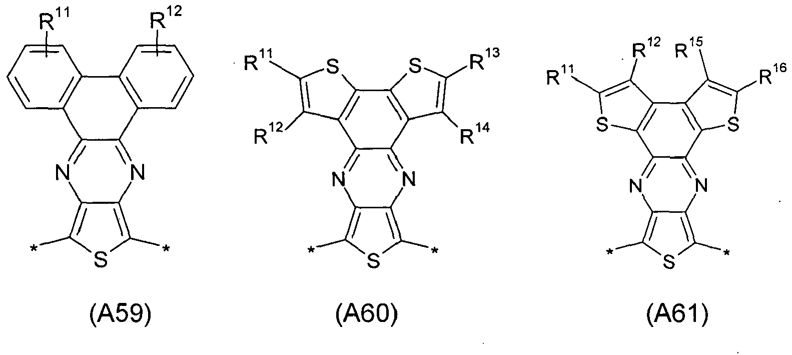 in denen eines von X¹¹ und X¹² S und das andere Se bedeutet und R¹¹, R¹², R¹³, R¹⁴ und R¹⁵ unabhängig voneinander H bedeuten oder eine der Bedeutungen von R¹ wie in Anspruch 1 definiert besitzen.

11. Polymer nach einem oder mehreren der Ansprüche 1 bis 10, das aus den folgenden Formeln ausgewählt ist 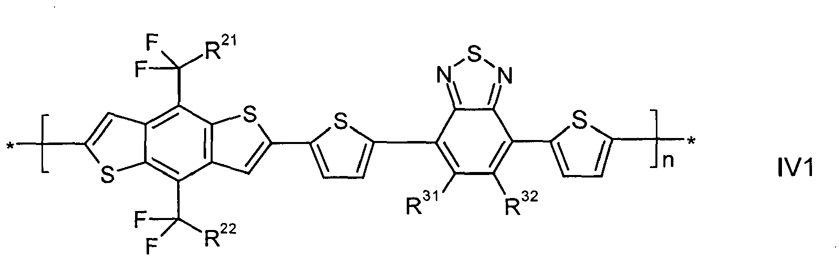 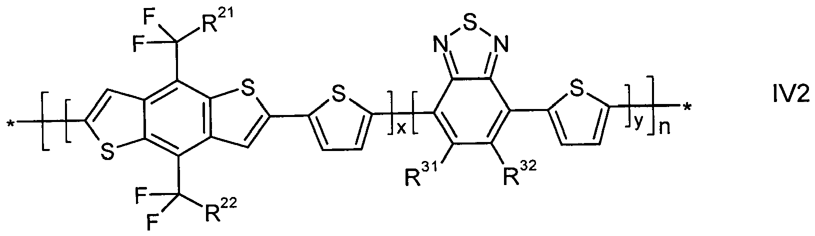 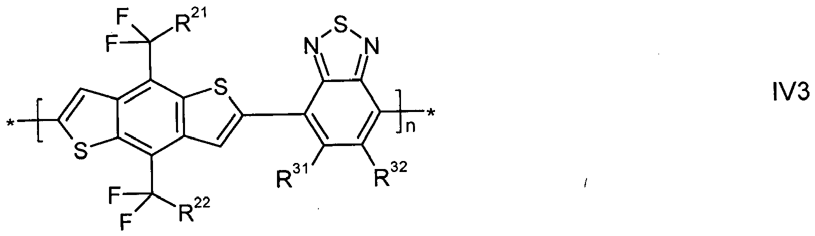 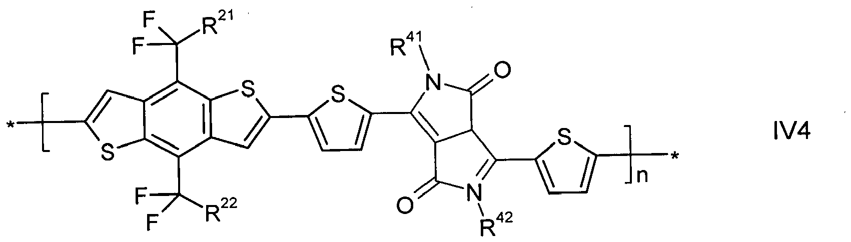 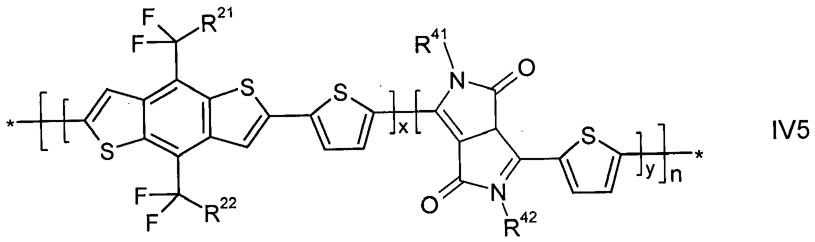 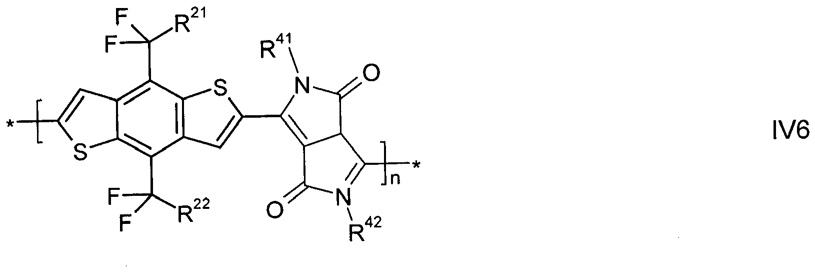 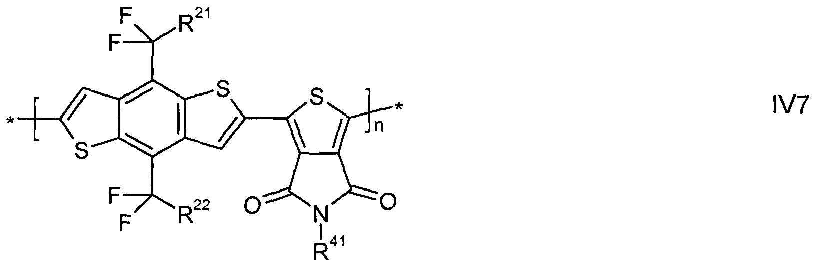 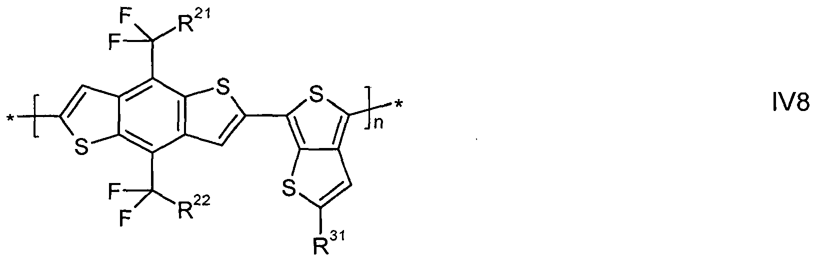 in denen n, x und y wie in Anspruch 5 definiert sind, R²¹ und R²² eine der in Anspruch 1 für R¹ angegebenen Bedeutungen besitzen und R³¹, R³², R⁴¹ und R⁴² eine der in Anspruch 1 für R³ angegebenen Bedeutungen besitzen und in denen die Thiophenringe gegebenenfalls durch eine oder zwei Gruppen R³¹ substituiert sind.

12. Polymer nach einem oder mehreren der Ansprüche 1 bis 11, bei dem R¹ und/oder R² unabhängig voneinander geradkettiges oder verzweigtes Alkyl mit 1 bis 20 C-Atomen bedeuten, das unsubstituiert oder durch ein oder mehrere F-Atome substituiert ist.

13. Polymer nach einem oder mehreren der Ansprüche 1 bis 12, bei dem R³ und/oder R⁴ unabhängig voneinander aus der Gruppe bestehend aus Alkyl, Alkoxy, Alkylcarbonyl, Alkoxycarbonyl und Alkylcarbonyloxy, die jeweils geradkettig oder verzweigt sind, gegebenenfalls fluoriert sind und 1 bis 30 C-Atome aufweisen, und Aryl, Aryloxy, Heteroaryl und Heteroaryloxy, die jeweils gegebenenfalls alkyliert oder alkoxyliert sind und 4 bis 30 Ringatome aufweisen, ausgewählt sind.

14. Mischung oder Polymerblend enthaltend ein oder mehrere Polymere nach einem oder mehreren der Ansprüche 1 bis 13 und ein(e) oder mehrere Verbindungen oder Polymere mit Halbleiter-, Ladungstransport-, Loch/Elektronentransport-, loch/elektronenblockierenden, elektrisch leitenden, photoleitenden oder lichtemittierenden Eigenschaften.

15. Mischung oder Polymerblend nach Anspruch 14, **dadurch gekennzeichnet, dass** sie/es ein oder mehrere Polymere nach einem oder mehreren der Ansprüche 1 bis 13 und eine oder mehrere organische Halbleiterverbindungen des n-Typs enthält.

16. Mischung oder Polymerblend nach Anspruch 15, **dadurch gekennzeichnet, dass** die organische Halbleiterverbindung des n-Typs aus der Gruppe bestehend aus Fullerenen, substituierten Fullerenen und Graphen ausgewählt ist.

17. Mischung oder Polymerblend nach Anspruch 16, **dadurch gekennzeichnet, dass** die organische Halbleiterverbindung des n-Typs aus der Gruppe bestehend aus PCBM-C₆₀, PCBM-C₇₀, PCBM-C₆₁, PCBM-C₇₁, bis-PCBM-C₆₁, bis-PCBM-C₇₁, ICBA und Graphen ausgewählt ist.

18. Formulierung enthaltend ein(e) oder mehrere Polymere, Mischungen oder Polymerblends nach einem oder mehreren der Ansprüche 1 bis 17 und ein oder mehrere Lösungsmittel, vorzugsweise ausgewählt aus organischen Lösungsmitteln.

19. Verwendung eines Polymers, einer Mischung, eines Polymerblends oder einer Formulierung nach einem oder mehreren der Ansprüche 1 bis 18 als Ladungstransport-, Halbleiter-, elektrisch leitendes, photoleitendes oder lichtemittierendes Material in einer optischen, elektrooptischen, elektronischen, Elektrolumineszenz- oder Photolumineszenz-Vorrichtung oder in einer Komponente einer solchen Vorrichtung oder in einer eine derartige Vorrichtung oder Komponente enthaltenden Baugruppe.

20. Ladungstransport-, Halbleiter-, elektrisch leitendes, photoleitendes oder lichtemittierendes Material enthaltend ein Polymer, eine Mischung, ein Polymerblend oder eine Formulierung nach einem oder mehreren der Ansprüche 1 bis 18.

21. Optische, elektrooptische, elektronische, Elektrolumineszenz- oder Photolumineszenz-Vorrichtung oder Komponente davon oder eine sie enthaltende Baugruppe, die ein Ladungstransport-, Halbleiter-, elektrisch leitendes, photoleitendes oder lichtemittierendes Material enthält oder ein Polymer, eine Mischung, ein Polymerblend oder eine Formulierung enthält, nach einem oder mehreren der Ansprüche 1 bis 18.

22. Optische, elektrooptische, elektronische, Elektrolumineszenz- oder Photolumineszenz-Vorrichtung nach Anspruch 21, die aus organischen Feldeffekttransistoren (organic field effect transistors - OFETs), organischen Dünnschichttransistoren (organic thin film transistors - OTFTs), organischen Leuchtdioden (organic light emitting diodes - OLEDs), organischen lichtemittierenden Transistoren (organic light emitting transistors - OLETs), organischen Photovoltaikvorrichtungen (OPVs), organischen Solarzellen, Laserdioden, organischen Plasmon-emittierenden Dioden (OPEDs), Schottky-Dioden, organischen Photoleitern (organic photoconductors - OPCs) und organischen Photodetektoren (organic photodetectors - OPDs) ausgewählt ist.

23. Komponente nach Anspruch 21, die aus Ladungsinjektionsschichten, Ladungstransportschichten, Zwischenschichten, Planarisierungsschichten, Antistatikfolien, Polymerelektrolytmembranen (PEMs), leitenden Substraten und leitenden Mustern ausgewählt ist.

24. Baugruppe nach Anspruch 21, die aus integrierten Schaltungen (integrated circuits - ICs), RFID-Tags (RFID - radio frequency identification) oder diese enthaltenden Sicherheitsmarkierungen oder Sicherheitsvorrichtungen, Flachbildschirmen oder deren Hintergrundbeleuchtungen, elektrophotographischen Vorrichtungen, elektropho-tographischen Aufzeichnungsvorrichtungen, organischen Speichervorrichtungen, Sensorvorrichtungen, Biosensoren und Biochips ausgewählt ist.

25. Verwendung eines Polymers, einer Mischung, eines Polymerblends oder einer Formulierung nach einem oder mehreren der Ansprüche 1 bis 18 als Elektrodenmaterialien in Batterien oder in Komponenten oder Vorrichtungen für den Nachweis und die Unterscheidung von DNA-Sequenzen.

26. Vorrichtung nach Anspruch 21 oder 22, bei der es sich um einen OFET, eine OPV-Vorrichtungen mit Volumen-Heteroübergang (bulk heterojunction - BHJ) oder eine invertierte BHJ-OPV-Vorrichtung handelt.

27. Monomer der Formel VI
R⁷-(Ar¹)ₐ-U-(Ar²)_{c}-R⁸ VI
in der U, Ar¹, Ar², a und c wie in Anspruch 3 oder 9 definiert sind und R⁷ und R⁸ aus Cl, Br, I, O-Tosylat, O-Triflat, O-Mesylat, O-Nonaflat, -SiMe₂F, -SiMeF₂, -O-SO₂Z¹, -B(OZ²)2, -CZ³=C(Z³)₂, -C≡CH, -C≡CSi(Z¹)₃, -ZnX⁰ und -Sn(Z⁴)₃ ausgewählt sind, in denen X⁰ Halogen, vorzugsweise Cl, Br oder I bedeutet, Z¹⁻⁴ aus der Gruppe ausgewählt sind, die aus jeweils gegebenenfalls substituiertem Alkyl und Aryl besteht, und zwei Gruppen Z² zusammen auch eine cyclische Gruppe bilden können.

28. Verfahren zur Herstellung eines Polymers nach einem oder mehreren der Ansprüche 1 bis 13, durch Kuppeln eines oder mehrerer Monomere nach Anspruch 27 miteinander und/oder mit einem oder mehreren Monomeren, die aus den folgenden Formeln ausgewählt sind
R⁷-(Ar¹)ₐ-A¹-(Ar²)_{c}-R⁸ C
R⁷-Ar¹-R⁸ D
R⁷-Ar³-R⁸ E
in denen Ar¹, Ar², Ar³, a und c wie in Anspruch 3, 9 oder 10 definiert sind, A¹ wie in Anspruch 4 oder 10 definiert ist und R⁷ und R⁸ wie in Anspruch 27 definiert sind, in einer Aryl-Aryl-Kupplungsreaktion.

## Revendications

1. Polymère comprenant une ou plusieurs unité(s) divalente(s) de la formule I : 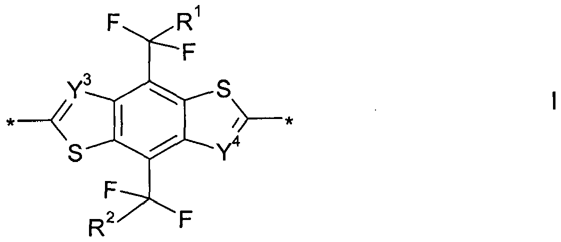 dans laquelle :
Y³ est N ou CR³,
Y⁴ est N ou CR⁴,
R¹, R² représentent, indépendamment l'un de l'autre et pour chaque occurrence de manière identique ou différente, alkyle en chaîne droite, ramifié ou cyclique avec de 1 à 30 atomes de C, de façon préférable de 1 à 20 atomes de C, où un ou plusieurs atomes de C non adjacents sont en option remplacés par -O-, -S-, -C(O)-, -C(O)-O-, -O-C(O)-, -CH=CH- ou -C≡C-et lesquels sont non substitués ou substitués par F, Cl, Br, I ou CN,
R³, R⁴ représentent, indépendamment l'un de l'autre et pour chaque occurrence de manière identique ou différente, H, halogène, ou un groupe carbyle ou hydrocarbyle en option substitué, où un ou plusieurs atome(s) de C est/sont en option remplacé(s) par un hétéroatome.

2. Polymère selon la revendication 1, **caractérisé en ce que** les unités de la formule I sont choisies parmi le groupe constitué par les sous-formules qui suivent : 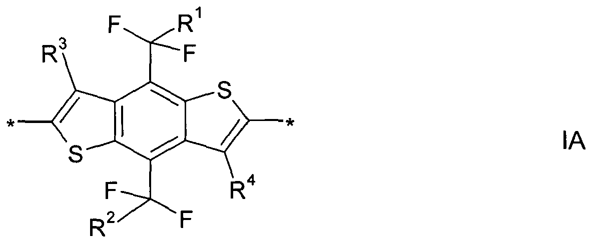 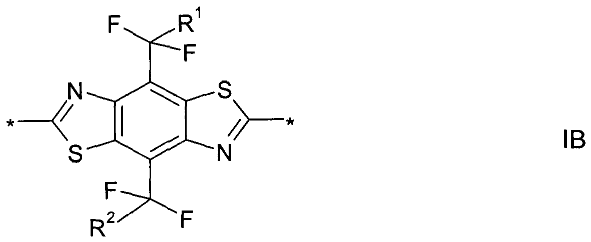 dans lesquelles R¹, R², R³ et R⁴ présentent les significations données selon la revendication 1.

3. Polymère selon la revendication 1 ou 2, **caractérisé en ce qu'**il comprend une ou plusieurs unité(s) de la formule II :
-[(Ar¹)ₐ-(U)_{b}-(Ar²)_{c}-(Ar³)_{d}]- II
dans laquelle :
U est une unité de la formule I comme défini selon la revendication 1,
Ar¹, Ar², Ar³ sont, pour chaque occurrence de manière identique ou différente et indépendamment les uns des autres, aryle ou hétéroaryle qui est différent de U, qui, de façon préférable, comporte de 5 à 30 atomes de cycle et qui est en option substitué, de façon préférable par un ou plusieurs groupe(s) R¹,
R¹ est, pour chaque occurrence de manière identique ou différente, F, Br, Cl, -CN, -NC, -NCO, -NCS, -OCN, -SCN, -C(O)NR⁰R⁰⁰, -C(O)X⁰, -C(O)R⁰, -NH₂, -NR⁰R⁰⁰, -SH, -SR⁰, -SO₃H -SO₂R⁰, -OH, -NO₂, -CF₃, -SF₅, silyle, carbyle ou hydrocarbyle en option substitué par de 1 à 40 atomes de C qui est en option substitué et, en option, comprend un ou plusieurs hétéroatome(s), ou P-Sp-,
R⁰ et R⁰⁰ sont, indépendamment l'un de l'autre, H ou C₁₋₄₀ carbyle ou hydrocarbyle en option substitué,
P est un groupe polymérisable ou réticulable,
Sp est un groupe d'espaceur ou une liaison simple,
X⁰ est halogène, de façon préférable F, Cl ou Br,
a, b, c sont, pour chaque occurrence de manière identique ou différente, 0, 1 ou 2,
d est, pour chaque occurrence de manière identique ou différente, 0 ou un entier de 1 à 10,
où le polymère comprend au moins une unité de répétition de la formule II dans laquelle b est au moins 1.

4. Polymère selon une ou plusieurs des revendications 1 à 3, **caractérisé en ce qu'**il comprend de façon additionnelle une ou plusieurs unité(s) de répétition choisie(s) parmi la formule III :
-[(Ar¹)ₐ-(A¹)_{b}-(Ar²)_{c}-(Ar³)_{d}]- III
dans laquelle Ar¹, Ar², Ar³, a, b, c et d sont comme défini selon la revendication 3, et A¹ est un groupe aryle ou hétéroaryle qui est différent de U et de Ar¹⁻³, comporte de 5 à 30 atomes de cycle, est en option substitué par un ou plusieurs groupe(s) R¹ comme défini selon la revendication 1, et est choisi parmi des groupes aryle ou hétéroaryle présentant des propriétés de donneur d'électrons, où le polymère comprend au moins une unité de répétition de la formule III dans laquelle b est au moins 1.

5. Polymère selon une ou plusieurs des revendications 1 à 4, **caractérisé en ce qu'**il est choisi parmi la formule IV : 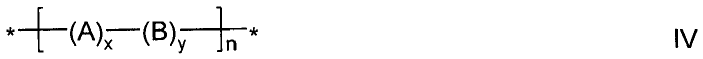 dans laquelle :
A est une unité de la formule I, IA, IB ou II comme défini selon la revendication 1, 2 ou 3,
B est une unité qui est différente de A et comprend un ou plusieurs groupe(s) aryle ou hétéroaryle qui est/sont en option substitué(s), et est de façon préférable choisi parmi la formule III comme défini selon la revendication 4,
x est > 0 et ≤ 1,
y est ≥ 0 et < 1,
x + y est 1, et
n est un entier >1.

6. Polymère selon une ou plusieurs des revendications 1 à 5, **caractérisé en ce qu'**il est choisi parmi les formules qui suivent :
*-[(Ar¹-U-Ar²)ₓ-(Ar³)_{y}]ₙ-* IVa
*-[(Ar¹-U-Ar²)ₓ-(Ar³-Ar³)_{y}]ₙ-* IVb
*-[(Ar¹-U-Ar²)ₓ-(Ar³-Ar³-Ar³)_{y}]ₙ-* IVc
*-[(Ar¹)ₐ-(U)_{b}-(Ar²)_{c}-(Ar³)_{d}]ₙ-* IVd
*-([(Ar¹)ₐ-(U)_{b}-(Ar²)_{c}-(Ar³)_{d}]ₓ-[(Ar¹)ₐ-(A¹)_{b}-(Ar²)_{c}-(Ar³)_{d}]_{y})ₙ-* IVe
dans lesquelles U, Ar¹, Ar², Ar³, a, b, c et d présentent, pour chaque occurrence de manière identique ou de façon différente, l'une des significations données selon la revendication 3, A¹ présente, pour chaque occurrence de manière identique ou différente, l'une des significations données selon la revendication 4, et x, y et n sont comme défini selon la revendication 5, où ces polymères peuvent être des copolymères alternés ou aléatoires, et dans lesquelles, selon les formules IVd et IVe, dans au moins l'une des unités de répétition [(Ar¹)ₐ-(U)_{b}-(Ar²)_{c}-(Ar³)_{d}] et dans au moins l'une des unités de répétition [(Ar¹)ₐ-(D)_{b}-(Ar²)_{c}-(Ar³)_{d}], b est au moins 1.

7. Polymère selon une ou plusieurs des revendications 1 à 6, **caractérisé en ce qu'**il est choisi parmi la formule V :
R⁵-chain-R⁶ V
dans laquelle "chain" est une chaîne de polymères de la formule IV ou des formules IVa à IVf comme défini selon la revendication 4 ou 5, et R⁵ et R⁶ représentent, indépendamment l'un de l'autre, F, Br, Cl, H, -CH₂Cl, -CHO, -CH=CH₂, -SiR'R"R"', -SnR'R"R"', -BR'R", -B(OR')(OR"), -B(OH)₂, ou P-Sp-, où P et Sp sont comme défini selon la revendication 3, R', R" et R'" présentent, indépendamment les uns des autres, l'une des significations de R⁰ données selon la revendication 3, et deux de R', R" et R'" peuvent également former un cycle en association avec l'hétéroatome auquel ils sont liés.

8. Polymère selon une ou plusieurs des revendications 1 à 7, **caractérisé en ce que** R¹ et R² représentent, indépendamment l'un de l'autre, alkyle en chaîne droite ou ramifié avec de 1 à 20 atome(s) de C, lequel est non substitué ou substitué par un ou plusieurs atome(s) de F.

9. Polymère selon une ou plusieurs des revendications 3 à 8, dans lequel un ou plusieurs élément(s) pris parmi Ar¹, Ar² et Ar³ représente(nt) aryle ou hétéroaryle choisi parmi le groupe constitué par les formules qui suivent : 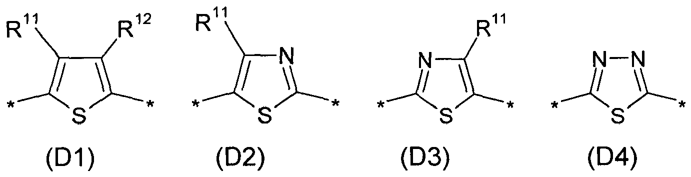 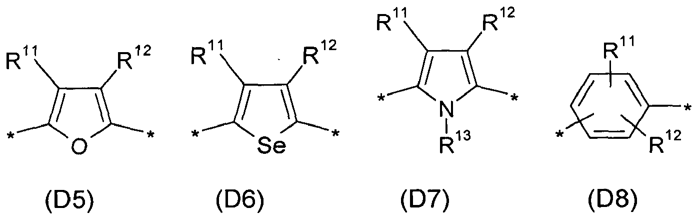 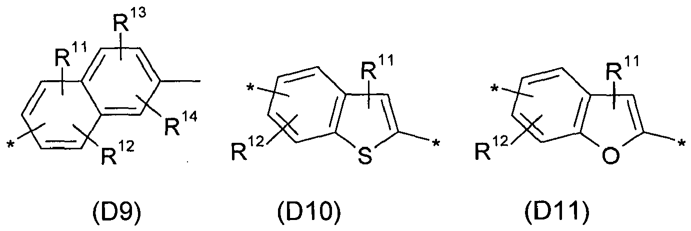 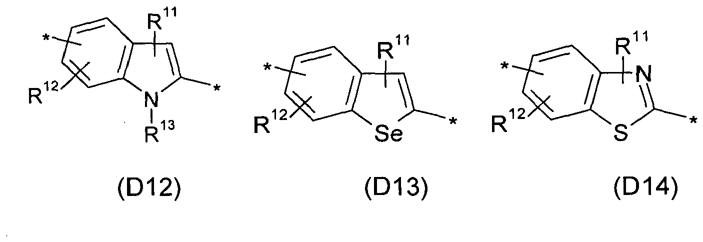 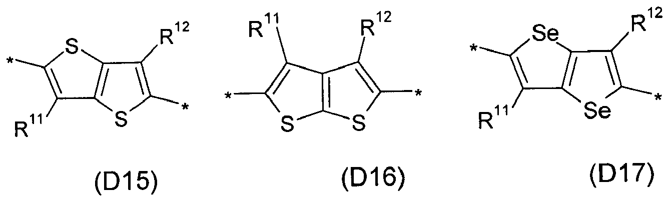 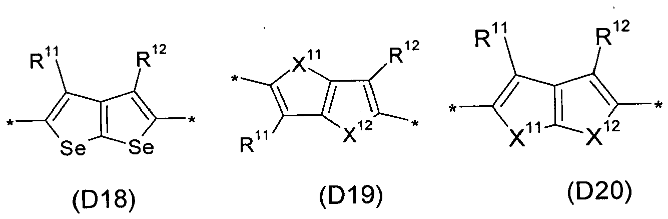 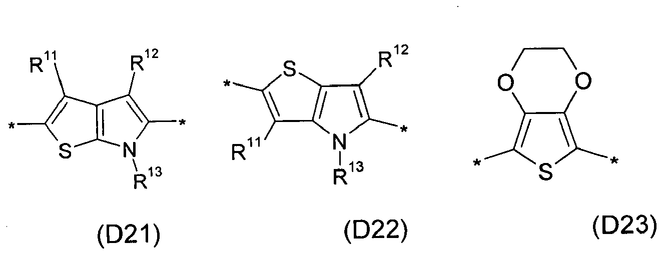 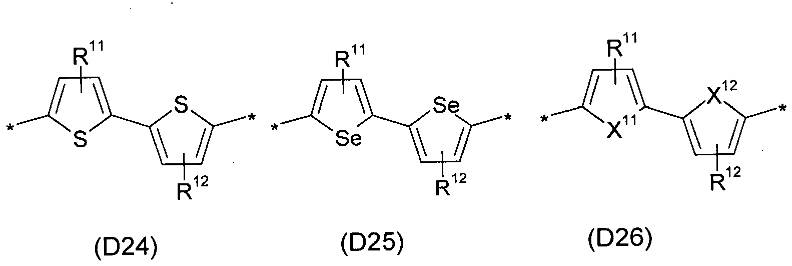 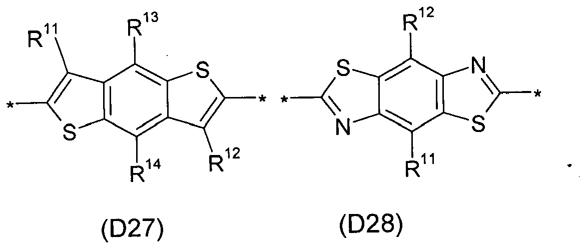 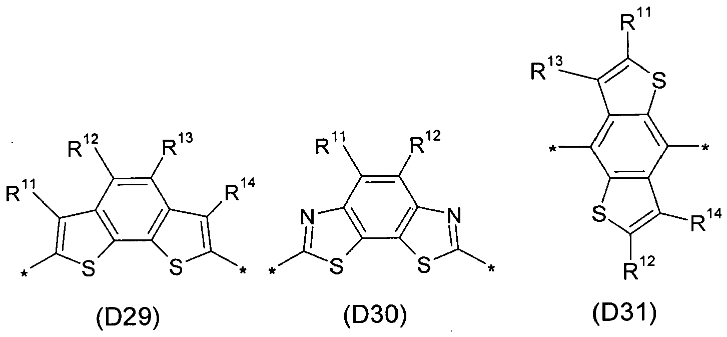 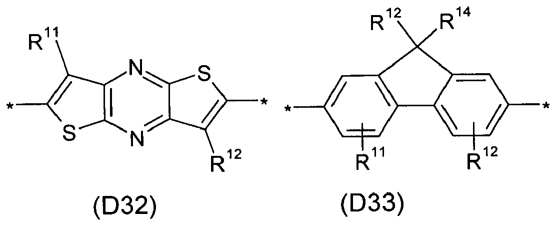 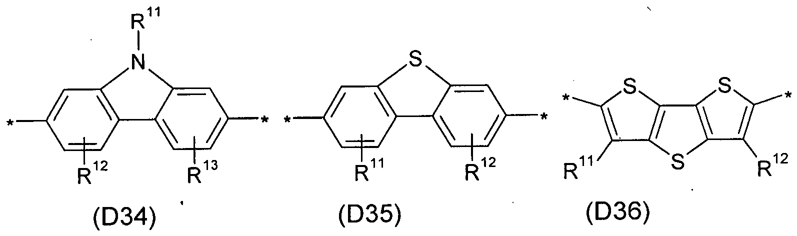 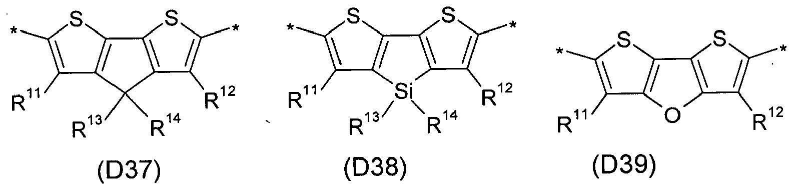 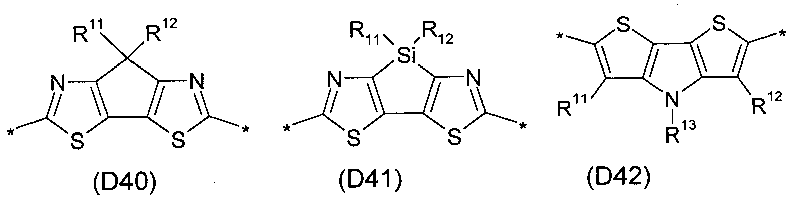 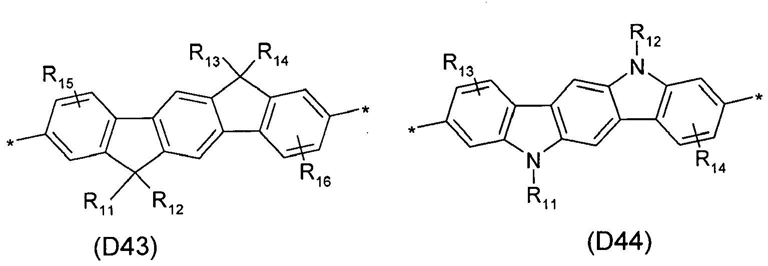 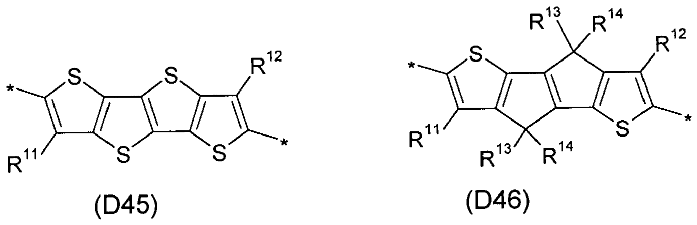 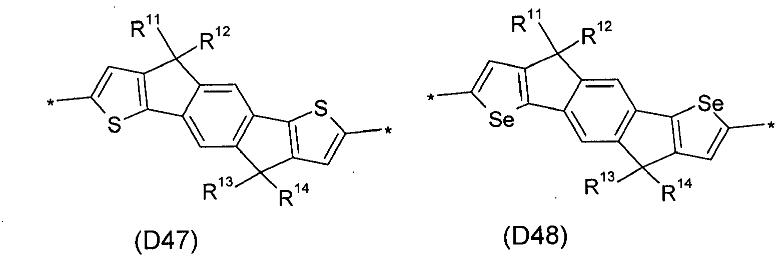 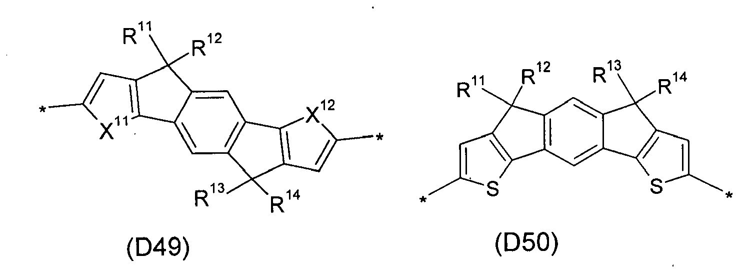 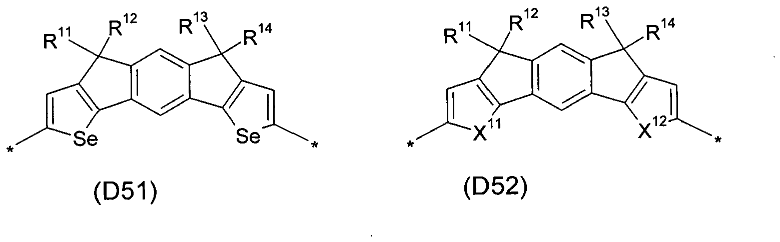 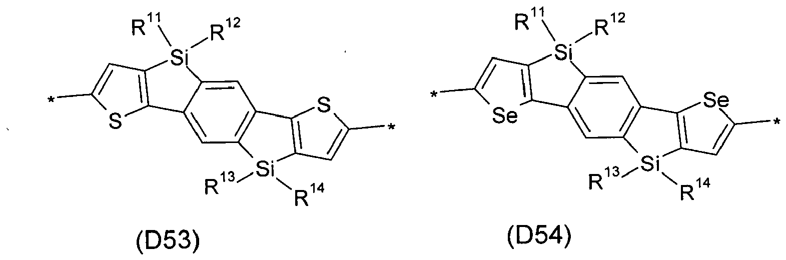 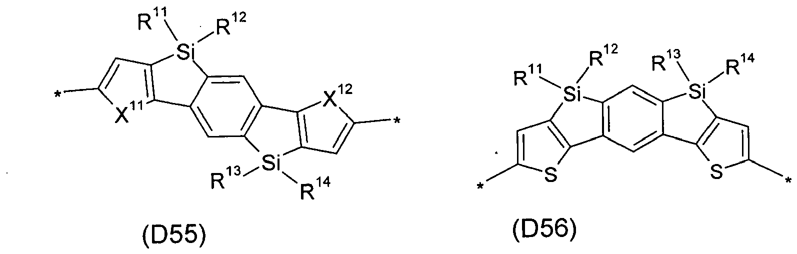 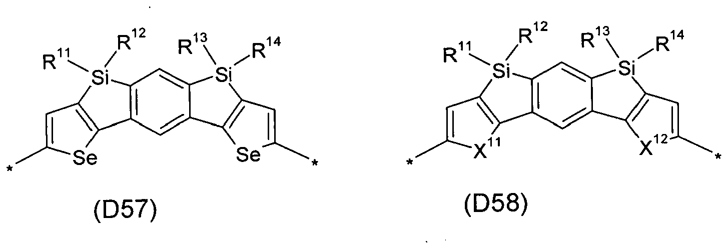 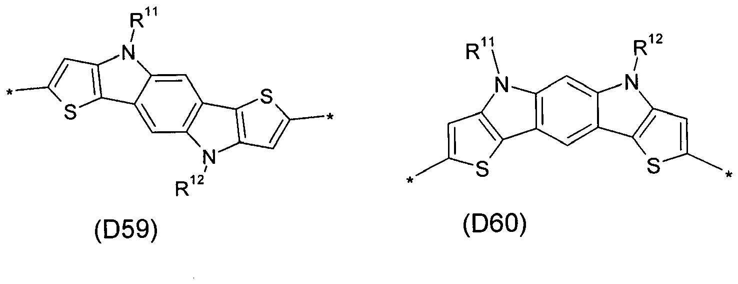 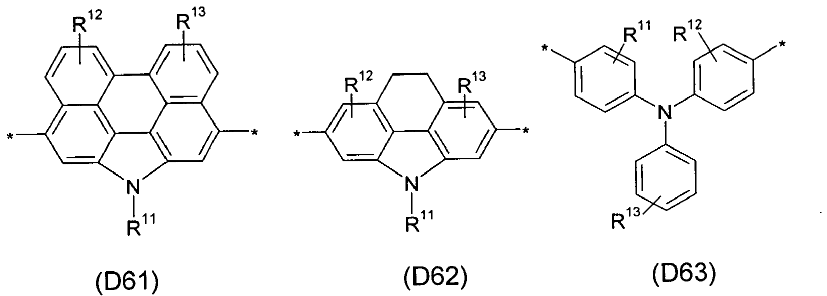 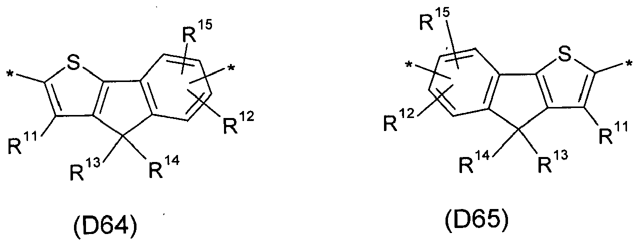 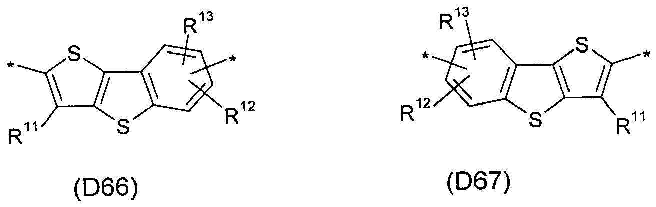 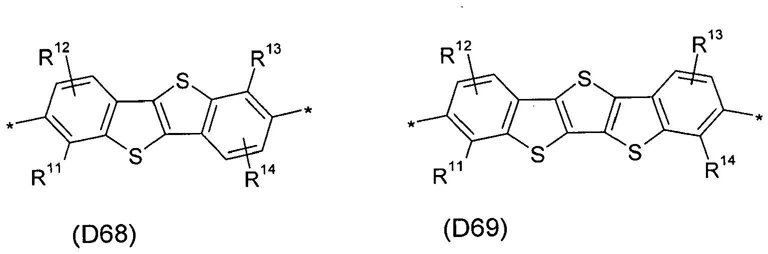 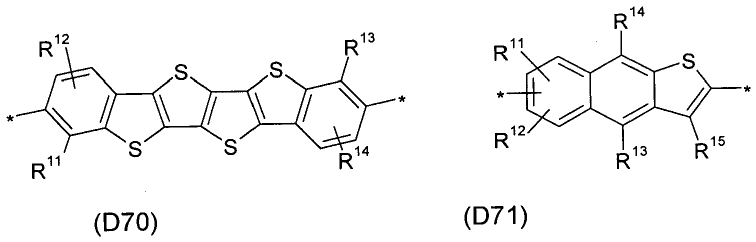 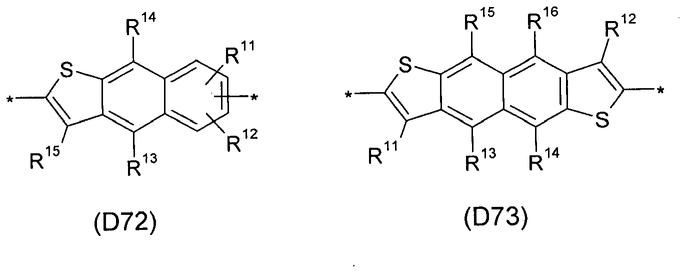 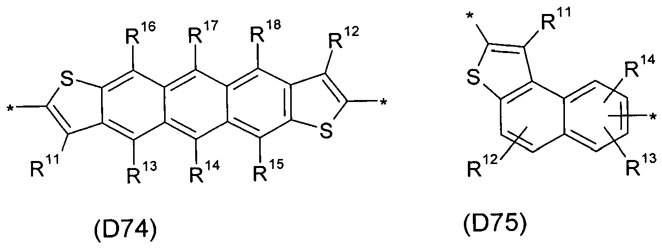 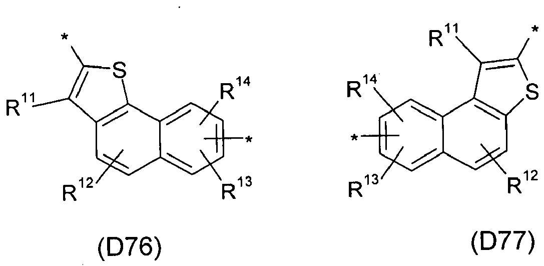 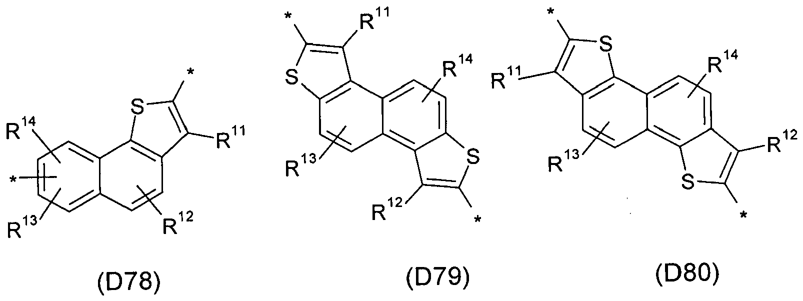 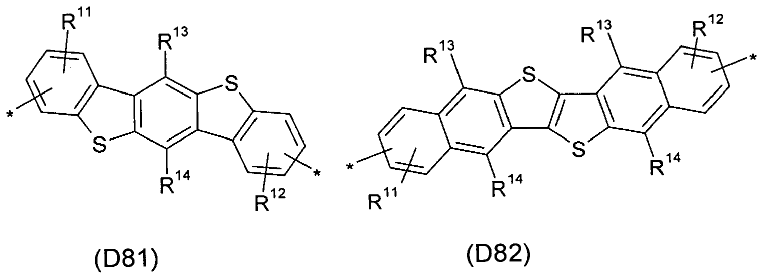 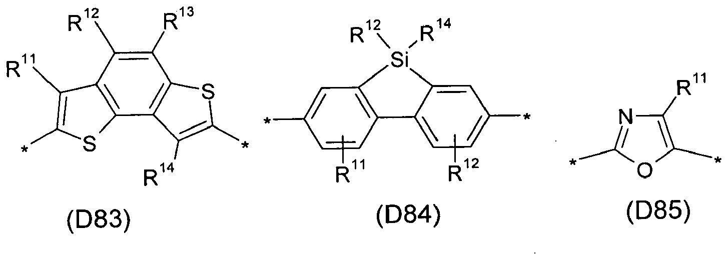 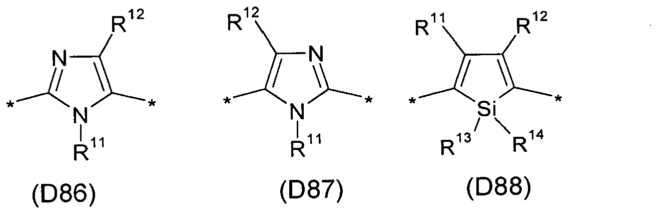 dans lesquelles l'un de X¹¹ et X¹² est S et l'autre est Se, et R¹¹, R¹², R¹³ , R¹⁴, R¹⁵, R¹⁶ , R¹⁷ et R¹⁸ représentent, indépendamment les uns des autres, H ou présentent l'une des significations de R¹ comme défini selon la revendication 1.

10. Polymère selon une ou plusieurs des revendications 3 à 9, dans lequel un ou plusieurs élément(s) pris parmi Ar³ et A¹ représente(nt) aryle ou hétéroaryle choisi parmi le groupe constitué par les formules qui suivent : 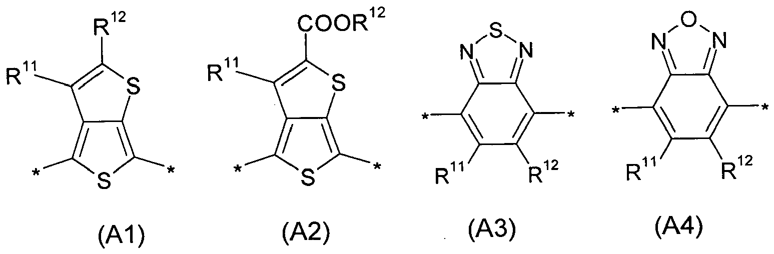 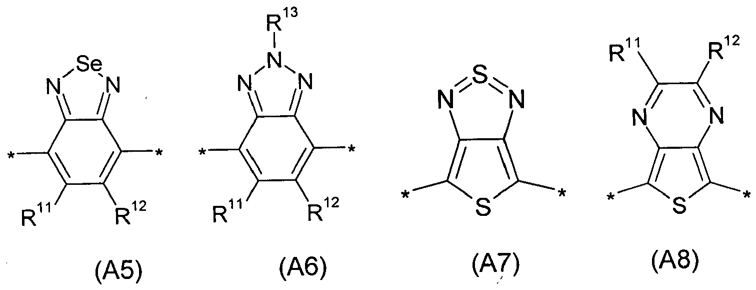 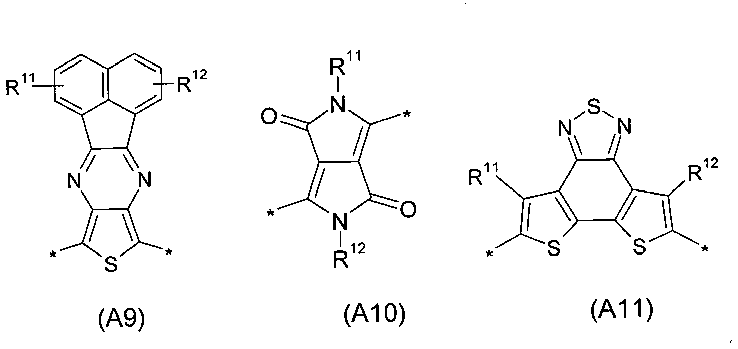 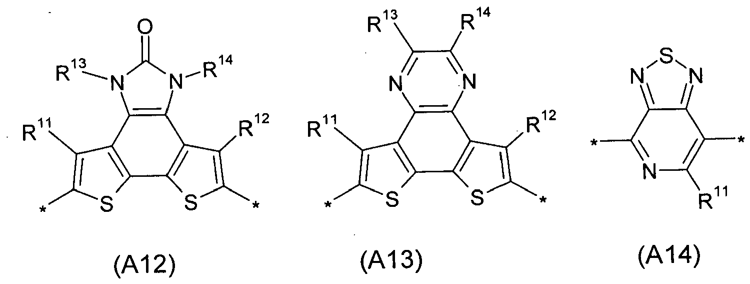 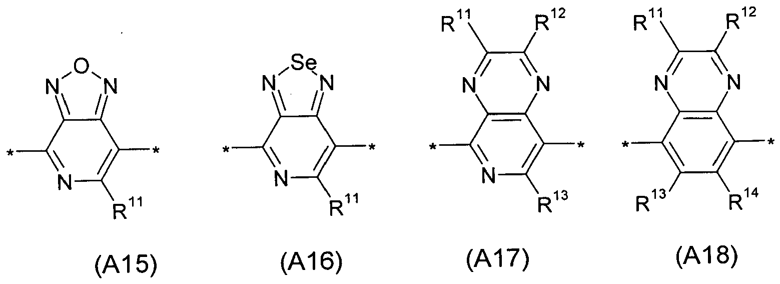 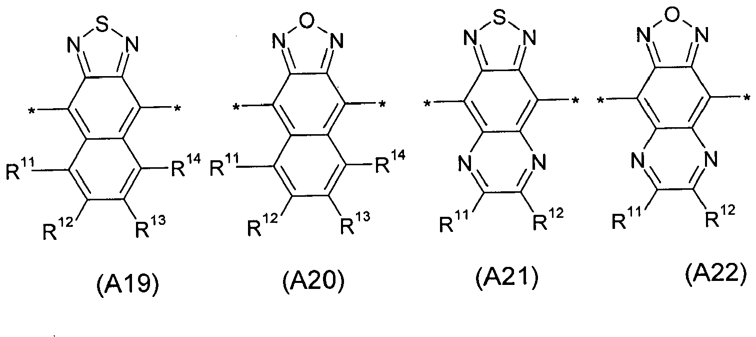 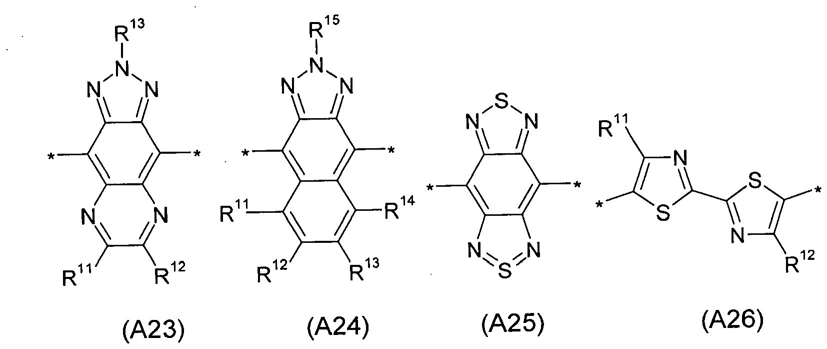 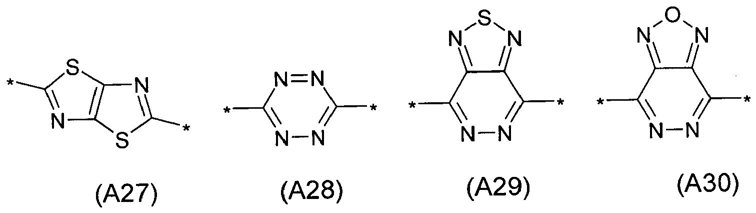 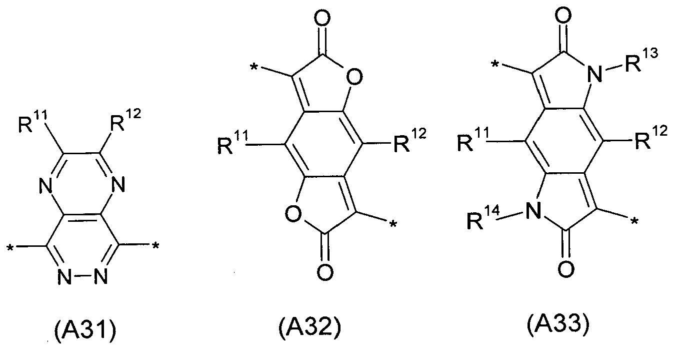 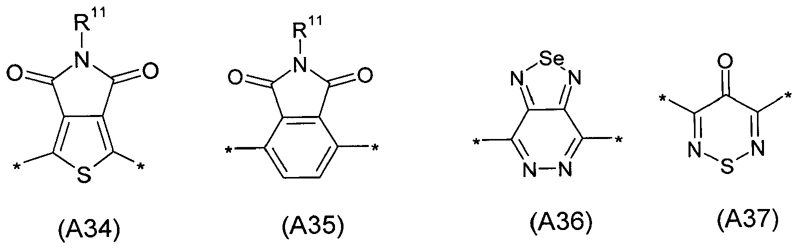 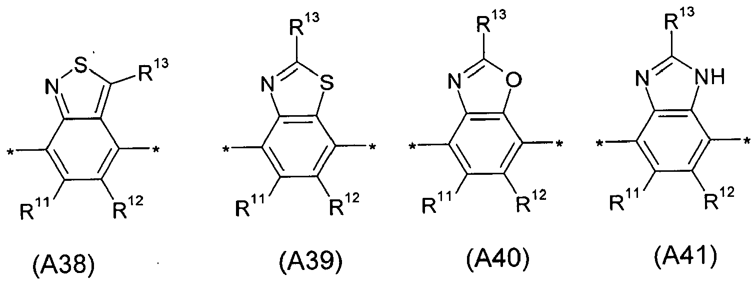 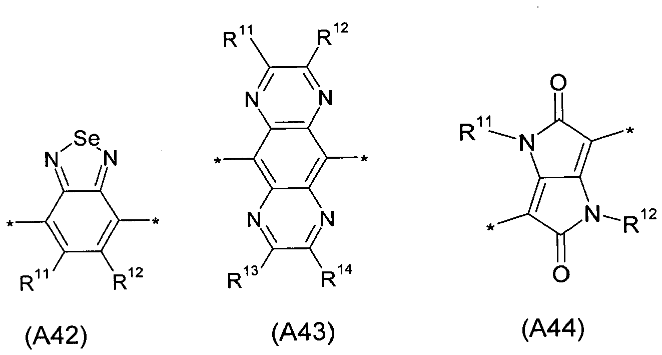 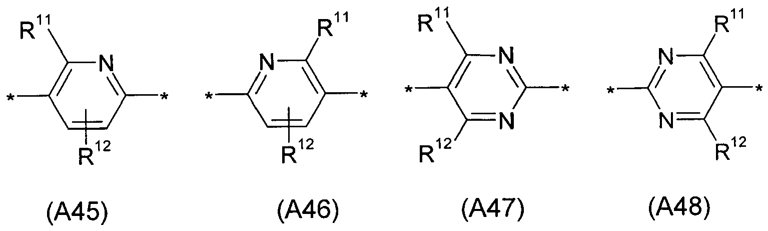 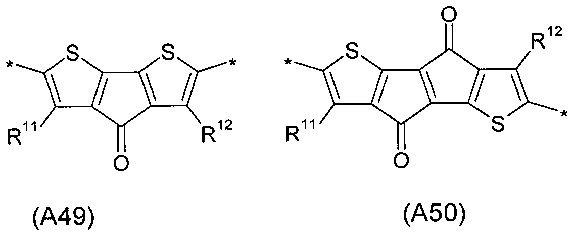 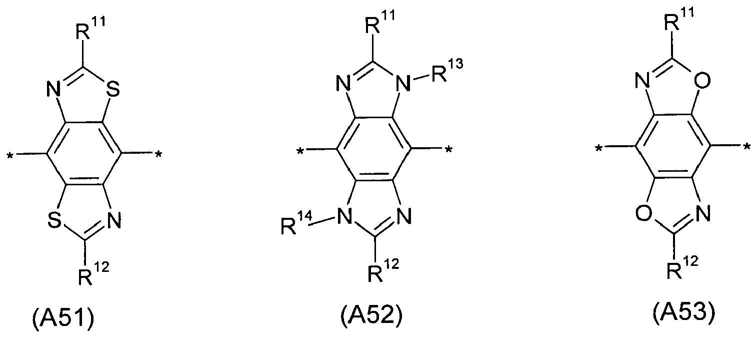 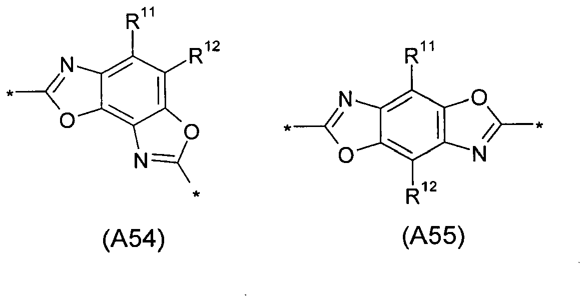 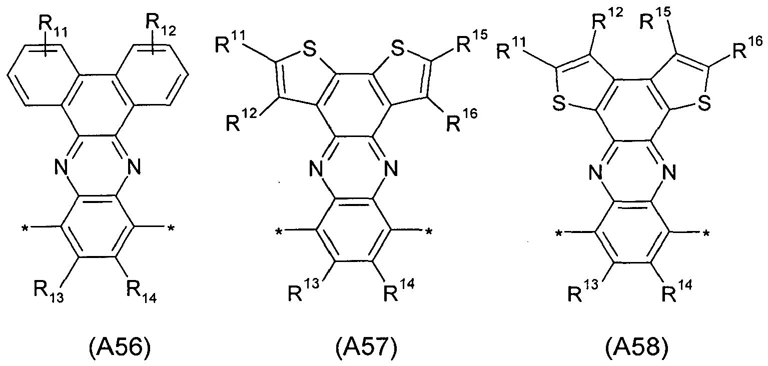 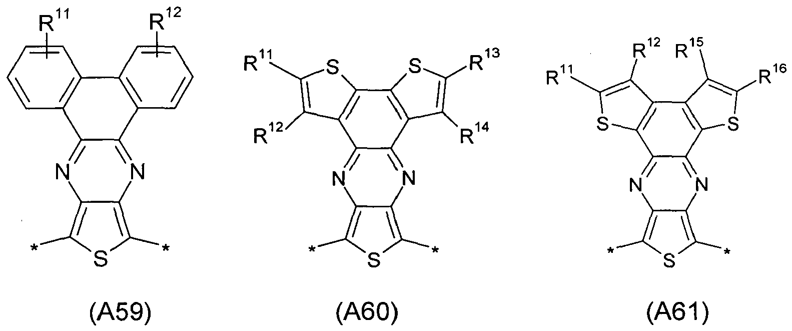 dans lesquelles l'un de X¹¹ et X¹² est S et l'autre est Se, et R¹¹, R¹², R¹³ , R¹⁴ et R¹⁵ représentent, indépendamment les uns des autres, H ou présentent l'une des significations de R¹ comme défini selon la revendication 1.

11. Polymère selon une ou plusieurs des revendications 1 à 10, lequel est choisi parmi les formules qui suivent : 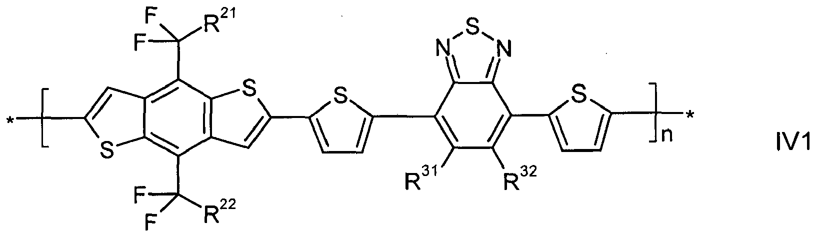 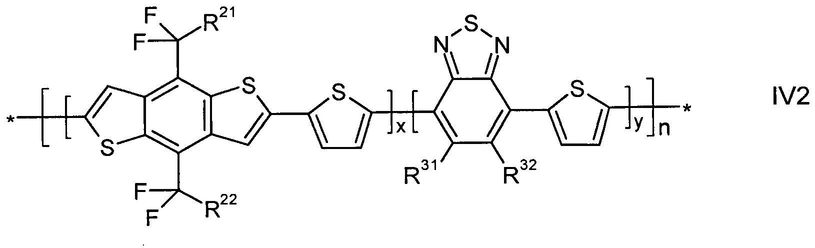 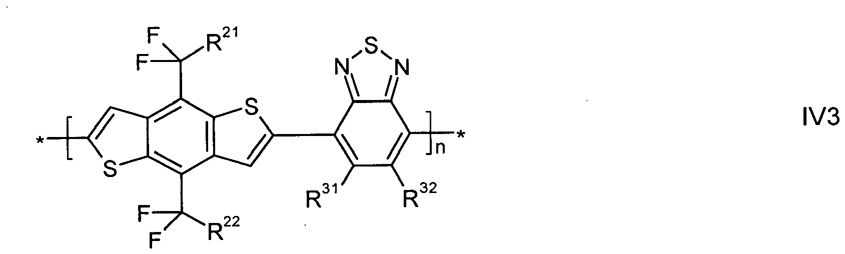 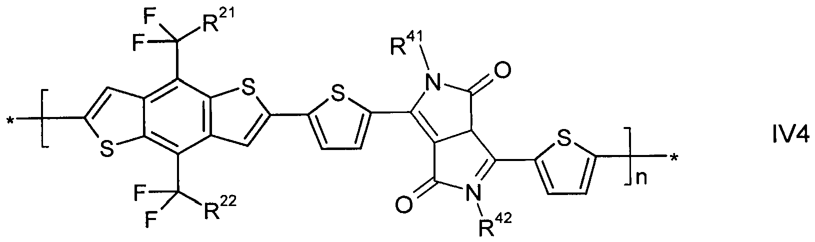 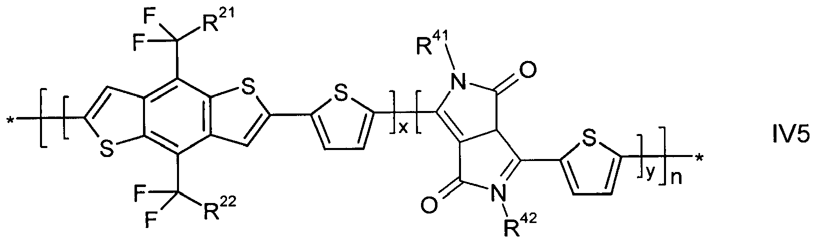 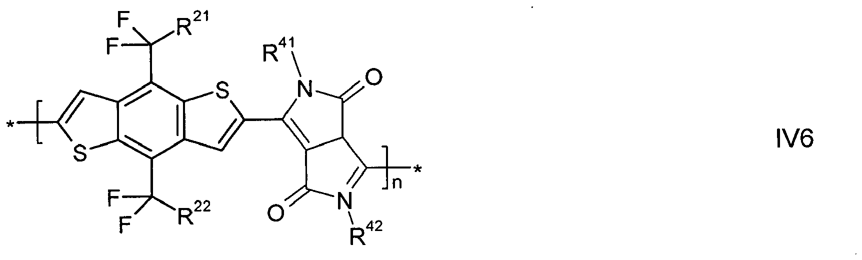 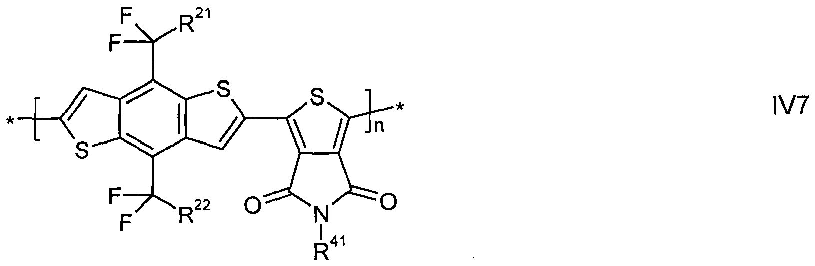 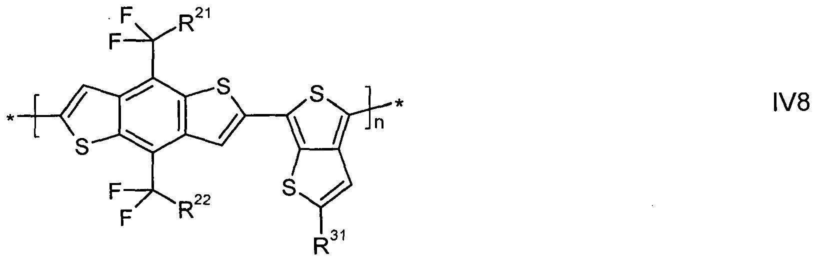 dans lesquelles n, x et y sont comme défini selon la revendication 5, R²¹ et R²² présentent l'une des significations données pour R¹ selon la revendication 1, et R³¹, R³², R⁴¹ et R⁴² présentent l'une des significations données pour R³ selon la revendication 1, et dans lesquelles les cycles thiophène sont en option substitués par un ou deux groupe(s) R³¹.

12. Polymère selon une ou plusieurs des revendications 1 à 11, dans lequel R¹ et/ou R² représente(nt), indépendamment l'un de l'autre, alkyle en chaîne droite ou ramifié avec de 1 à 20 atome(s) de C, lequel est non substitué ou substitué par un ou plusieurs atome(s) de F.

13. Polymère selon une ou plusieurs des revendications 1 à 12, dans lequel R³ et/ou R⁴ est/sont, indépendamment l'un de l'autre, choisi(s) parmi le groupe constitué par alkyle, alcoxy, alkylcarbonyle, alcoxy-carbonyle et alkylcarbonyloxy, dont tous sont en chaîne droite ou ramifiés, sont en option fluorés et comportent de 1 à 30 atome(s) de C, et par aryle, aryloxy, hétéroaryle et hétéroaryloxy, dont tous sont en option alkylatés ou alcoxylatés et comportent de 4 à 30 atomes de cycle.

14. Composition ou mélange de polymères comprenant un ou plusieurs polymère(s) selon une ou plusieurs des revendications 1 à 13 et un ou plusieurs composé(s) ou polymère(s) présentant des propriétés de semiconduction, de transport de charges, de transport de trous/ d'électrons, de blocage de trous/d'électrons, de conduction électrique, de photoconduction ou d'émission de lumière.

15. Composition ou mélange de polymères selon la revendication 14, caractérisé(e) en ce qu'elle/il comprend un ou plusieurs polymère(s) selon une ou plusieurs des revendications 1 à 13 et un ou plusieurs composé(s) semiconducteur(s) organique(s) de type n.

16. Composition ou mélange de polymères selon la revendication 15, caractérisé(e) en ce que le composé semiconducteur organique de type n est choisi parmi le groupe constitué par des fullerènes, des fullerènes substitués et du graphène.

17. Composition ou mélange de polymères selon la revendication 16, caractérisé(e) en ce que le composé semiconducteur organique de type n est choisi parmi le groupe constitué par PCBM-C₆₀, PCBM-C₇₀, PCBM-C₆₁, PCBM-C₇₁, bis-PCBM-C₆₁, bis-PCBM-C₇₁, ICBA et du graphène.

18. Formulation comprenant un(e) ou plusieurs polymère(s), composition(s) ou mélange(s) de polymères selon une ou plusieurs des revendications 1 à 17, et un ou plusieurs solvant(s), de façon préférable choisi(s) parmi des solvants organiques.

19. Utilisation d'un polymère, d'une composition, d'un mélange de polymères ou d'une formulation selon une ou plusieurs des revendications 1 à 18 en tant que matériau de transport de charges, de semiconduction, de conduction électrique, de photoconduction ou d'émission de lumière dans un dispositif optique, électrooptique, électronique, électroluminescent ou photoluminescent, ou dans un composant d'un tel dispositif, ou dans un assemblage comprenant un tel dispositif ou composant.

20. Matériau de transport de charges, de semiconduction, de conduction électrique, de photoconduction ou d'émission de lumière comprenant un polymère, une composition, un mélange de polymères ou une formulation selon une ou plusieurs des revendications 1 à 18.

21. Dispositif optique, électrooptique, électronique, électroluminescent ou photoluminescent, ou un composant afférent, ou un assemblage le comprenant, lequel comprend un matériau de transport de charges, de semiconduction, de conduction électrique, de photoconduction ou d'émission de lumière, ou comprend un polymère, une composition, un mélange de polymères ou une formulation, selon une ou plusieurs des revendications 1 à 18.

22. Dispositif optique, électrooptique, électronique, électroluminescent ou photoluminescent selon la revendication 21, lequel est choisi parmi des transistors à effet de champ organiques (OFET), des transistors à film mince organiques (OTFT), des diodes émettrices de lumière organiques (OLED), des transistors à émission de lumière organiques (OLET), des dispositifs photovoltaïques organiques (OPV), des cellules solaires organiques, des diodes laser, des diodes à émission de plasmons organiques (OPED), des diodes Schottky, des photoconducteurs organiques (OPC) et des photo-détecteurs organiques (OPD).

23. Composant selon la revendication 21, lequel est choisi parmi des couches d'injection de charges, des couches de transport de charges, des intercouches, des couches de planarisation, des films antistatiques, des membranes à électrolyte polymère (PEM), des substrats de conduction et des motifs de conduction.

24. Assemblage selon la revendication 21, lequel est choisi parmi des circuits intégrés (IC), des étiquettes d'identification radiofréquence (RFID) ou des marquages de sécurité ou des dispositifs de sécurité les contenant, des affichages à écran plat ou leurs éclairages arrière, des dispositifs électrophotographiques, des dispositifs d'enregistrement électrophotographique, des dispositifs de mémoire organique, des dispositifs de capteur, des biocapteurs et des biopuces.

25. Utilisation d'un polymère, d'une composition, d'un mélange de polymères ou d'une formulation selon une ou plusieurs des revendications 1 à 18 en tant que matériaux d'électrode dans des accumulateurs, ou dans des composants ou dispositifs pour détecter et discriminer des séquences d'ADN.

26. Dispositif selon la revendication 21 ou 22, lequel est un OFET, un dispositif OPV à hétérojonction dans la masse (BHJ) ou un dispositif OPV BHJ inversé.

27. Monomère de la formule VI :
R⁷-(Ar¹)ₐ-U-(Ar²)_{c}-R⁸ VI
dans laquelle U, Ar¹, Ar², a et c sont comme défini selon la revendication 3 ou 9, et R⁷ et R⁸ sont choisis parmi Cl, Br, I, O-tosylate, O-triflate, O-mésylate, O-nonaflate, -SiMe₂F, -SiMeF₂, -O-SO₂Z¹, -B(OZ²)Z , -CZ³=C(Z³)₂, -C≡CH, - C≡CSi(Z¹)₃, -ZnX⁰ et -Sn(Z⁴)₃, où X⁰ est halogène, de façon préférable Cl, Br ou , Z¹⁻⁴ sont choisis parmi le groupe constitué par alkyle et aryle, chacun étant en option substitué, et deux groupes Z² peuvent également former ensemble un groupe cyclique.

28. Procédé de préparation d'un polymère selon une ou plusieurs des revendications 1 à 13, en couplant un ou plusieurs monomère(s) selon la revendication 27 les uns avec les autres, et/ou avec un ou plusieurs monomère(s) choisi(s) parmi les formules qui suivent :
R⁷-(Ar¹)ₐ-A¹-(Ar²)_{c}-R⁸ C
R⁷-Ar¹-R⁸ D
R⁷-Ar³-R⁸ E
dans lesquelles Ar¹, Ar², Ar³, a et c sont comme défini selon la revendication 3, 9 ou 10, A¹ est comme défini selon la revendication 4 ou 10, et R⁷ et R⁸ sont comme défini selon la revendication 27, lors d'une réaction de couplage aryle-aryle.
